# EUROPEAN PATENT APPLICATION

(11) **EP 4 776 820 A1**
(43) Date of publication of application: **15.07.2026**
(21) Application number: 24862937.0
(22) Date of filing: 09.01.2024
(51) Int. Cl.: H10K 85/60, H10K 50/11, H10K 50/15, C09K 11/06

(54) **ORGANIC OPTOELECTRONIC ELEMENT AND DISPLAY DEVICE**

(30) Priority: 07.09.2023 KR 20230119182
(71) Applicant: SAMSUNG SDI CO., LTD., Yongin-si, Gyeonggi-do 17084 (KR)
(72) Inventor: JO, Youngkyoung, Suwon-si, Gyeonggi-do 16678 (KR); LIM, Youngmook, Suwon-si, Gyeonggi-do 16678 (KR); JUNG, Ho Kuk, Suwon-si, Gyeonggi-do 16678 (KR); LEE, Mijin, Suwon-si, Gyeonggi-do 16678 (KR); KIM, Kyoungrok, Suwon-si, Gyeonggi-do 16678 (KR); WON, Jongwoo, Suwon-si, Gyeonggi-do 16678 (KR); SHIN, Sunwoong, Suwon-si, Gyeonggi-do 16678 (KR); KIM, Junghoon, Suwon-si, Gyeonggi-do 16678 (KR); PARK, Gibeom, Suwon-si, Gyeonggi-do 16678 (KR); LUI, Jinhyun, Suwon-si, Gyeonggi-do 16678 (KR); LEE, Namheon, Suwon-si, Gyeonggi-do 16678 (KR); KIM, Hyung Sun, Suwon-si, Gyeonggi-do 16678 (KR)
(74) Representative: Michalski Hüttermann & Partner mbB
(86) International application number: PCT/KR2024/000396
(87) International publication number: WO 2025/053353

(57) **Abstract**

Disclosed is an organic optoelectronic device including an anode and a cathode facing each other, a light emitting layer between the anode and the cathode, a hole transport layer between the anode and the light emitting layer, and a hole transport auxiliary between the light emitting layer and the hole transport layer,
wherein the light emitting layer includes a first compound represented by Chemical Formula 1 and a second compound represented by Chemical Formula 2 or a combination of Chemical Formula 3 and Chemical Formula 4, and the hole transport auxiliary layer includes a third compound represented by Chemical Formula 5.

Details of Chemical Formula 1 to Chemical Formula 5 are as defined in the specification.

## Description

### [Technical Field]

An organic optoelectronic device and a display device are disclosed.

### [Background Art]

An organic optoelectronic device (organic optoelectronic diode) is a device capable of converting electrical energy and optical energy to each other.

Organic optoelectronic devices may be largely divided into two types according to a principle of operation. One is a photoelectric device that generates electrical energy by separating excitons formed by light energy into electrons and holes, and transferring the electrons and holes to different electrodes, respectively and the other is a light emitting device that generates light energy from electrical energy by supplying voltage or current to the electrodes.

Examples of the organic optoelectronic device include an organic photoelectric device, an organic light emitting diode, an organic solar cell, and an organic photoconductor drum.

Among them, organic light emitting diodes (OLEDs) are attracting much attention in recent years due to increasing demands for flat panel display devices. The organic light emitting diode is a device that converts electrical energy into light, and the performance of the organic light emitting diode is greatly influenced by an organic material between electrodes.

### [Disclosure]

### [Technical Problem]

An embodiment provides an organic optoelectronic device capable of implementing high efficiency characteristics.

Another embodiment provides a display device including the organic optoelectronic device.

### [Technical Solution]

According to an embodiment, an organic optoelectronic device includes an anode and a cathode facing each other, a light emitting layer between the anode and the cathode, a hole transport layer between the anode and the light emitting layer, and a hole transport auxiliary layer between the light emitting layer and the hole transport layer, wherein the light emitting layer includes a composition including a first compound represented by Chemical Formula 1 and a second compound represented by Chemical Formula 2 or a combination of Chemical Formula 3 and Chemical Formula 4 and the hole transport auxiliary layer includes a third compound represented by Chemical Formula 5.

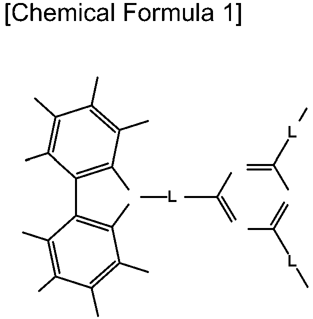

In Chemical Formula 1,
Z¹ to Z³ are each independently N or CR^{a},
at least two of Z¹ to Z³ are N,
R¹ to R⁸ and R^{a} are each independently hydrogen, deuterium, a substituted or unsubstituted C1 to C10 alkyl group, a substituted or unsubstituted C6 to C30 aryl group, or a substituted or unsubstituted C2 to C30 heterocyclic group,
L¹ to L³ are each independently a single bond, a substituted or unsubstituted C6 to C20 arylene group, or a substituted or unsubstituted C2 to C20 heterocyclic group, and
Ar¹ and Ar² are each independently a substituted or unsubstituted C6 to C30 aryl group, a substituted or unsubstituted C2 to C30 heterocyclic group; 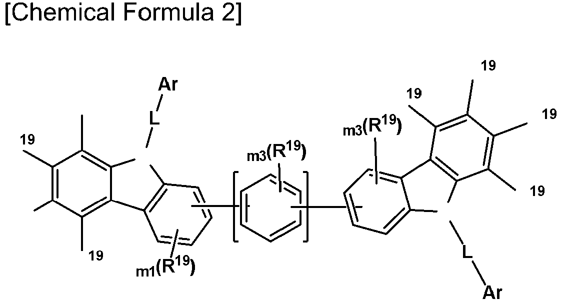
wherein, in Chemical Formula 2,
Ar³ and Ar⁴ are each independently a substituted or unsubstituted C6 to C20 aryl group or a substituted or unsubstituted C2 to C30 heterocyclic group,
L⁴ and L⁵ are each independently a single bond or a substituted or unsubstituted C6 to C20 arylene group,
R⁹ to R¹⁹ are each independently hydrogen, deuterium, a cyano group, a halogen, a substituted or unsubstituted amine group, a substituted or unsubstituted C1 to C30 alkyl group, a substituted or unsubstituted C6 to C30 aryl group, or a substituted or unsubstituted C2 to C30 heterocyclic group,
m1 and m2 are each independently one of integers of 1 to 3,
m3 is one of integers of 1 to 4, and
n is one of integers of 0 to 2; 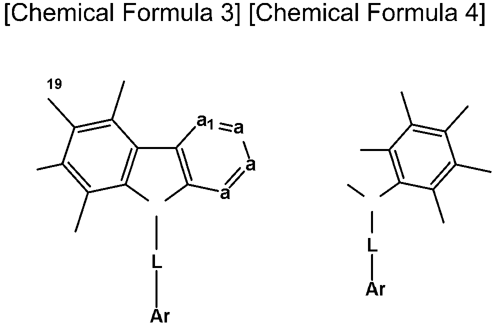
wherein, in Chemical Formula 3 and Chemical Formula 4,
Ar⁵ and Ar⁶ are each independently a substituted or unsubstituted C6 to C20 aryl group or a substituted or unsubstituted C2 to C30 heterocyclic group,
a₁* to a₄* in Chemical Formula 3 are each independently a linking carbon (C) or C-L^{a}-_{R}^{b},
*s in Chemical Formula 4 are each independently a linking carbon (C),
among a₁* to a₄* in Chemical Formula 3, two adjacent ones are each linked to * in Chemical Formula 4,
L^{a}, L⁶, and L⁷ are each independently a single bond or a substituted or unsubstituted C6 to C20 arylene group, and
R^{b} and R²⁰ to R²⁷ are each independently hydrogen, deuterium, a cyano group, a halogen, a substituted or unsubstituted amine group, a substituted or unsubstituted C1 to C30 alkyl group, a substituted or unsubstituted C6 to C30 aryl group, or a substituted or unsubstituted C2 to C30 heterocyclic group; 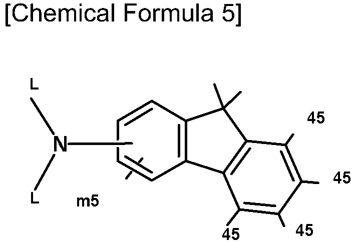
wherein, in Chemical Formula 5,
Ar⁸ and Ar⁹ are each independently a substituted or unsubstituted C6 to C30 aryl group, or a substituted or unsubstituted C2 to C30 heterocyclic group,
Ar¹⁰ and Ar¹¹ are each independently a substituted or unsubstituted C1 to C30 alkyl group, or a substituted or unsubstituted C6 to C30 aryl group,
R⁴¹ to R⁴⁵ are each independently hydrogen, deuterium, a cyano group, a halogen, a substituted or unsubstituted C1 to C30 alkyl group, a substituted or unsubstituted C6 to C30 aryl group, or a substituted or unsubstituted C2 to C30 heterocyclic group, and
m5 is one of integers of 1 to 3.

According to another embodiment, a display device including the organic optoelectronic device is provided.

### [Advantageous Effects]

It is possible to realize organic optoelectronic devices with high efficiency characteristics.

### [Description of the Drawings]

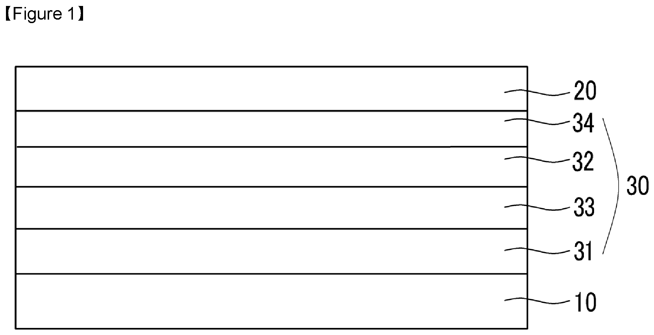

FIG. 1 is a cross-sectional view illustrating an organic light emitting diode according to an embodiment.

### <Description of Symbols>

| | | | |
|---|---|---|---|
| 10: | anode | 20: | cathode |
| 30: | organic layer | 31: | hole transport layer |
| 32: | light emitting layer | 33: | hole transport auxiliary layer |
| 34: | electron transport layer | | |

### [Best Mode]

Hereinafter, embodiments of the present invention are described in detail. However, these embodiments are exemplary, and this disclosure is not limited thereto.

In the present specification, when a definition is not otherwise provided, "substituted" refers to replacement of at least one hydrogen of a substituent or a compound by deuterium, a halogen, a hydroxyl group, an amino group, a substituted or unsubstituted C1 to C30 amine group, a nitro group, a substituted or unsubstituted C1 to C40 silyl group, a C1 to C30 alkyl group, a C1 to C10 alkylsilyl group, a C6 to C30 arylsilyl group, a C3 to C30 cycloalkyl group, a C3 to C30 heterocycloalkyl group, a C6 to C30 aryl group, a C2 to C30 heteroaryl group, a C1 to C20 alkoxy group, a C1 to C10 trifluoroalkyl group, a cyano group, or a combination thereof.

In one example of the present invention, the "substituted" refers to replacement of at least one hydrogen of a substituent or a compound by deuterium, a C1 to C30 alkyl group, a C1 to C10 alkylsilyl group, a C6 to C30 arylsilyl group, a C3 to C30 cycloalkyl group, a C3 to C30 heterocycloalkyl group, a C6 to C30 aryl group, a C2 to C30 heteroaryl group, or a cyano group. In specific example of the present invention, the "substituted" refers to replacement of at least one hydrogen of a substituent or a compound by deuterium, a C1 to C20 alkyl group, a C6 to C30 aryl group, or a cyano group. In specific example of the present invention, the "substituted" refers to replacement of at least one hydrogen of a substituent or a compound by deuterium, a C1 to C5 alkyl group, a C6 to C18 aryl group, a cyano group. In specific example of the present invention, the "substituted" refers to replacement of at least one hydrogen of a substituent or a compound by deuterium, a cyano group, a methyl group, an ethyl group, a propyl group, a butyl group, a phenyl group, a biphenyl group, a terphenyl group, or a naphthyl group.

In the present specification, "unsubstituted" refers to non-replacement of a hydrogen atom by another substituent and remaining of the hydrogen atom.

In the present specification, "hydrogen substitution (-H)" may include "deuterium substitution (-D)" or "tritium substitution (-T)."

In the present specification, when a definition is not otherwise provided, "hetero" refers to one including one to three heteroatoms selected from N, O, S, P, and Si, and remaining carbons in one functional group.

In the present specification, "aryl group" refers to a group including at least one hydrocarbon aromatic moiety, and all elements of the hydrocarbon aromatic moiety have p-orbitals which form conjugation, for example a phenyl group, a naphthyl group, and the like, two or more hydrocarbon aromatic moieties may be linked by a sigma bond and may be, for example a biphenyl group, a terphenyl group, a quaterphenyl group, and the like, and two or more hydrocarbon aromatic moieties are fused directly or indirectly to provide a non-aromatic fused ring, for example a fluorenyl group.

The aryl group may include a monocyclic, polycyclic, or fused ring polycyclic (i.e., rings sharing adjacent pairs of carbon atoms) functional group.

As used herein, "a heterocyclic group" is a generic concept of a heteroaryl group, and may include at least one heteroatom selected from N, O, S, P, and Si instead of carbon (C) in a cyclic compound such as aryl group, a cycloalkyl group, a fused ring thereof, or a combination thereof. When the heterocyclic group is a fused ring, the entire ring or each ring of the heterocyclic group may include one or more heteroatoms.

For example, "a heteroaryl group" may refer to aryl group including at least one heteroatom selected from N, O, S, P, and Si. Two or more heteroaryl groups are linked by a sigma bond directly, or when the heteroaryl group includes two or more rings, the two or more rings may be fused. When the heteroaryl group is a fused ring, each ring may include one to three heteroatoms.

More specifically, the substituted or unsubstituted C6 to C30 aryl group may be a substituted or unsubstituted phenyl group, a substituted or unsubstituted naphthyl group, a substituted or unsubstituted anthracenyl group, a substituted or unsubstituted phenanthrenyl group, a substituted or unsubstituted naphthacenyl group, a substituted or unsubstituted pyrenyl group, a substituted or unsubstituted biphenyl group, a substituted or unsubstituted p-terphenyl group, a substituted or unsubstituted m-terphenyl group, a substituted or unsubstituted o-terphenyl group, a substituted or unsubstituted chrysenyl group, a substituted or unsubstituted benzophenanthrenyl group, a substituted or unsubstituted triphenylene group, a substituted or unsubstituted perylenyl group, a substituted or unsubstituted fluorenyl group, a substituted or unsubstituted indenyl group, or a combination thereof, but is not limited thereto.

More specifically, the substituted or unsubstituted C2 to C30 heterocyclic group may be a substituted or unsubstituted furanyl group, a substituted or unsubstituted thiophenyl group, a substituted or unsubstituted pyrrolyl group, a substituted or unsubstituted pyrazolyl group, a substituted or unsubstituted imidazolyl group, a substituted or unsubstituted triazolyl group, a substituted or unsubstituted oxazolyl group, a substituted or unsubstituted thiazolyl group, a substituted or unsubstituted oxadiazolyl group, a substituted or unsubstituted thiadiazolyl group, a substituted or unsubstituted pyridyl group, a substituted or unsubstituted pyrimidinyl group, a substituted or unsubstituted pyrazinyl group, a substituted or unsubstituted triazinyl group, a substituted or unsubstituted benzofuranyl group, a substituted or unsubstituted benzothiophenyl group, a substituted or unsubstituted benzimidazolyl group, a substituted or unsubstituted indolyl group, a substituted or unsubstituted quinolinyl group, a substituted or unsubstituted isoquinolinyl group, a substituted or unsubstituted quinazolinyl group, a substituted or unsubstituted quinoxalinyl group, a substituted or unsubstituted naphthyridinyl group, a substituted or unsubstituted benzoxazinyl group, a substituted or unsubstituted benzthiazinyl group, a substituted or unsubstituted acridinyl group, a substituted or unsubstituted phenazinyl group, a substituted or unsubstituted phenothiazinyl group, a substituted or unsubstituted phenoxazinyl group, a substituted or unsubstituted carbazolyl group, a substituted or unsubstituted dibenzofuranyl group, or a substituted or unsubstituted dibenzothiophenyl group, or combination thereof, but is not limited thereto.

As used herein, hole characteristics refer to an ability to donate an electron to form a hole when an electric field is applied and that a hole formed in the anode may be easily injected into the light emitting layer and transported in the light emitting layer due to conductive characteristics according to a highest occupied molecular orbital (HOMO) level.

In addition, electron characteristics refer to an ability to accept an electron when an electric field is applied and that electron formed in the cathode may be easily injected into the light emitting layer and transported in the light emitting layer due to conductive characteristics according to a lowest unoccupied molecular orbital (LUMO) level.

An organic optoelectronic device according to an embodiment of the present invention is described below.

The organic optoelectronic device may be a suitable device to convert electrical energy into photoenergy and vice versa, e.g., an organic photoelectric device, an organic light emitting diode, an organic solar cell, or an organic photoconductor drum.

Herein, an organic light emitting diode as one example of an organic optoelectronic device is described, but the present invention is not limited thereto, and may be applied to other organic optoelectronic device in the same way.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present.

FIG. 1 is a schematic cross-sectional view of an organic optoelectronic device according to an embodiment.

Referring to FIG. 1, an organic optoelectronic device according to one embodiment includes an anode 10 and a cathode 20 facing each other, and an organic layer 30 between the anode 10 and the cathode 20.

The anode 10 may be made of a conductor having a large work function to help hole injection, and may be for example a metal, a metal oxide and/or a conductive polymer. The anode 10 may be, for example a metal such as nickel, platinum, vanadium, chromium, copper, zinc, gold, and the like or an alloy thereof; a metal oxide such as zinc oxide, indium oxide, indium tin oxide (ITO), indium zinc oxide (IZO), and the like; a combination of a metal and an oxide such as ZnO and Al or SnO₂ and Sb; a conductive polymer such as poly(3-methylthiophene), poly(3,4-(ethylene-1,2-dioxy)thiophene) (PEDOT), polypyrrole, and polyaniline, but is not limited thereto.

The cathode 20 may be made of a conductor having a small work function to help electron injection, and may be for example a metal, a metal oxide and/or a conductive polymer. The cathode 20 may be for example a metal such as magnesium, calcium, sodium, potassium, titanium, indium, yttrium, lithium, gadolinium, aluminum silver, tin, lead, cesium, barium, and the like, or an alloy thereof; a multi-layer structure material such as LiF/Al, LiO₂/Al, LiF/Ca, and BaF₂/Ca, but is not limited thereto.

The organic layer 30 includes a hole transport layer 31, a light emitting layer 32, and a hole transport auxiliary layer 33 between the hole transport layer 31 and the light emitting layer 32.

The hole transport layer 31 is a layer for facilitating hole transfer from the anode 10 to the light emitting layer 32, and may include, for example, an amine compound, but is not limited thereto.

The amine compound may include, for example, at least one aryl group and/or heteroaryl group. The amine compound may be represented by, for example, Chemical Formula a or Chemical Formula b, but is not limited thereto.

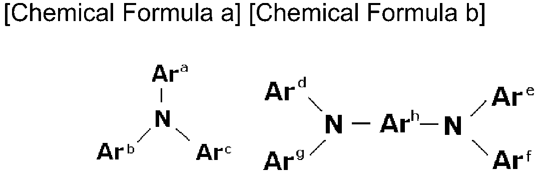

In Chemical Formula a or b,
Ar^{a} to Ar^{g} are each independently hydrogen, deuterium, a substituted or unsubstituted C1 to C20 alkyl group, a substituted or unsubstituted C6 to C30 aryl group, a substituted or unsubstituted C2 to C30 heteroaryl group, or a combination thereof,
at least one of Ar^{a} to Ar^{c} and at least one of Ar^{d} to Ar^{g} are a substituted or unsubstituted C6 to C30 aryl group, a substituted or unsubstituted C2 to C30 heteroaryl group, or a combination thereof, and
Ar^{h} is a single bond, a substituted or unsubstituted C1 to C20 alkylene group, a substituted or unsubstituted C6 to C30 arylene group, a substituted or unsubstituted C2 to C30 heteroarylene group or a combination thereof.

The light emitting layer 32 includes at least two types of hosts and dopants. The host includes a first compound having bipolar characteristics with relatively strong electronic characteristics and a second compound having relatively strong hole characteristics.

The first compound is a compound having bipolar characteristics with relatively strong electronic characteristics, and may be represented by Chemical Formula 1.

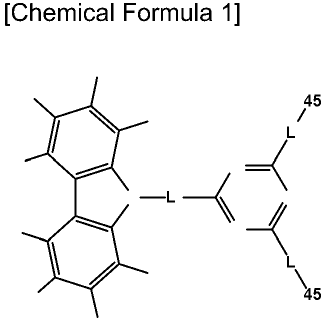

In Chemical Formula 1,
Z¹ to Z³ are each independently N or CR^{a},
at least two of Z¹ to Z³ are N,
R¹ to R⁸ and R^{a} are each independently hydrogen, deuterium, a substituted or unsubstituted C1 to C10 alkyl group, a substituted or unsubstituted C6 to C30 aryl group, or a substituted or unsubstituted C2 to C30 heterocyclic group,
L¹ to L³ are each independently a single bond, a substituted or unsubstituted C6 to C20 arylene group, or a substituted or unsubstituted C2 to C20 heterocyclic group, and
Ar¹ and Ar² are each independently a substituted or unsubstituted C6 to C30 aryl group, a substituted or unsubstituted C2 to C30 heterocyclic group.

The first compound has a structure in which a pyrimidine or triazine ring is substituted with at least one 9-carbazole, so that it can easily receive electrons when an electric field is applied, and accordingly, together with the second compound described below, it can appropriately balance good interface characteristics and the flow of holes and electrons, and thus, it can improve a driving voltage of an organic optoelectronic device to which the first compound is applied.

In Chemical Formula 1, Ar¹ and Ar² are each independently a substituted or unsubstituted phenyl group, a substituted or unsubstituted biphenyl group, a substituted or unsubstituted terphenyl group, a substituted or unsubstituted naphthyl group, a substituted or unsubstituted phenanthrenyl group, a substituted or unsubstituted triphenylene group, a substituted or unsubstituted fluorenyl group, a substituted or unsubstituted dibenzofuranyl group, a substituted or unsubstituted dibenzothiophenyl group, a substituted or unsubstituted dibenzosilolyl group, or a substituted or unsubstituted carbazolyl group.

For example, Ar¹ and Ar² may each independently be a substituted or unsubstituted phenyl group, a substituted or unsubstituted biphenyl group, a substituted or unsubstituted terphenyl group, a substituted or unsubstituted triphenylene group, a substituted or unsubstituted dibenzofuranyl group, a substituted or unsubstituted dibenzothiophenyl group, a substituted or unsubstituted dibenzosilolyl group, or a substituted or unsubstituted carbazolyl group.

In Chemical Formula 1, L¹ to L³ may each independently be a single bond, a substituted or unsubstituted phenylene group, or a substituted or unsubstituted biphenylene group.

For example, L¹-Ar¹ and L²-Ar² may each independently be selected from the substituents listed in Group I .

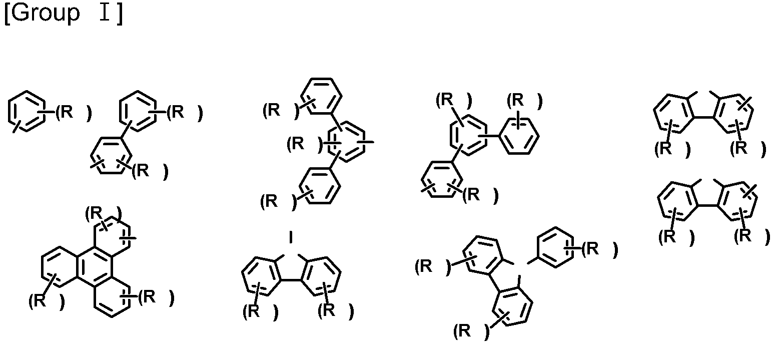

In Group I,
R⁴⁶ to R⁴⁸ are each independently hydrogen, deuterium, a cyano group, a substituted or unsubstituted C1 to C10 alkyl group, or a substituted or unsubstituted C6 to C12 aryl group,
m6 is one of integers of 1 to 5,
m7 is one of integers of 1 to 4,
m8 is one of integers of 1 to 3, and
* is a linking point.

In Chemical Formula 1, R¹ to R⁸ may each independently be hydrogen, deuterium, a substituted or unsubstituted C1 to C5 alkyl group, a substituted or unsubstituted C6 to C12 aryl group, a substituted or unsubstituted carbazolyl group, a substituted or unsubstituted dibenzofuranyl group, or a substituted or unsubstituted dibenzothiophenyl group.

For example, R¹ to R⁸ may each independently be hydrogen, deuterium, a substituted or unsubstituted C1 to C5 alkyl group, a substituted or unsubstituted phenyl group, a substituted or unsubstituted biphenyl group, a substituted or unsubstituted carbazolyl group, a substituted or unsubstituted dibenzofuranyl group, or a substituted or unsubstituted dibenzothiophenyl group.

In Chemical Formula 1, R^{a} may be hydrogen, deuterium, a substituted or unsubstituted C1 to C5 alkyl group, or a substituted or unsubstituted C6 to C12 aryl group.

For example, R^{a} may be hydrogen, deuterium, a substituted or unsubstituted C1 to C5 alkyl group, a substituted or unsubstituted phenyl group, or a substituted or unsubstituted biphenyl group.

The first compound may be, for example, one selected from compounds of Group 1, but is not limited thereto.

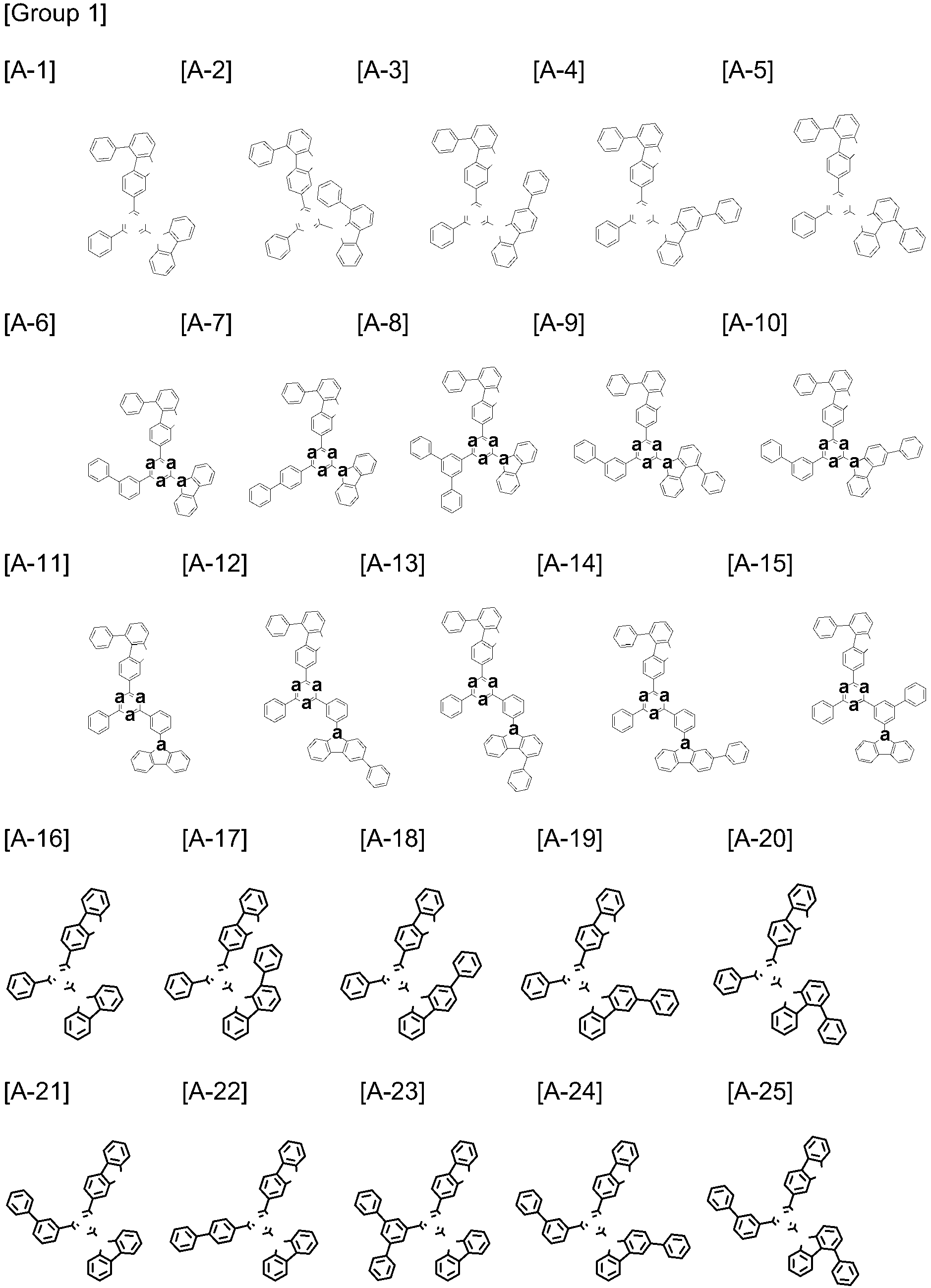

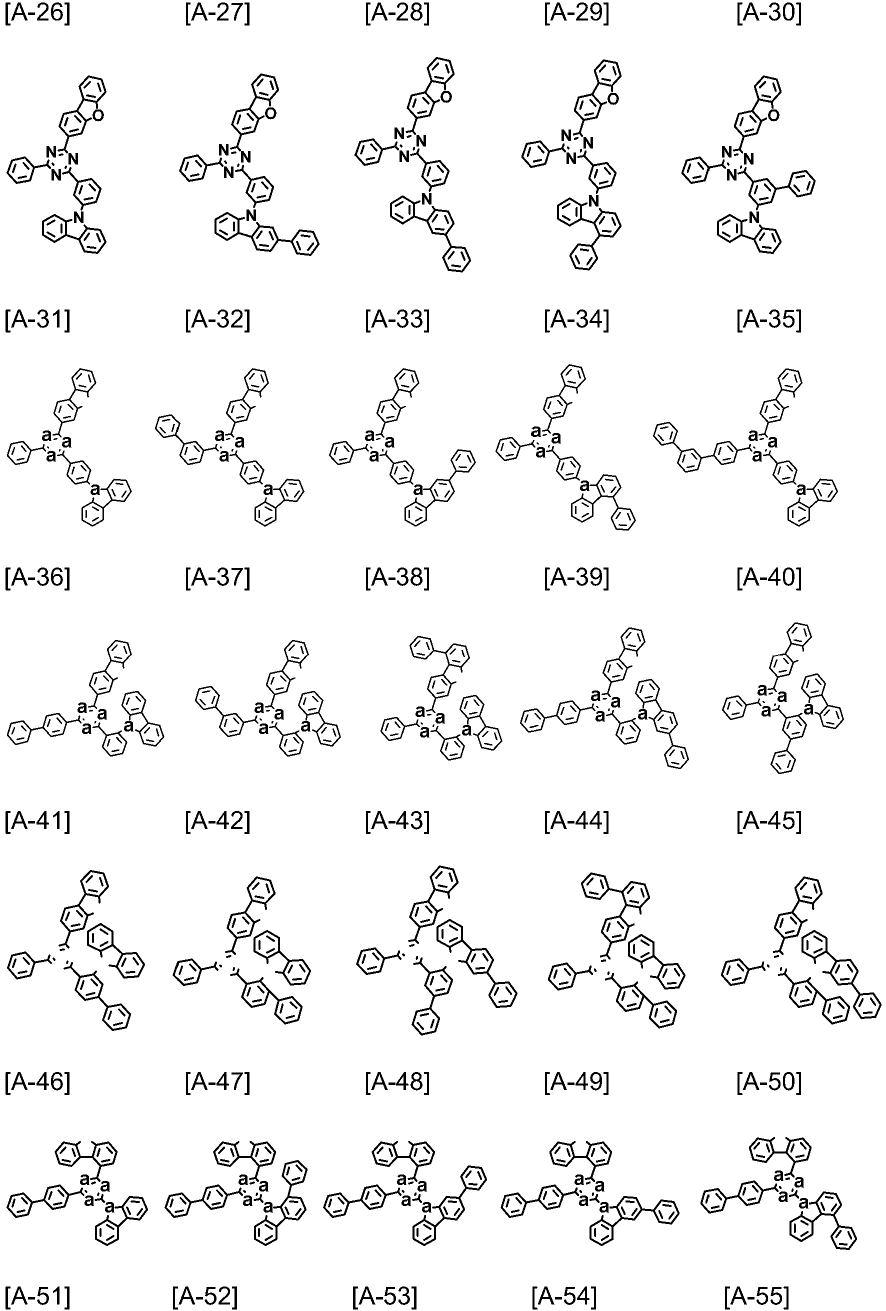

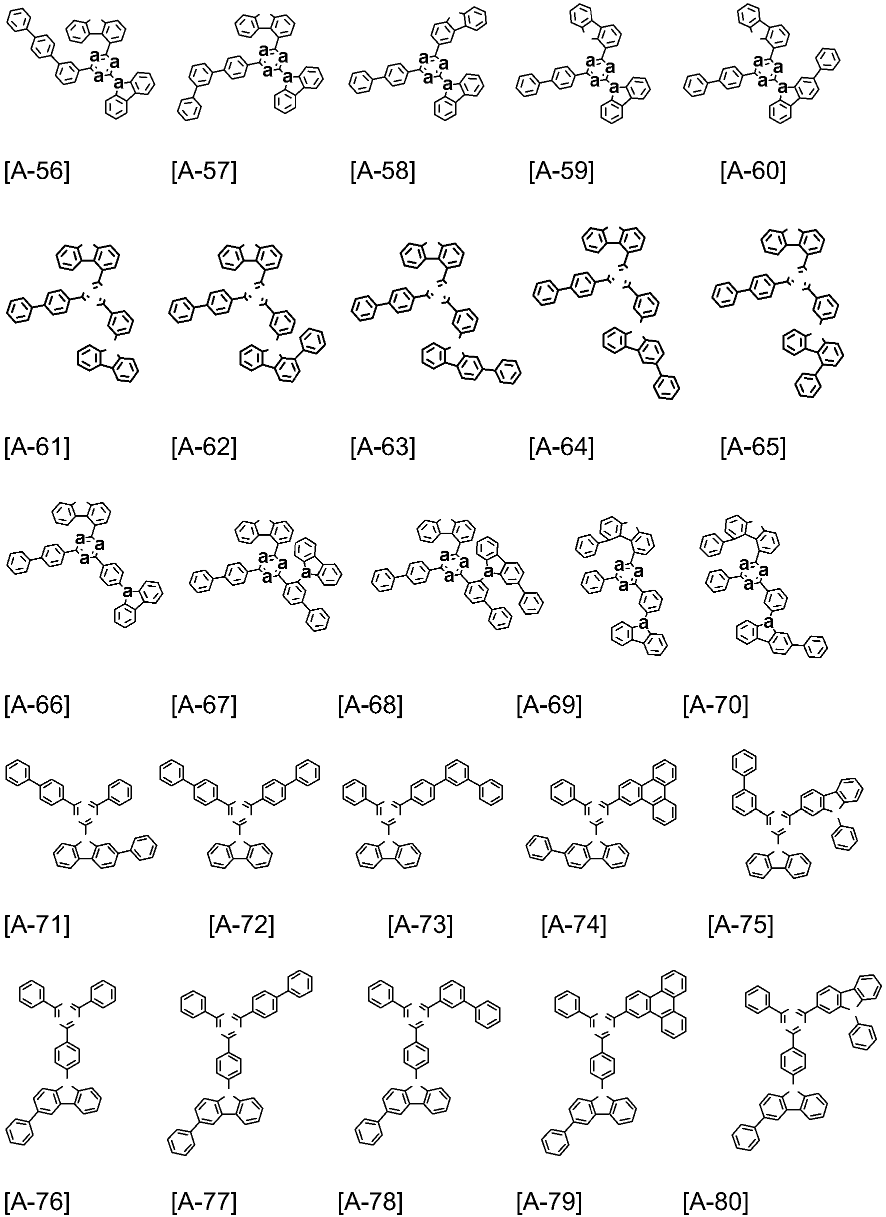

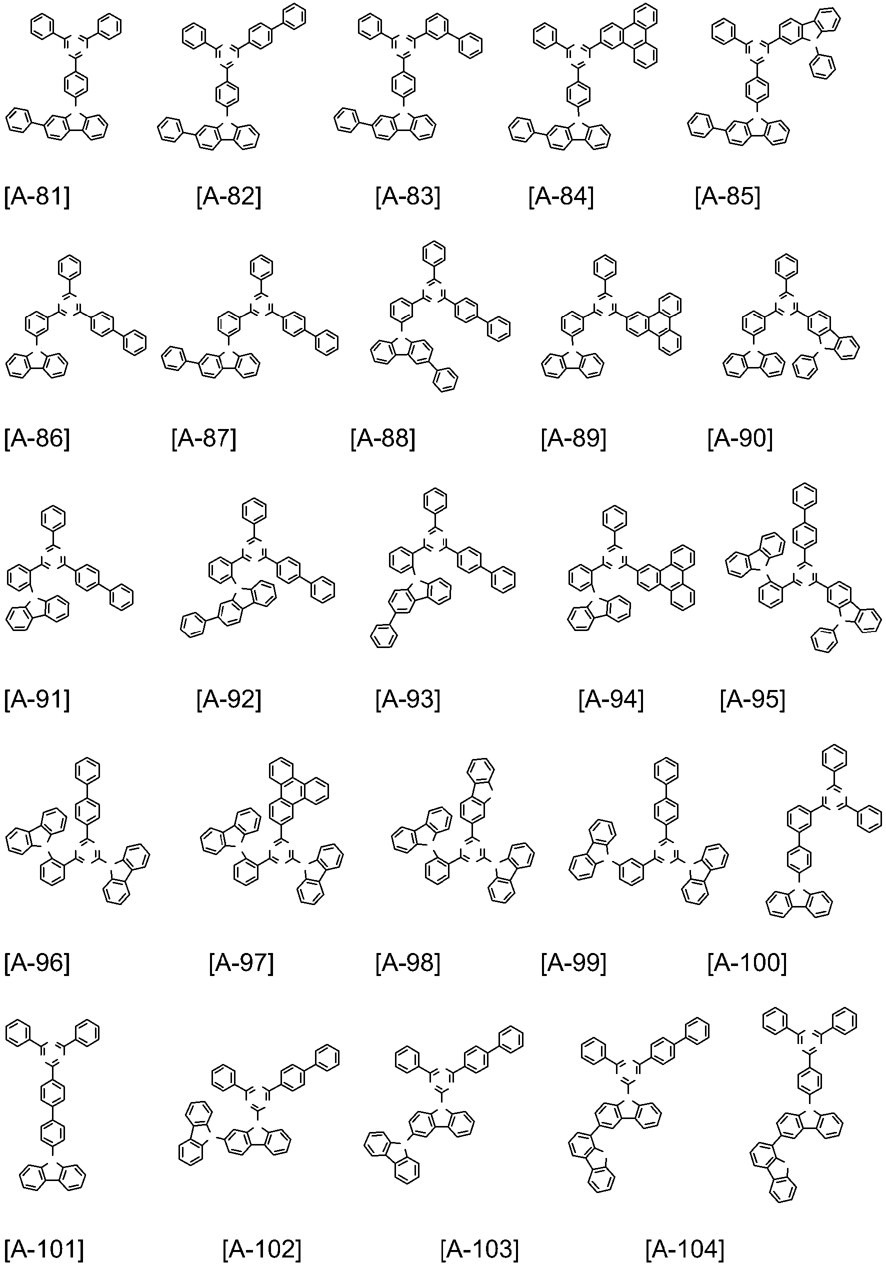

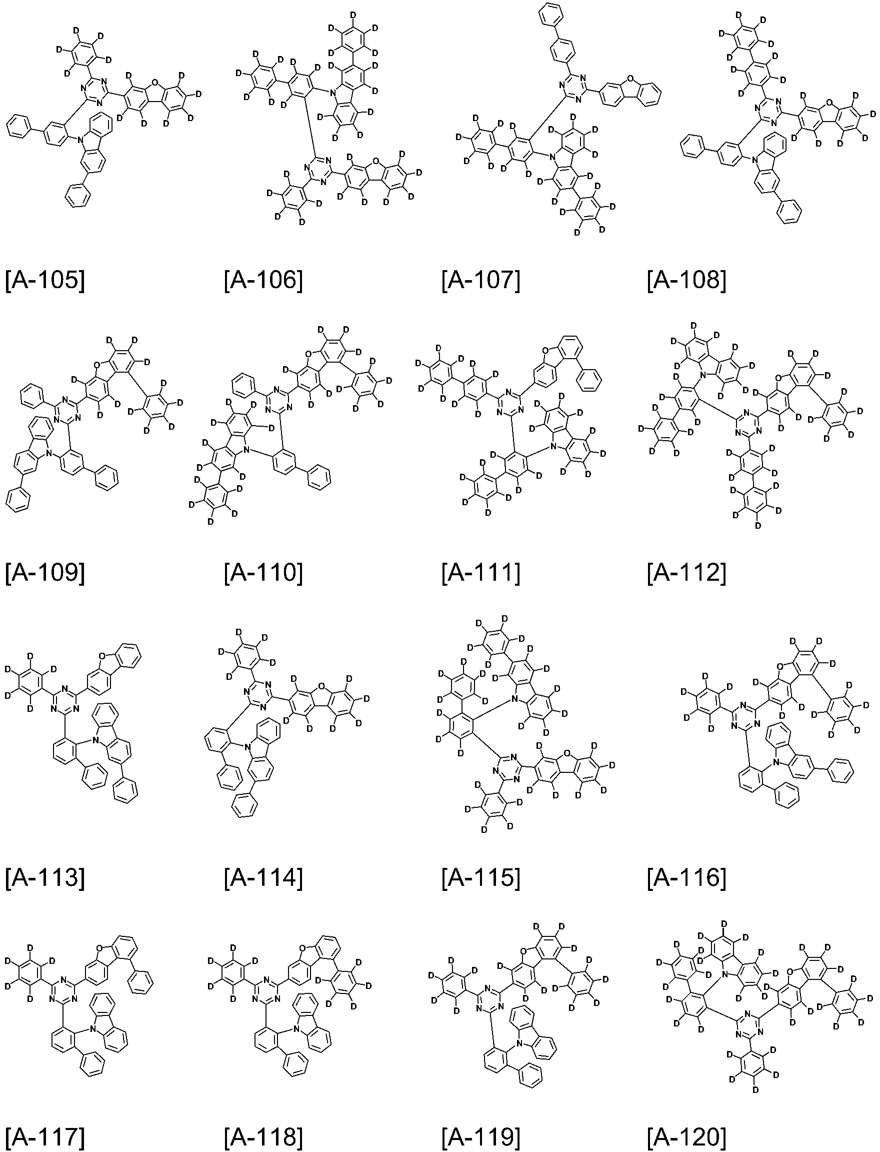

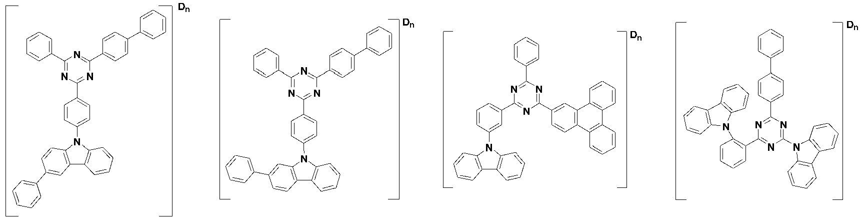

The first compound may be used in one or two or more types.

The second compound may be used in a light emitting layer together with the first compound to improve luminous efficiency and life-span characteristics by increasing charge mobility and increasing stability.

The second compound may be represented, for example, by Chemical Formula 2.

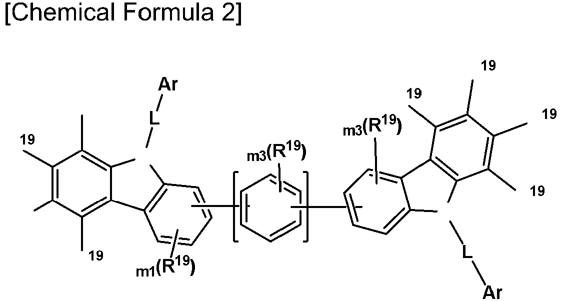

In Chemical Formula 2,
Ar³ and Ar⁴ are each independently a substituted or unsubstituted C6 to C20 aryl group or a substituted or unsubstituted C2 to C30 heterocyclic group,
L⁴ and L⁵ are each independently a single bond or a substituted or unsubstituted C6 to C20 arylene group,
R⁹ to R¹⁹ are each independently hydrogen, deuterium, a cyano group, a halogen, a substituted or unsubstituted amine group, a substituted or unsubstituted C1 to C30 alkyl group, a substituted or unsubstituted C6 to C30 aryl group, or a substituted or unsubstituted C2 to C30 heterocyclic group,
m1 and m2 are each independently one of integers of 1 to 3,
m3 is one of integers of 1 to 4, and
n is one of integers of 0 to 2.

When m1 is 2 or more, each R¹³ may be the same or different from each other.

When m2 is 2 or more, each R¹⁴ may be the same or different from each other.

When m3 is 2 or more, each R¹⁹ may be the same or different from each other.

For example, in Chemical Formula 2, Ar³ and Ar⁴ may each independently be a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted triphenylenyl group, a substituted or unsubstituted pyridinyl group, a substituted or unsubstituted carbazolyl group, a substituted or unsubstituted dibenzothiophenyl group, a substituted or unsubstituted dibenzofuranyl group, or a substituted or unsubstituted fluorenyl group,
in Chemical Formula 2, L⁴ and L⁵ may each independently be a single bond, a substituted or unsubstituted phenylene group, or a substituted or unsubstituted biphenylene group,
in Chemical Formula 2, R⁹ to R¹⁹ may each independently be hydrogen, deuterium, or a substituted or unsubstituted C6 to C12 aryl group, and
n may be 0 or 1.

For example, "substituted" in Chemical Formula 2 means that at least one hydrogen is substituted with deuterium, a C1 to C4 alkyl group, a C6 to C18 aryl group, or a C2 to C30 heteroaryl group.

In a specific embodiment of the present invention, Chemical Formula 2 may be represented by one of Chemical Formula 2-1 to Chemical Formula 2-15.

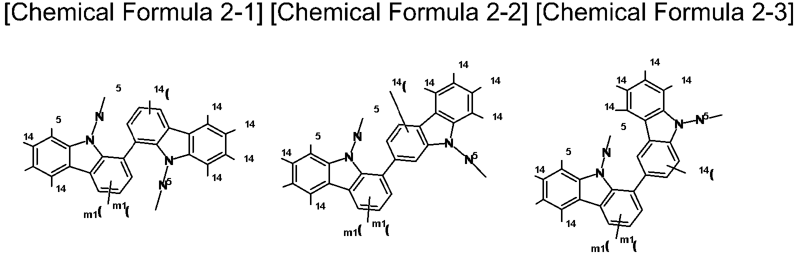

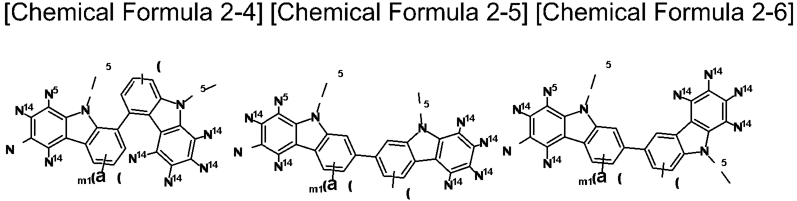

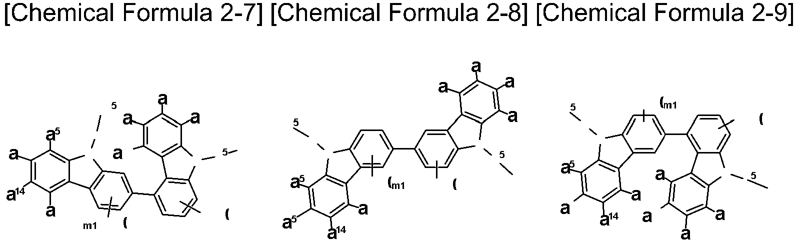

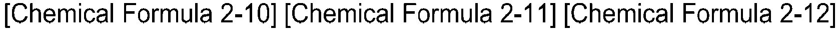

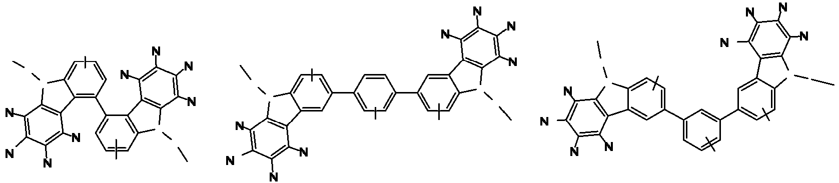

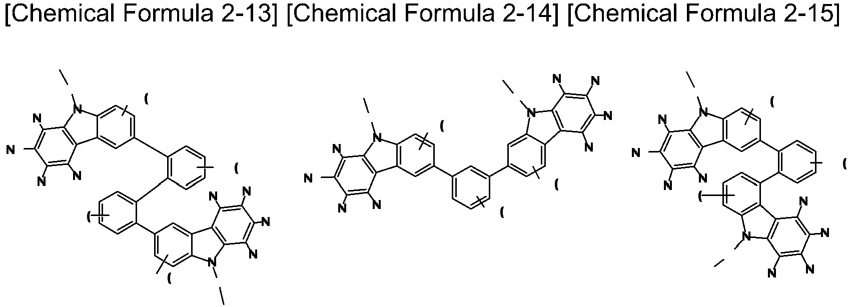

In Chemical Formula 2-1 to Chemical Formula 2-15, R⁹ to R¹⁹ may each independently be hydrogen, deuterium, or a substituted or unsubstituted C6 to C12 aryl group,
m1 and m2 may each independently be one of integers of 1 to 3,
m3 may be one of integers of 1 to 4, and
L⁴-Ar³ and L⁵-Ar⁴ may each independently be one of substituents listed in Group II.

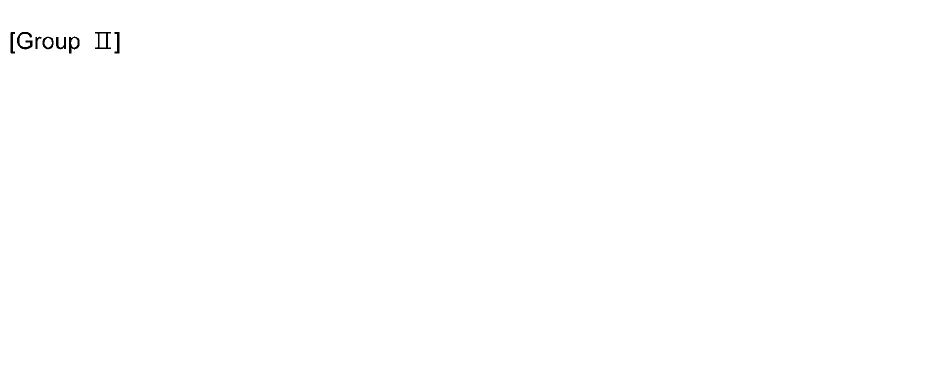

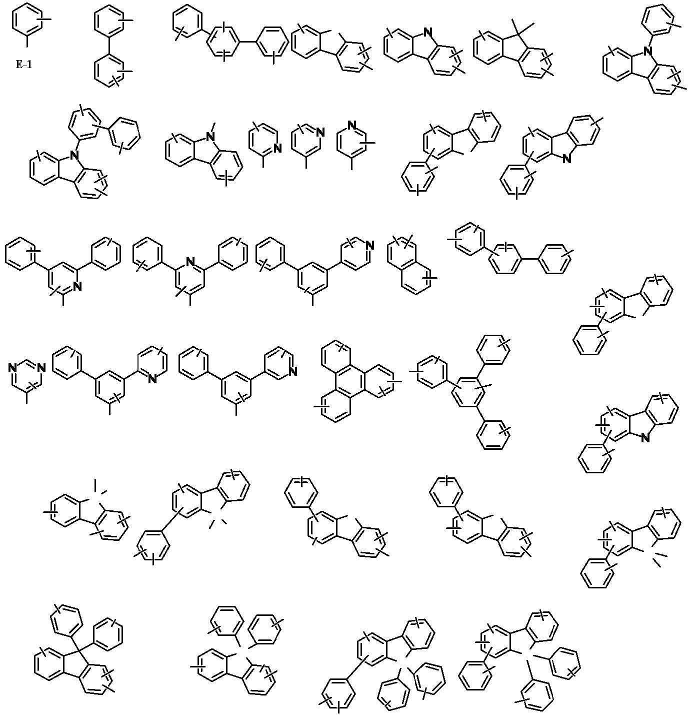

In Group II,
R⁴⁹ to R⁵² are each independently hydrogen, deuterium, a cyano group, a substituted or unsubstituted C1 to C10 alkyl group, or a substituted or unsubstituted C6 to C12 aryl group,
m9 is one of integers of 1 to 5,
m10 is one of integers of 1 to 4,
m11 is one of integers of 1 to 3,
m12 is an integer of 1 or 2, and
* is a linking point.

When m9 is 2 or more, each R⁴⁹ may be the same or different from each other.

When m10 is 2 or more, each R⁵⁰ may be the same or different from each other.

When m11 is 2 or more, each R⁵¹ may be the same or different from each other.

When m12 is 2 or more, each R⁵² may be the same or different from each other.

In an embodiment, Chemical Formula 2 may be represented by Chemical Formula 2-8.

In addition, in Chemical Formula 2-8, L⁴-Ar³ and L⁵-Ar⁴ may each independently be selected from Group II, and may be for example, any one of E-1, E-2, E-3, E-4, E-7, E-8, and E-9.

The second compound may be represented by, for example, a combination of Chemical Formula 3 and Chemical Formula 4.

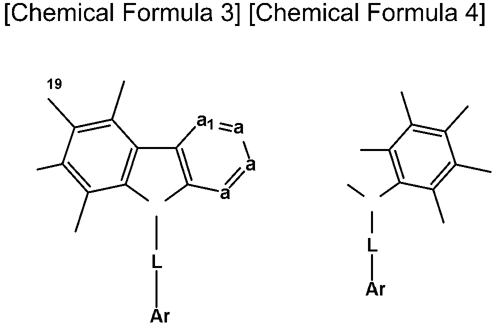

In Chemical Formula 3 and Chemical Formula 4,
Ar⁵ and Ar⁶ are each independently a substituted or unsubstituted C6 to C20 aryl group or a substituted or unsubstituted C2 to C30 heterocyclic group,
a₁* to a₄* in Chemical Formula 3 are each independently a linking carbon (C) or C-L^{a}-R^{b},
*s in Chemical Formula 4 are each independently a linking carbon (C),
adjacent two of a₁* to a₄* in Chemical Formula 3 are each linked to * in Chemical Formula 4,
L^{a}, L⁶, and L⁷ are each independently a single bond or a substituted or unsubstituted C6 to C20 arylene group, and
R^{b} and R²⁰ to R²⁷ are each independently hydrogen, deuterium, a cyano group, a halogen, a substituted or unsubstituted amine group, a substituted or unsubstituted C1 to C30 alkyl group, a substituted or unsubstituted C6 to C30 aryl group, or a substituted or unsubstituted C2 to C30 heterocyclic group.

For example, the second compound represented by the combination of Chemical Formula 3 and Chemical Formula 4 may be represented by any one of Chemical Formula 3A, Chemical Formula 3B, Chemical Formula 3C, Chemical Formula 3D, and Chemical Formula 3E.

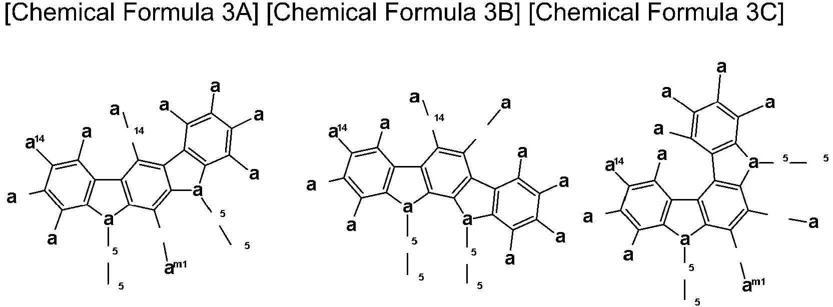

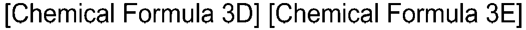

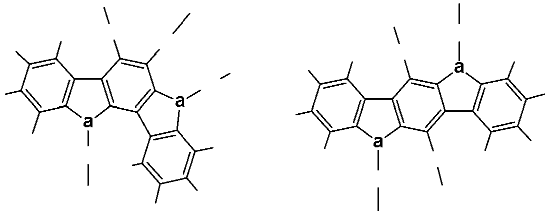

In Chemical Formula 3A to Chemical Formula 3E, Ar⁵, Ar⁶, L⁶, L⁷, and R²⁰ to R²⁷ are the same as described above,
L^{a1} to L^{a4} are the same as the definitions of L⁶ and L⁷, and
R^{a1} to R^{a4} are the same as the definitions of R²⁰ to R²⁷.

For example, in Chemical Formulas 3 and 4, Ar⁵ and Ar⁶ may each independently be a substituted or unsubstituted phenyl group, a substituted or unsubstituted biphenyl group, a substituted or unsubstituted pyridinyl group, a substituted or unsubstituted carbazolyl group, a substituted or unsubstituted dibenzofuranyl group, or a substituted or unsubstituted dibenzothiophenyl group, and
R^{a1} to R^{a4} and R²⁰ to R²⁷ may each independently be hydrogen, deuterium, a cyano group, a substituted or unsubstituted phenyl group, a substituted or unsubstituted biphenyl group, a substituted or unsubstituted pyridinyl group, a substituted or unsubstituted carbazolyl group, a substituted or unsubstituted dibenzofuranyl group, or a substituted or unsubstituted dibenzothiophenyl group.

In another specific embodiment of the present invention, in Chemical Formulas 3 and 4, L⁶-Ar⁵ and L⁷-Ar⁶ may each independently be selected be from substituents listed in Group II.

In an embodiment, R^{a1} to R^{a4} and R²⁰ to R²⁷ may each independently be hydrogen, deuterium, a cyano group, a substituted or unsubstituted phenyl group, a substituted or unsubstituted biphenyl group, a substituted or unsubstituted pyridinyl group, a substituted or unsubstituted carbazolyl group, a substituted or unsubstituted dibenzofuranyl group, or a substituted or unsubstituted dibenzothiophenyl group.

For example, R^{a1} to R^{a4} and R²⁰ to R²⁷ may each independently be hydrogen, deuterium, a cyano group, or a substituted or unsubstituted phenyl group, and
in a specific embodiment, R^{a1} to R^{a4}, and R²⁰ to R²⁷ may each independently be hydrogen, deuterium, or a phenyl group.

For example, the second compound for the organic optoelectronic device may be, for example, one selected from compounds of Group 2, but is not limited thereto.

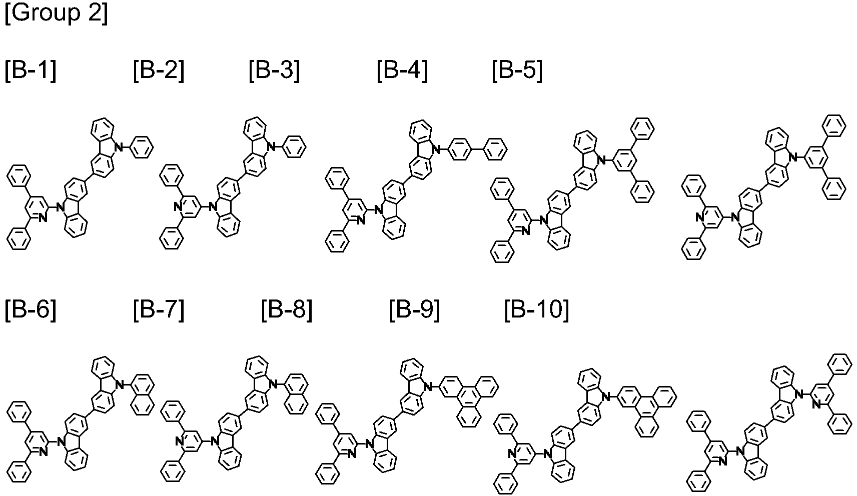

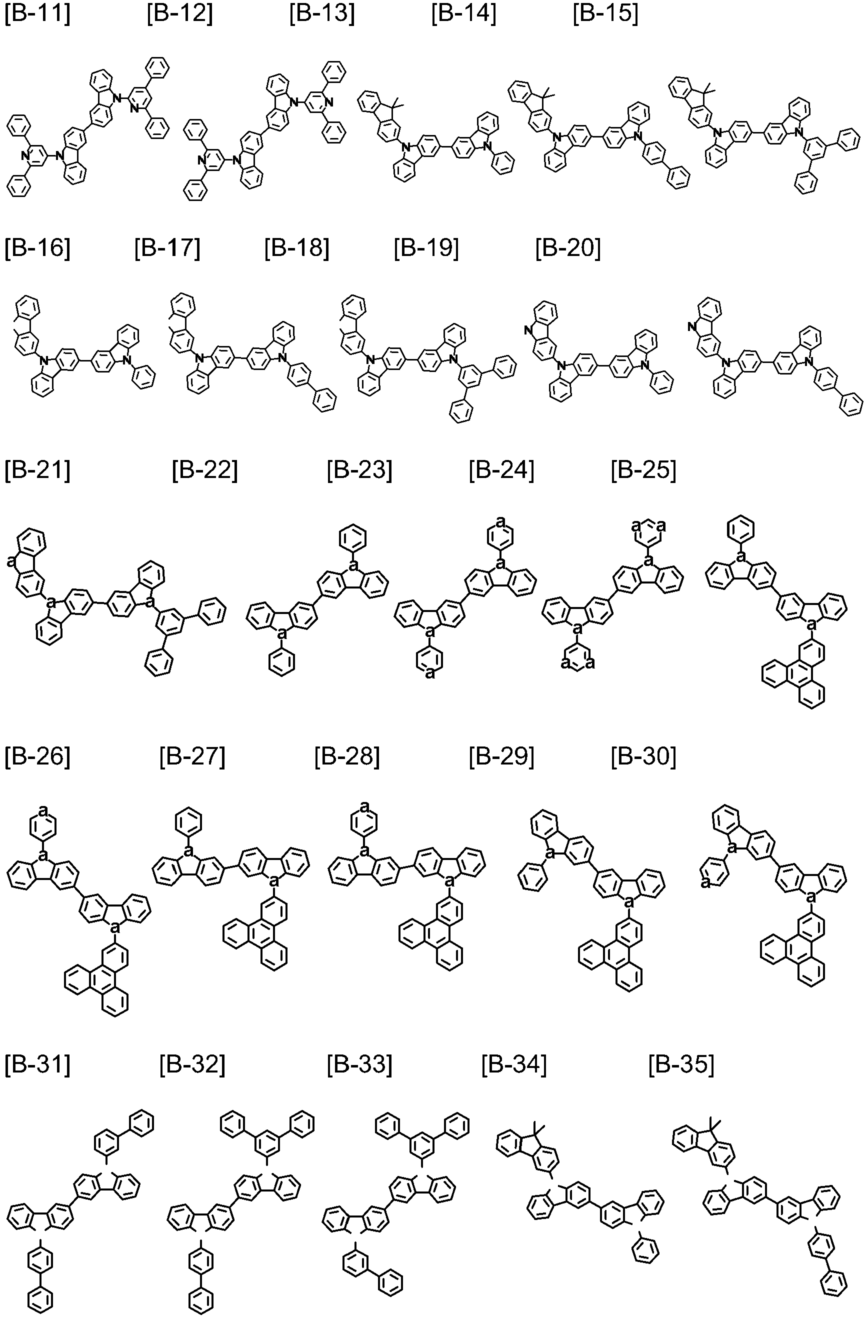

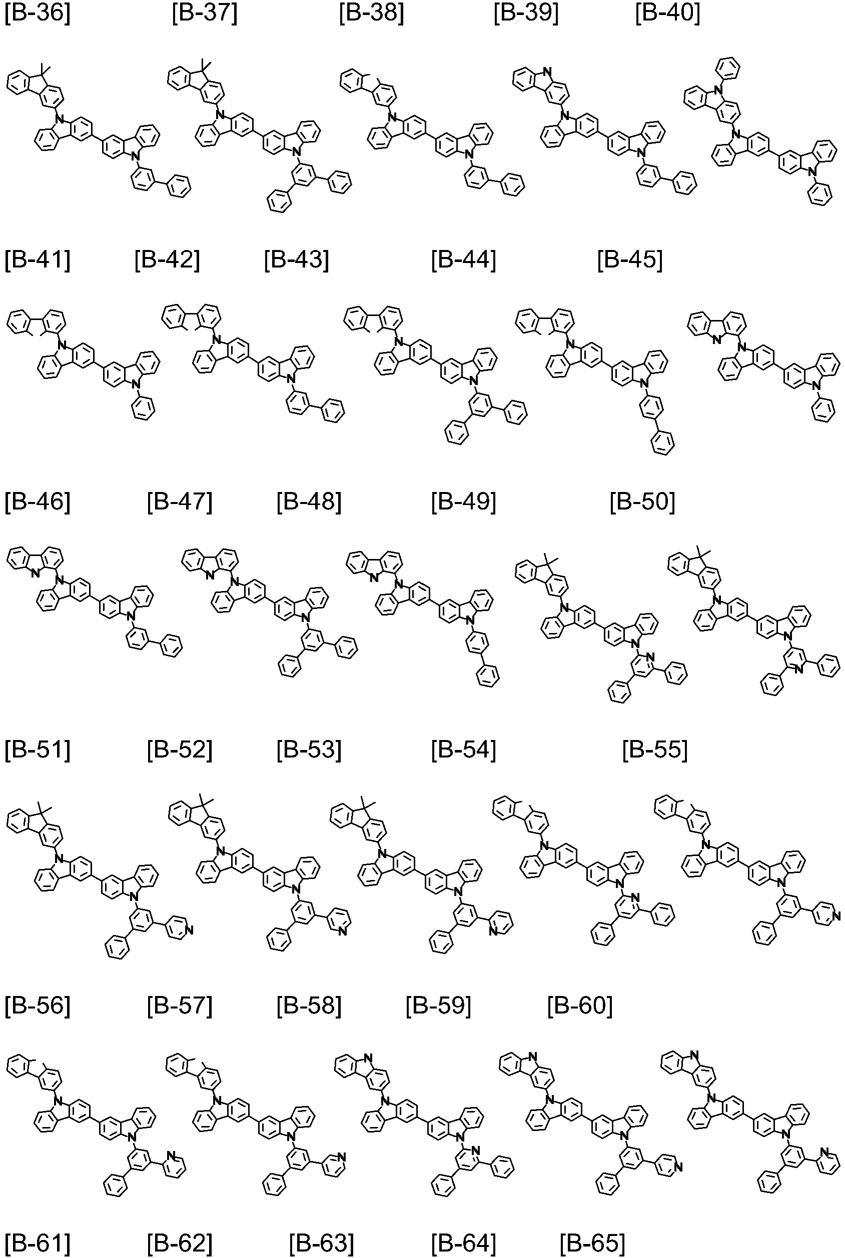

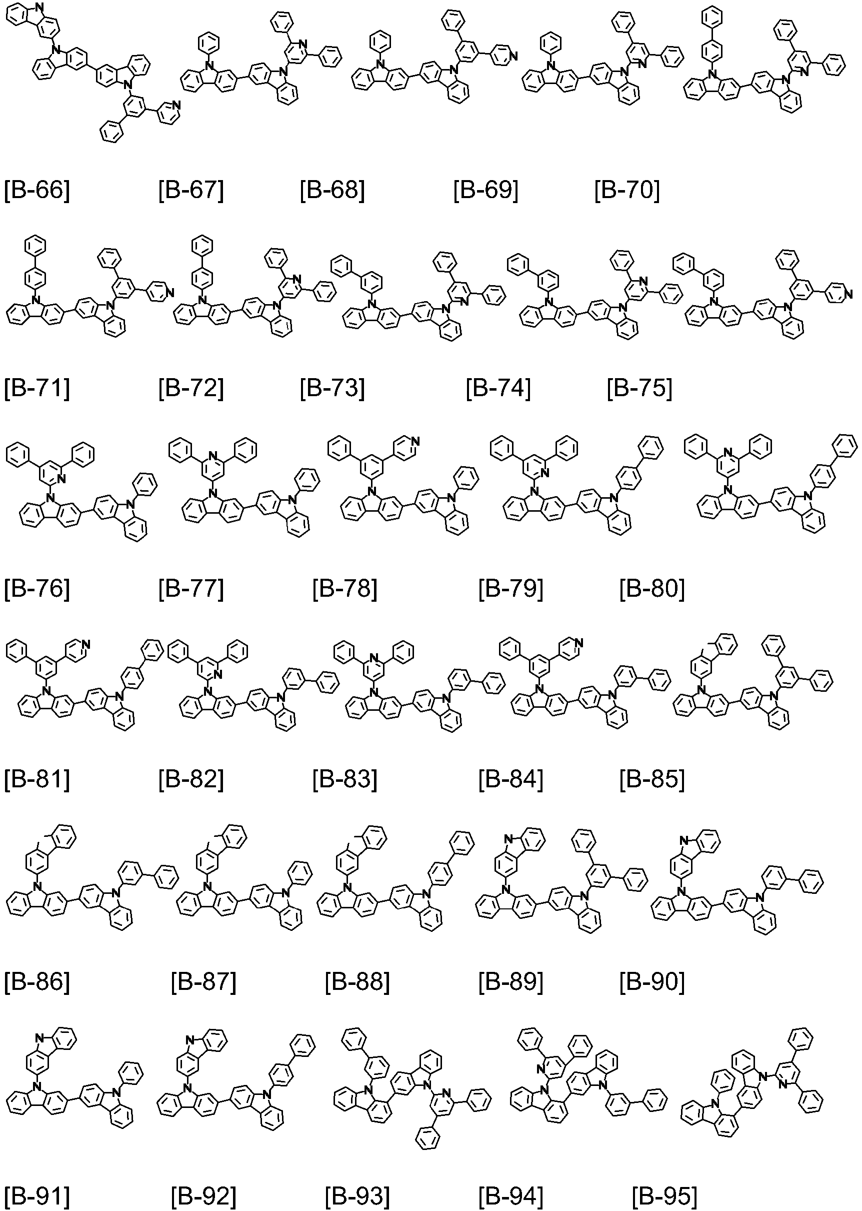

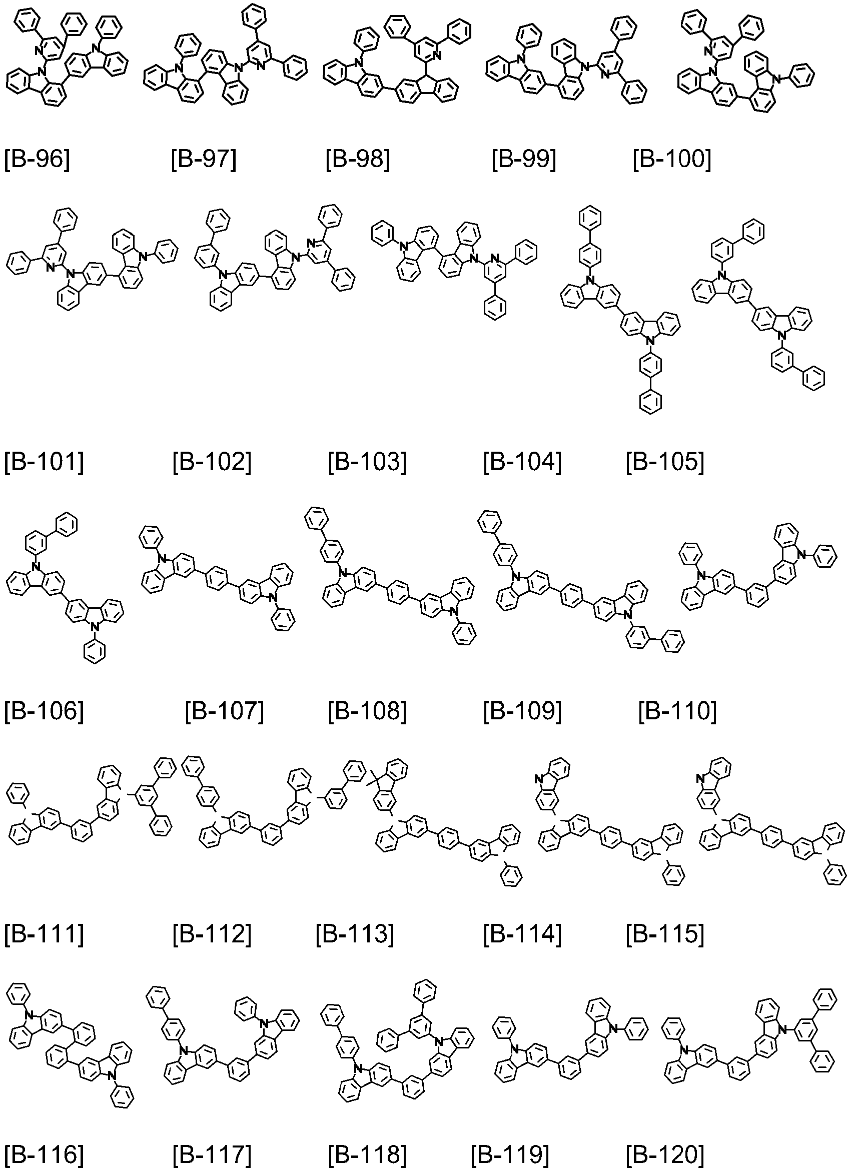

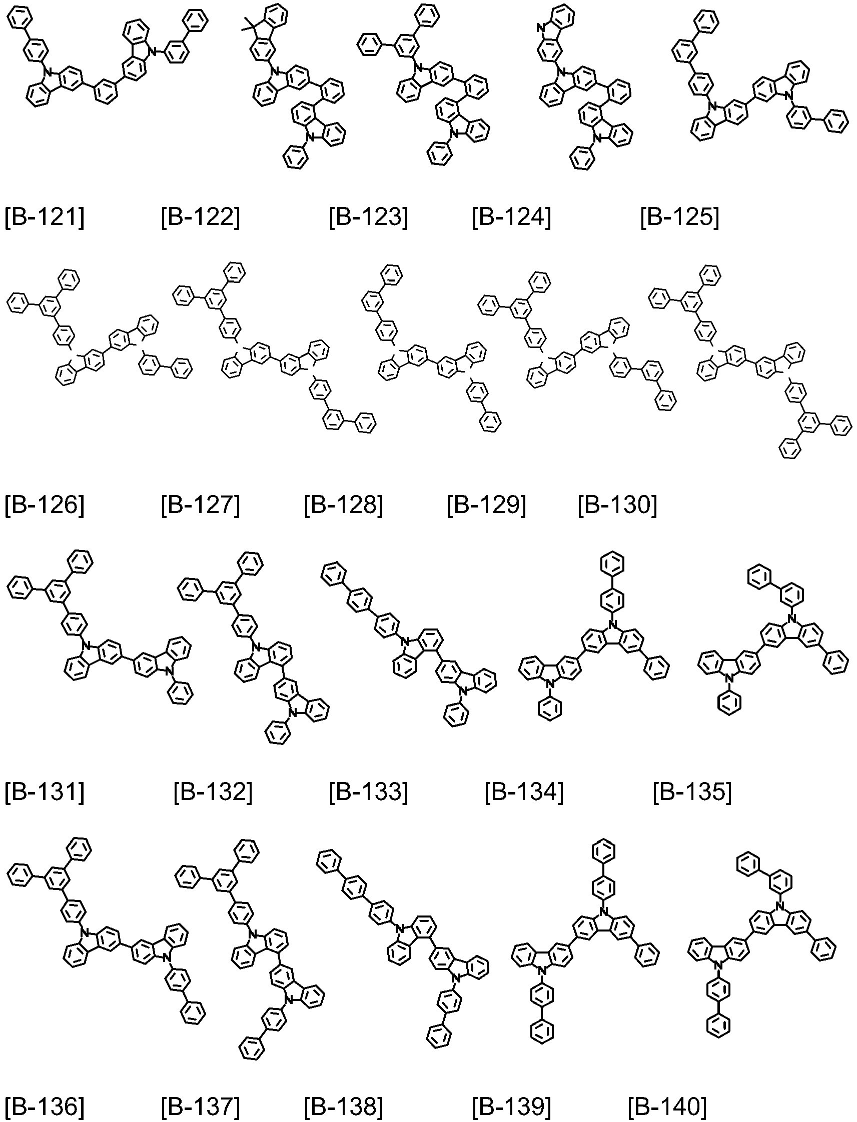

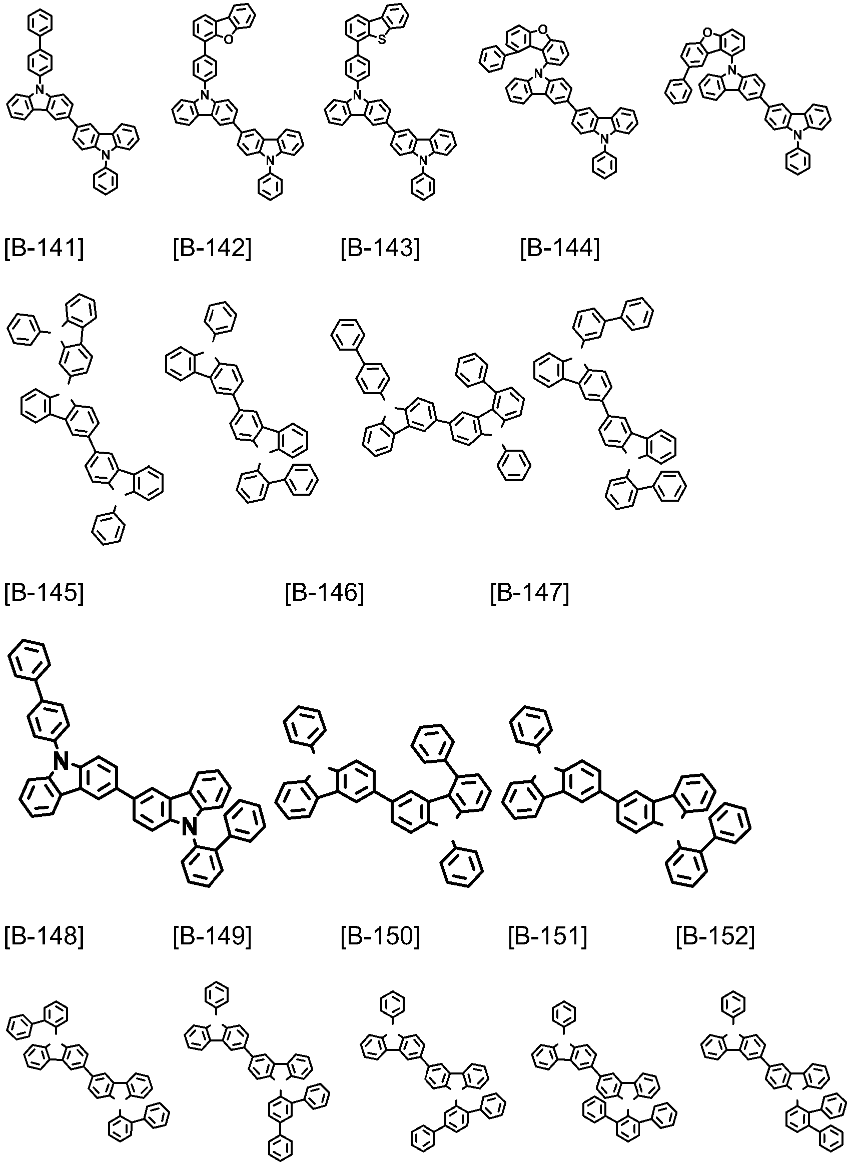

Additionally, examples of Compound B-1 to Compound B-152 listed in Group 2 in which at least one hydrogen is replaced with deuterium are given below, but are not limited thereto.

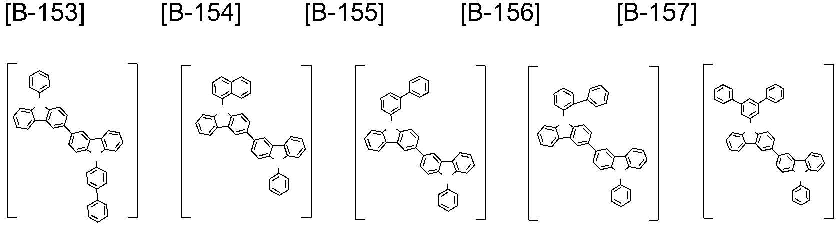

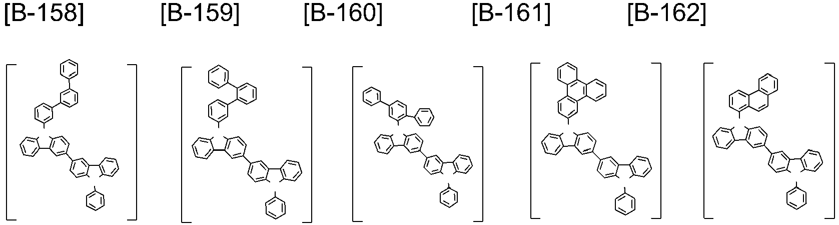

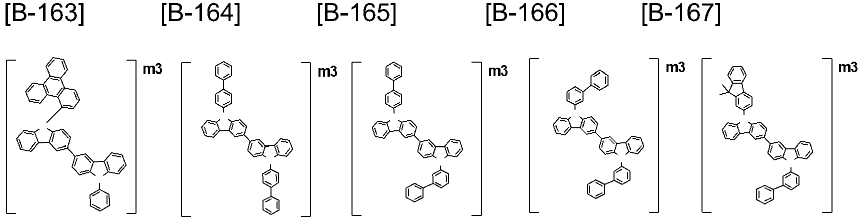

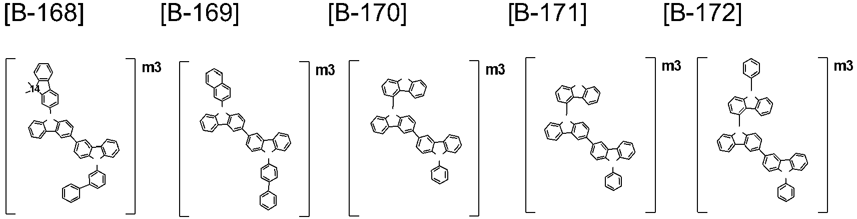

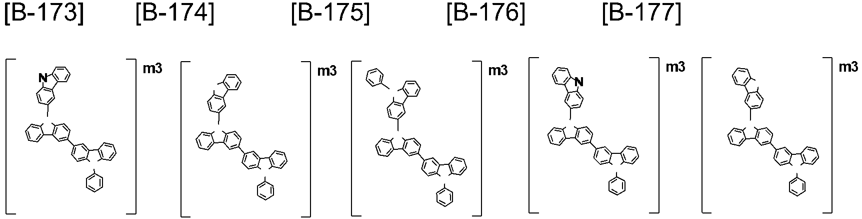

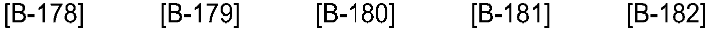

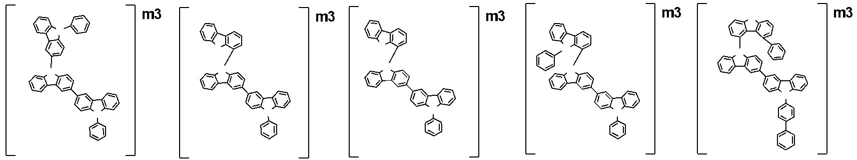

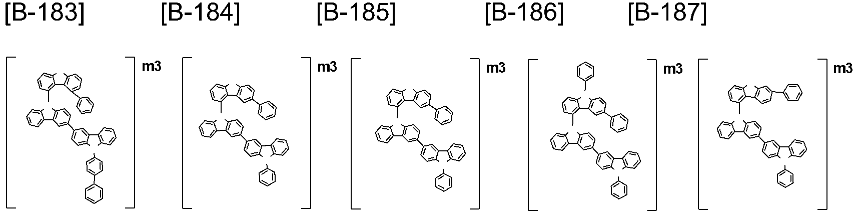

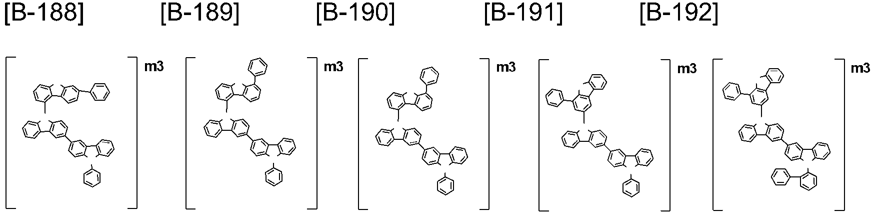

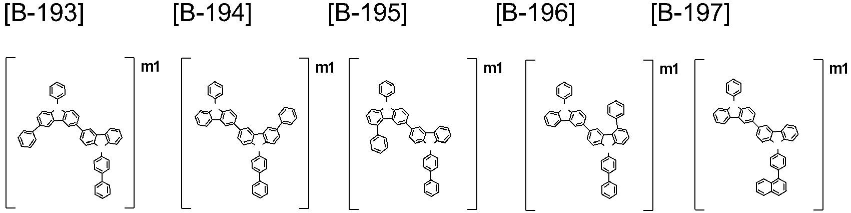

### (Dn means the number of substituted deuterium and indicates a structure that one or more deuteriums are substituted)

For Compound B-153 to Compound B-197 of Group 2, the most specific structures are presented below only as examples according to the deuterium substitution position and substitution rate, and are not intended to limit the scope of rights to compounds not presented below.

The scope of the present invention is determined by the claims, and if substituted with deuterium, the present invention is not limited to the compounds exemplified below but may include all changeable ranges within the above range of Compound B-1 to Compound B-197 according to a deuterium substitution position and deuterium substitution rate, and the like.

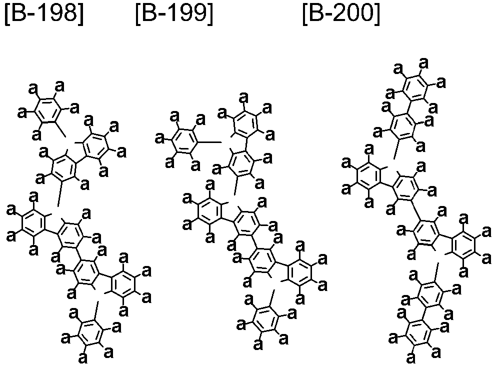

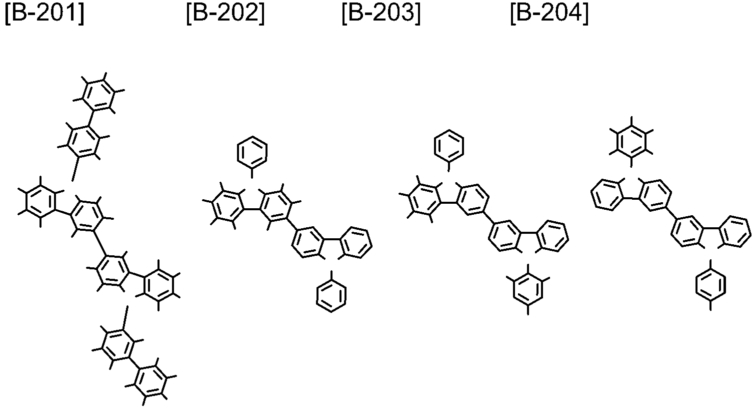

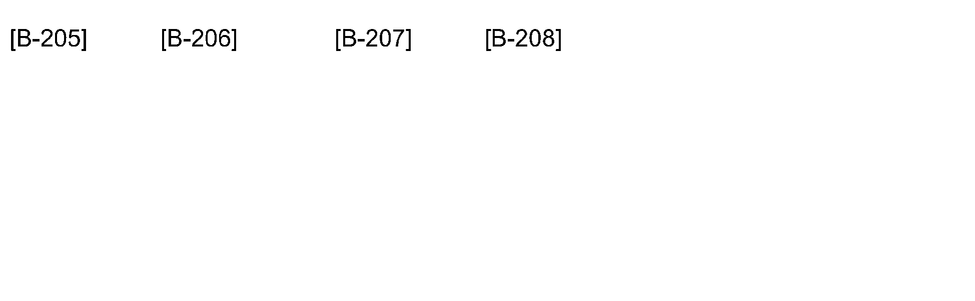

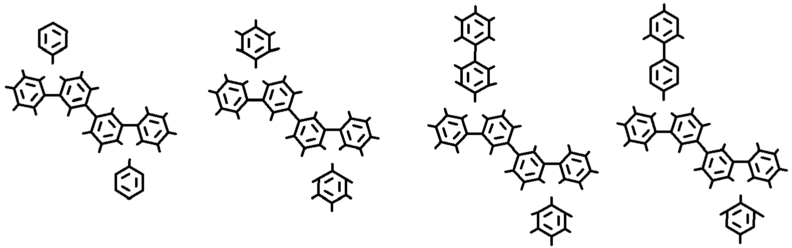

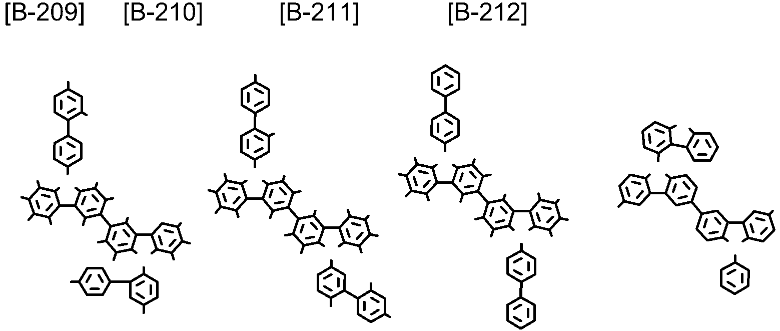

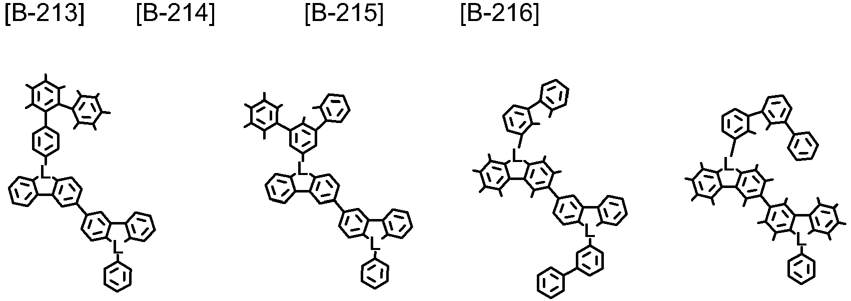

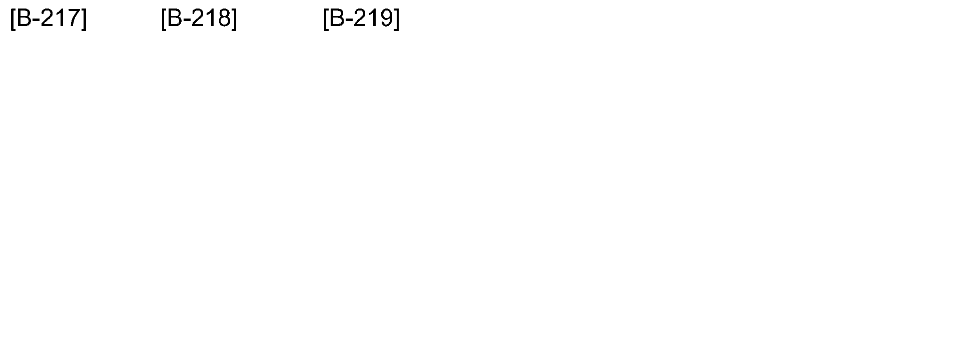

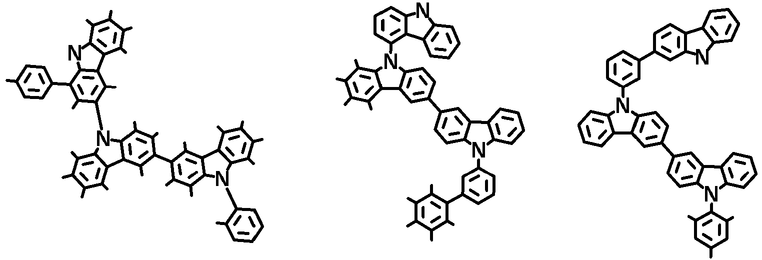

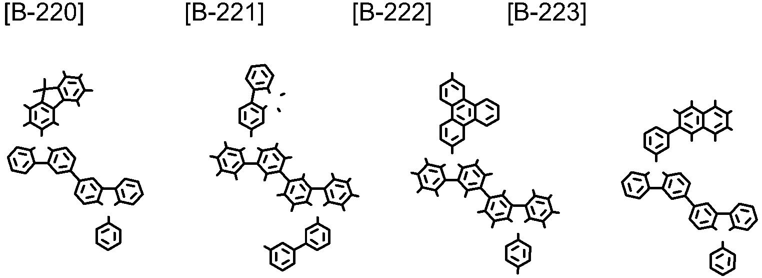

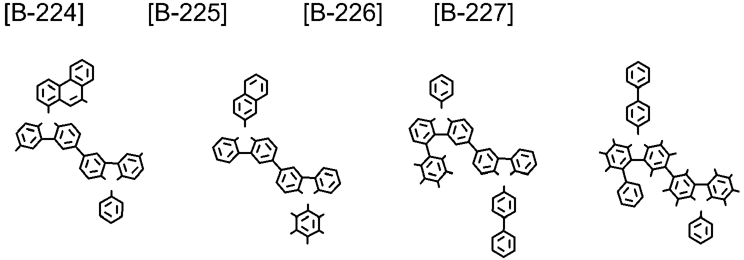

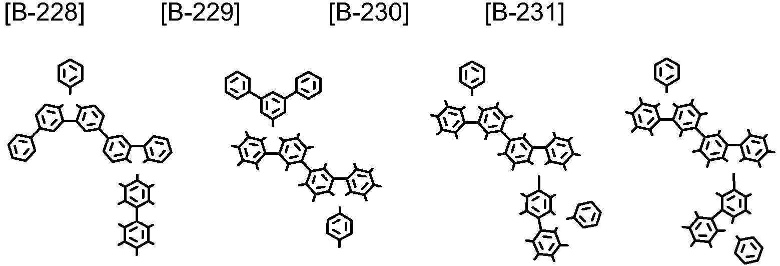

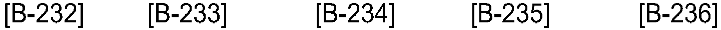

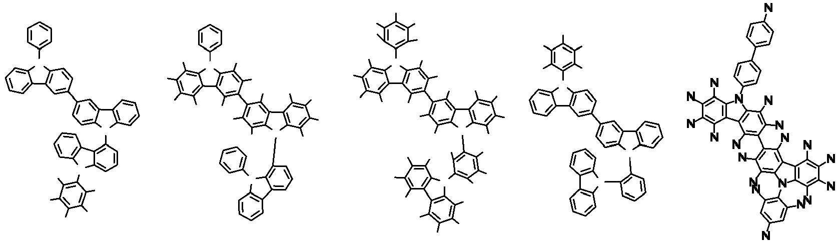

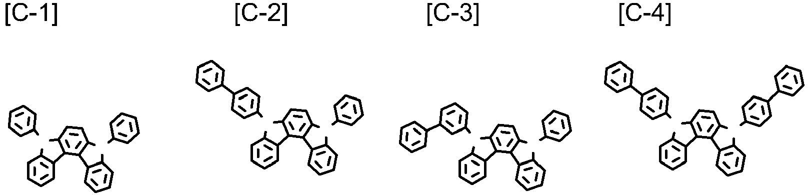

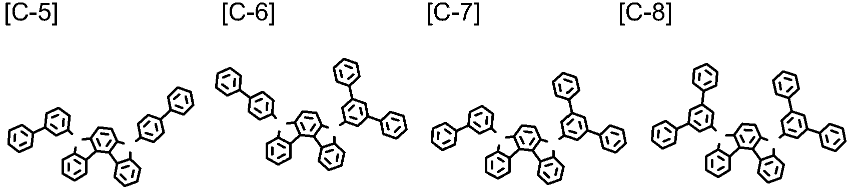

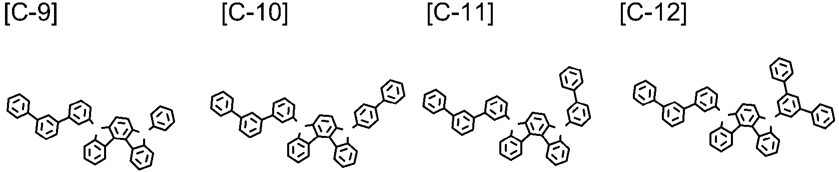

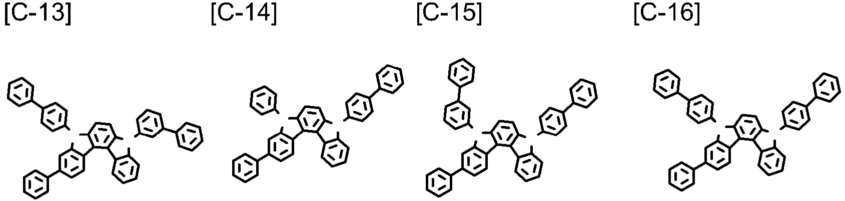

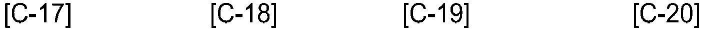

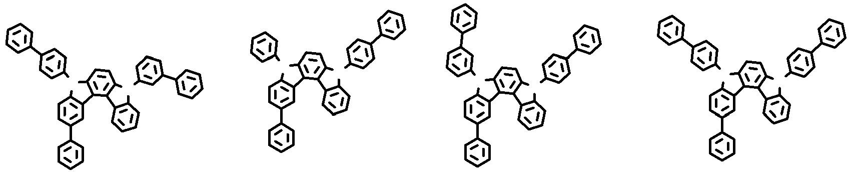

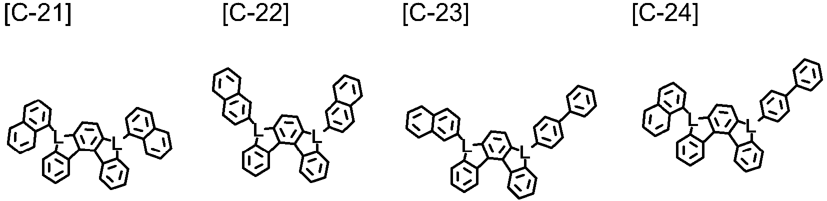

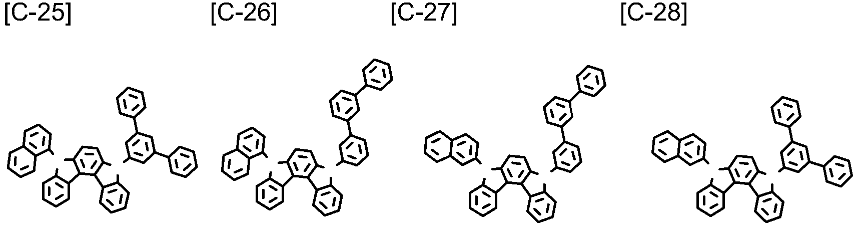

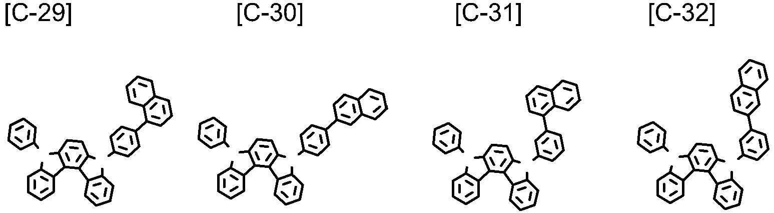

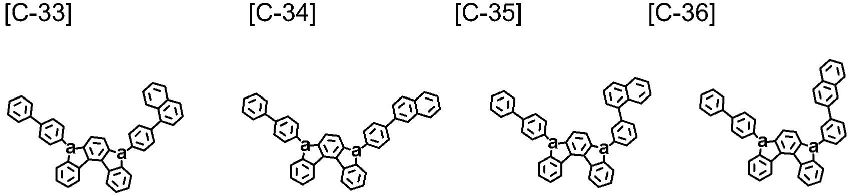

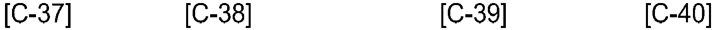

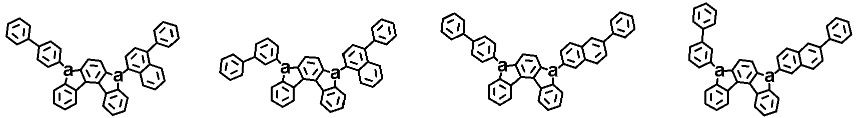

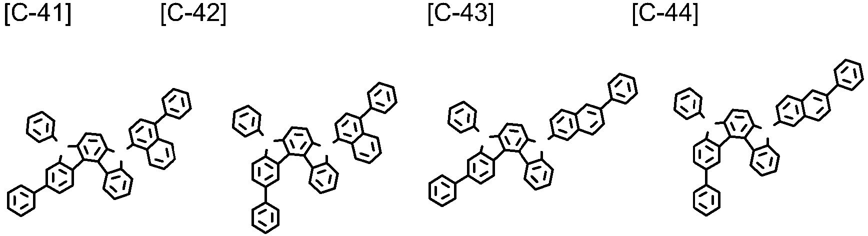

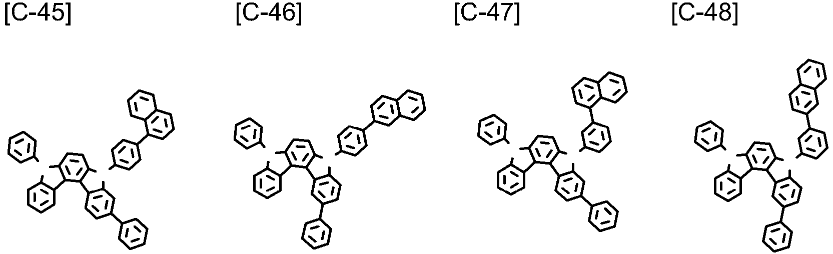

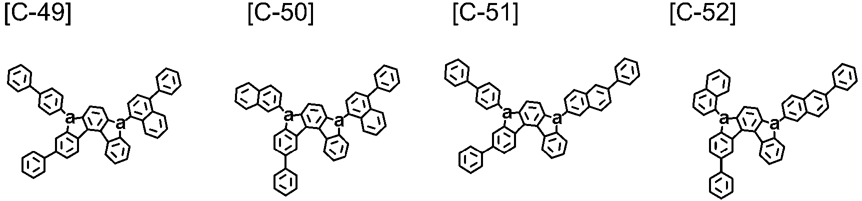

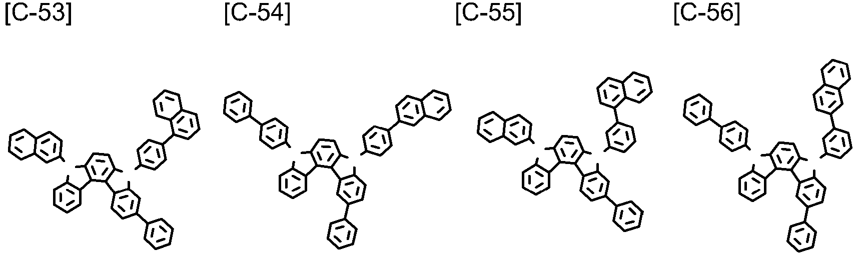

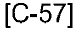

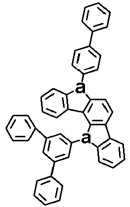

Additionally, examples of Compound C-1 to Compound C-57 listed in Group 2 in which at least one hydrogen is replaced with deuterium are given below, but are not limited thereto.

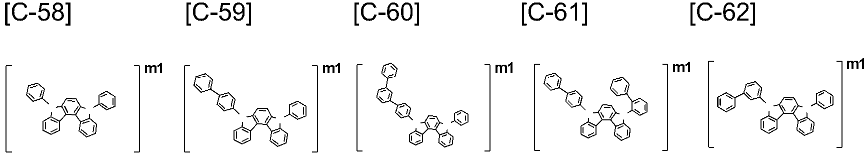

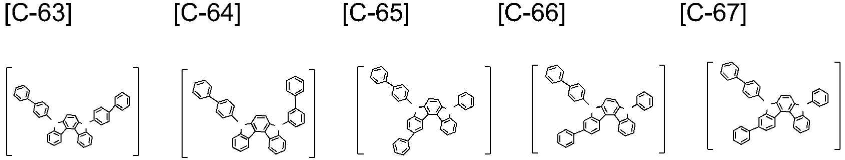

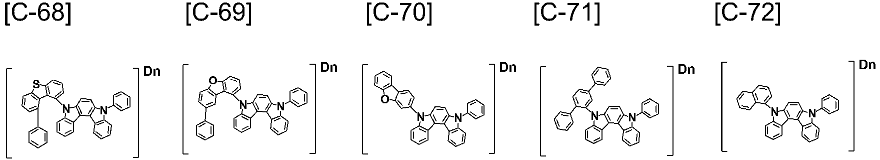

### (Dn means the number of substituted deuterium and indicates a structure that one or more deuteriums are substituted)

For Compound C-58 to Compound C-72 of Group 2, the most specific structures are presented below only as examples according to the deuterium substitution position and substitution rate, and are not intended to limit the scope of rights to compounds not presented below.

The scope of the present invention is determined by the claims, and if substituted with deuterium, the present invention is not limited to the compounds exemplified below but may include all changeable ranges within the above range of Compound C-1 to Compound C-72 according to a deuterium substitution position and deuterium substitution rate, and the like.

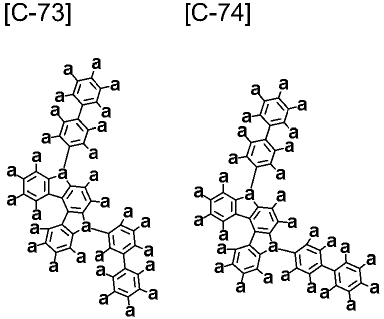

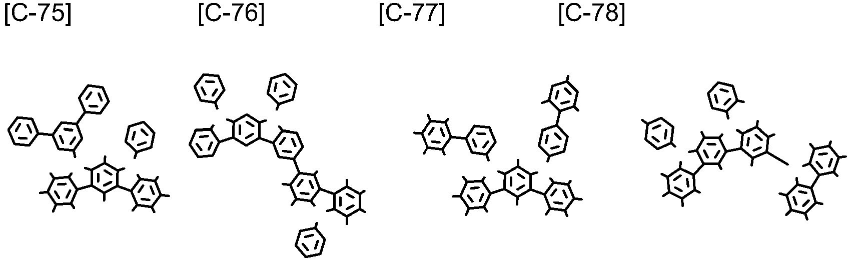

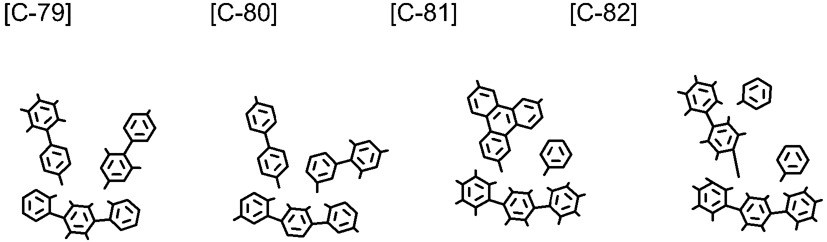

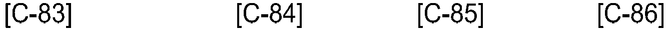

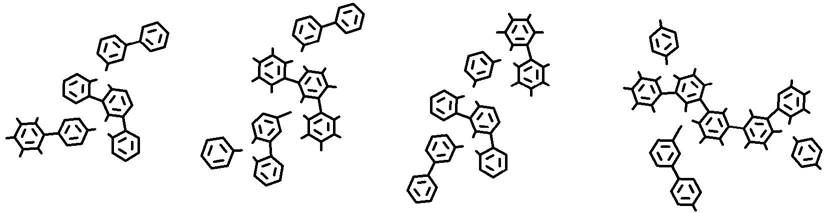

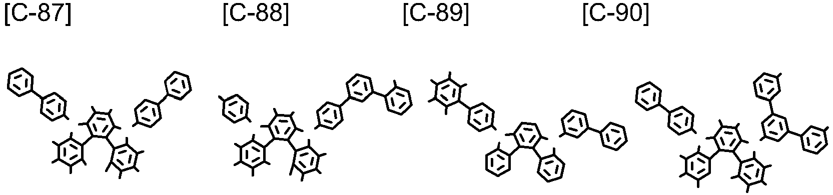

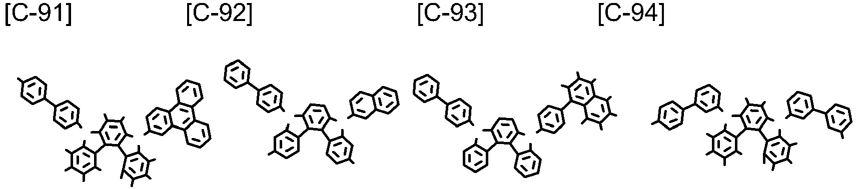

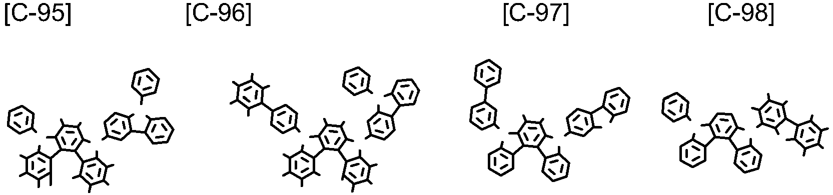

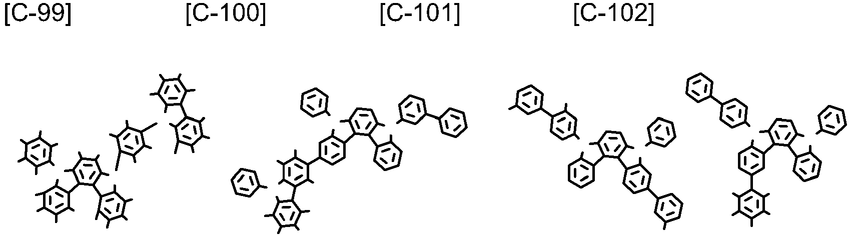

One type or two or more types of the second compound may be used.

In the light emitting layer 32, the first compound and the second compound may be included as a host, and may be included in a weight ratio of, for example, about 1:99 to 99:1. Within the above range, bipolar properties may be implemented by matching an appropriate weight ratio using electron transport capability of the first compound and the hole transport capability of the second compound, to improve efficiency and life-span. Within this range, for example, they may be included in a weight ratio of about 10:90 to 90:10, about 20:80 to 80:20, for example about 20:80 to about 70: 30, about 20:80 to about 60:40, and about 20:80 to about 50:50. As a specific example, they may be included in a weight ratio of about 20:80, 30:70, or 40:60.

The light emitting layer 32 may further include one or more compounds other than the aforementioned first compound and second compound as a host.

The light emitting layer 32 may further include a dopant.

The dopant may be, for example, a phosphorescent dopant, for example, a red, green, or blue phosphorescent dopant, and may be, for example, a red or green phosphorescent dopant.

The dopant is a material mixed with the compound for the organic optoelectronic device in a small amount to cause light emission, and may be generally a material such as a metal complex that emits light by multiple excitation into a triplet or more. The dopant may be, for example an inorganic, organic, or organic/inorganic compound, and one or more types thereof may be used.

Examples of the dopant may be a phosphorescent dopant and examples of the phosphorescent dopant may be an organometal compound including Ir, Pt, Os, Ti, Zr, Hf, Eu, Tb, Tm, Fe, Co, Ni, Ru, Rh, Pd, or a combination thereof. The phosphorescent dopant may be, for example a compound represented by Chemical Formula Z, but is not limited thereto.

[Chemical Formula Z] L⁹MX¹

In Chemical Formula Z, M is a metal, and L⁹ and X¹ are the same or different and are a ligand to form a complex compound with M.

The M may be for example Ir, Pt, Os, Ti, Zr, Hf, Eu, Tb, Tm, Fe, Co, Ni, Ru, Rh, Pd, or a combination thereof and L⁹ and X¹ may be for example a bidentate ligand.

Examples of ligands represented by L⁹ and X¹ may be selected from the Chemical Formulas listed in Group A, but are not limited thereto.

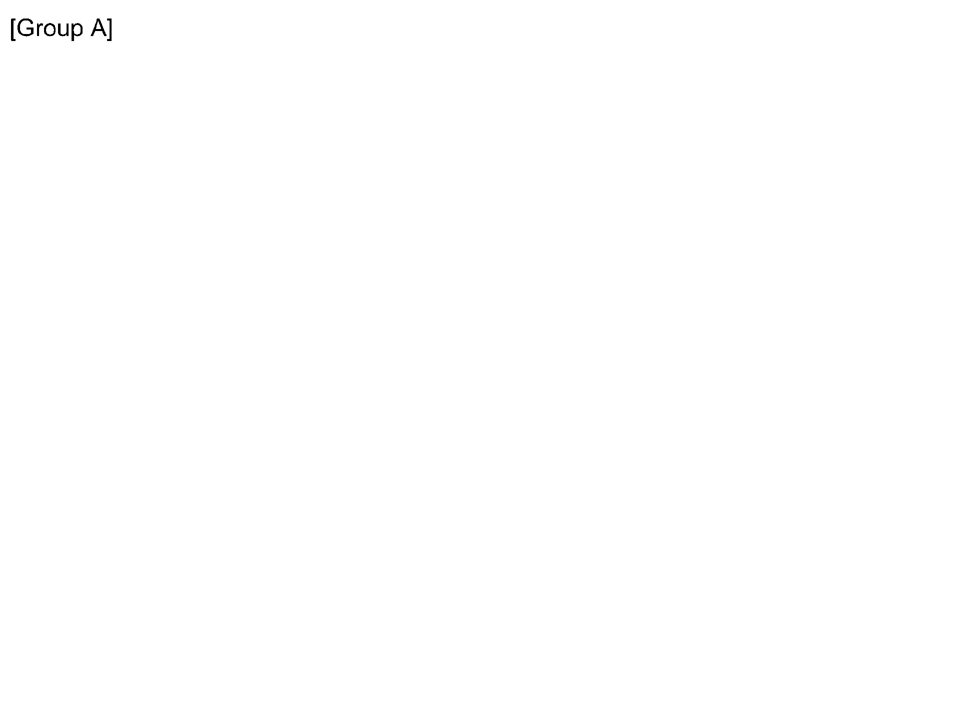

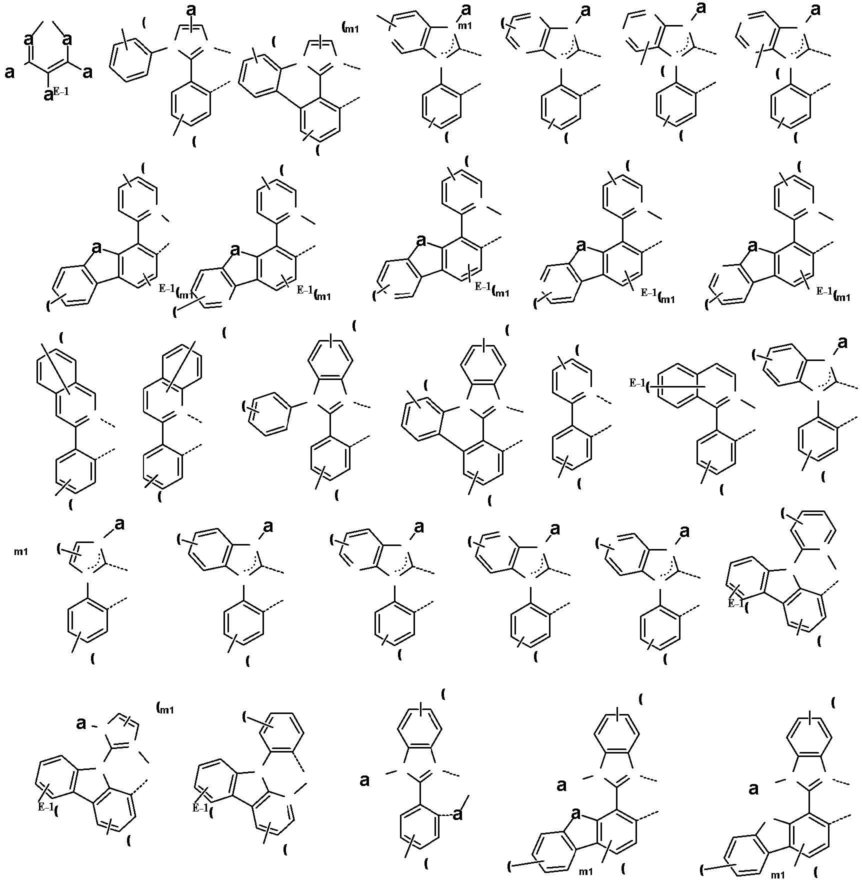

In Group A,
R³⁰⁰ to R³⁰² are each independently hydrogen, deuterium, a C1 to C30 alkyl group that is substituted or unsubstituted with a halogen, a C6 to C30 aryl group that is substituted or unsubstituted with a C1 to C30 alkyl, or a halogen, and
R³⁰³ to R³²⁴ are each independently hydrogen, deuterium, halogen, a substituted or unsubstituted C1 to C30 alkyl group, a substituted or unsubstituted C1 to C30 alkoxy group, a substituted or unsubstituted C3 to C30 cycloalkyl group, a substituted or unsubstituted C2 to C30 alkenyl group, a substituted or unsubstituted C6 to C30 aryl group, a substituted or unsubstituted C1 to C30 heteroaryl group, a substituted or unsubstituted C1 to C30 amino group, a substituted or unsubstituted C6 to C30 arylamino group, SF₅, a trialkylsilyl group having a substituted or unsubstituted C1 to C30 alkyl group, a dialkylarylsilyl group having a substituted or unsubstituted C1 to C30 alkyl group and a C6 to C30 aryl group, or a triarylsilyl group having a substituted or unsubstituted C6 to C30 aryl group.

In an embodiment, the dopant may be an iridium complex, and may be represented by, for example, Chemical Formula V-1 or Chemical Formula V-2.

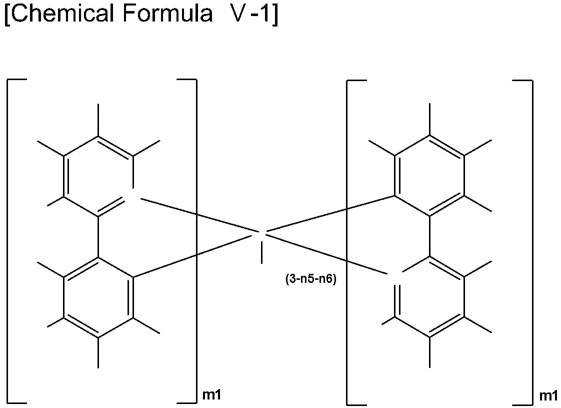

In Chemical Formula V-1,
R¹⁰¹ to R¹¹⁶ are each independently hydrogen, deuterium, a substituted or unsubstituted C1 to C10 alkyl group, a substituted or unsubstituted C6 to C20 aryl group, or -SiR¹³²R¹³³R¹³⁴,
R¹³² to R¹³⁴ are each independently a substituted or unsubstituted C1 to C6 alkyl group,
at least one of R¹⁰¹ to R¹¹⁶ is a functional group represented by Chemical Formula 6,
L¹⁰⁰ is a bidentate ligand of a monovalent anion, and is a ligand that coordinates to iridium through a lone pair of carbons or heteroatoms, and
n5 and n6 are each independently any one of integers of 0 to 3, and n5 + n6 is any one of integers of 1 to 3, 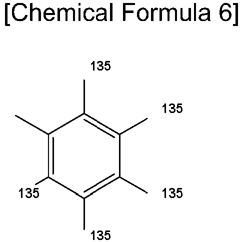
wherein, in Chemical Formula 6,
R¹³⁵ to R¹³⁹ are each independently hydrogen, deuterium, a substituted or unsubstituted C1 to C10 alkyl group, a substituted or unsubstituted C6 to C20 aryl group, or -SiR¹³²R¹³³R¹³⁴, and
* refers to a portion linked to a carbon atom. 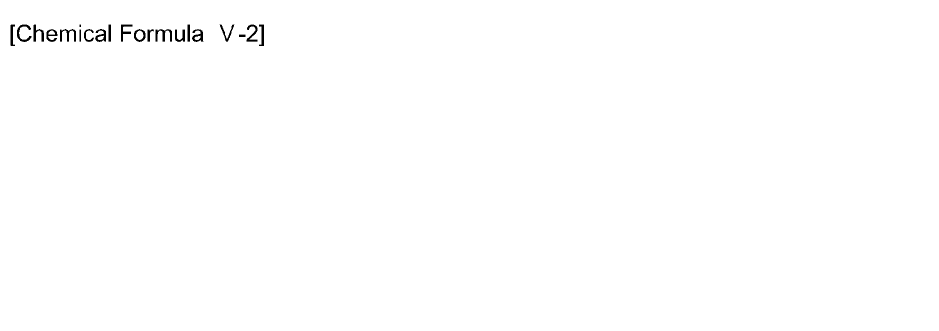 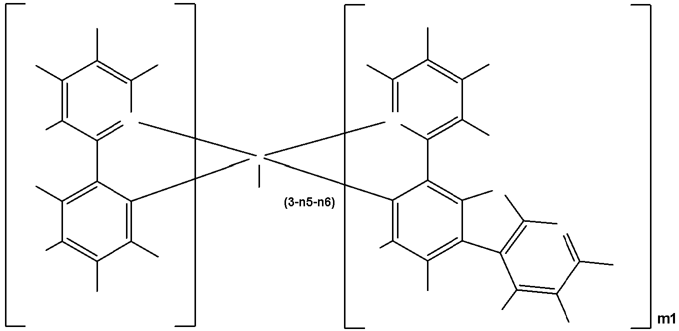
wherein, in Chemical Formula V-2,
R¹⁰¹ to R¹¹⁷ are each independently hydrogen, deuterium, a substituted or unsubstituted C1 to C10 alkyl group, a substituted or unsubstituted C6 to C20 aryl group, or -SiR¹³³R¹³⁴R¹³⁵,
R¹³³ to R¹³⁵ are each independently a substituted or unsubstituted C1 to C6 alkyl group,
L¹⁰⁰ is a bidentate ligand of a monovalent anion, and is a ligand that coordinates to iridium through a lone pair of carbons or heteroatoms, and
n1 and n2 are each independently any one of integers of 0 to 3, and n1 + n2 is any one of integers of 1 to 3.

In another embodiment, the dopant may be a platinum complex, for example represented by Chemical Formula Z-1.

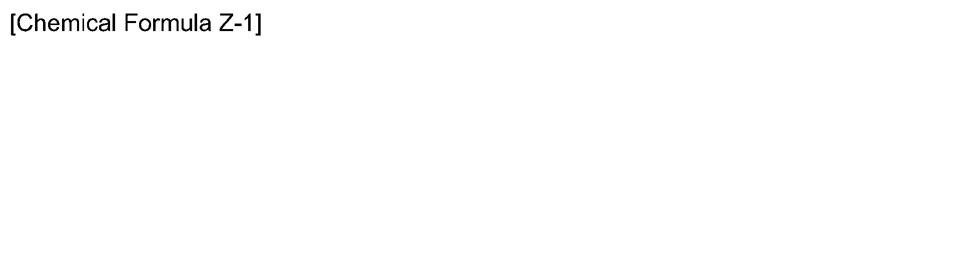

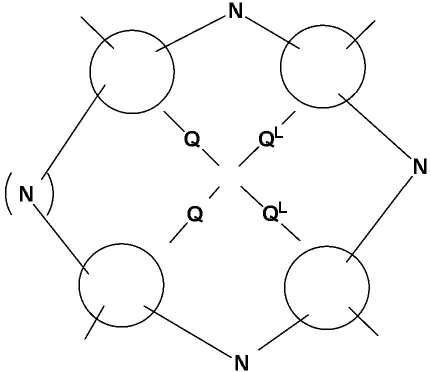

In Chemical Formula Z-1, rings A, B, C, and D independently represent a 5-membered or 6-membered carbocyclic or heterocyclic ring;
R^{A}, R^{B}, R^{C}, and R^{D} independently represent mono-, di-, tri-, or tetra-substitution, or unsubstitution;
L^{B}, L^{C}, and L^{D} are each independent selected from a direct bond, BR, NR, PR, O, S, Se, C=O, S=O, SO₂, CRR', SiRR', GeRR', and a combination thereof;
when nA is 1, L^{E} is selected from a direct bond, BR, NR, PR, O, S, Se, C=O, S=O, SO₂, CRR', SiRR', GeRR', and a combination thereof; when nA is 0, L^{E} does not exist; and
R^{A}, R^{B}, R^{C}, R^{D}, R, and R' are each independently selected from hydrogen, deuterium, a halogen, alkyl group, a cycloalkyl group, a heteroalkyl group, an arylalkyl group, an alkoxy group, an aryloxy group, an amino group, a silyl group, an alkenyl group, a cycloalkenyl group, a heteroalkenyl group, an alkynyl group, an aryl group, a heteroaryl group, an acyl group, a carbonyl group, a carboxylic acid group, an ester group, a nitrile group, an isonitrile group, a sulfanyl group, a sulfinyl group, a sulfonyl group, a phosphino group, and a combination thereof; any adjacent R^{A}, R^{B}, R^{C}, R^{D}, R, and R' are optionally linked to each other to provide a ring; X^{B}, X^{C}, X^{D}, and X^{E} are each independently selected from carbon and nitrogen; and Q¹, Q², Q³, and Q⁴ each represent oxygen or a direct bond.

The dopant according to an embodiment may be a platinum complex, and may be, for example, represented by Chemical Formula VI-1 or Chemical Formula VI-2.

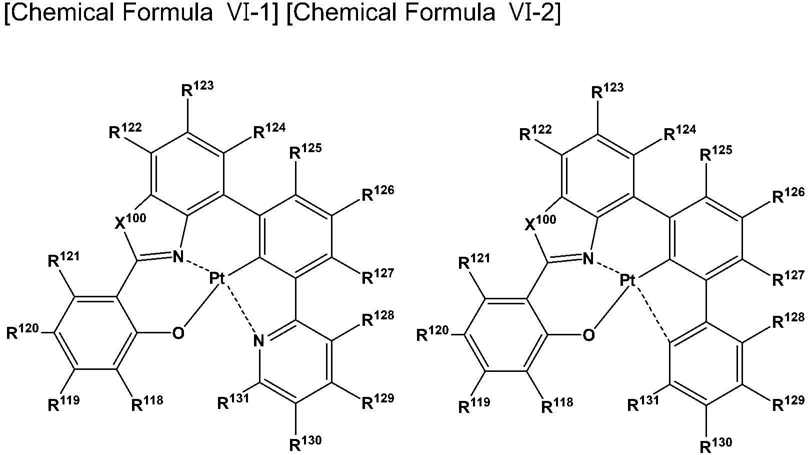

In Chemical Formula VI-1 and Chemical Formula VI-2,
X¹⁰⁰ is selected from O, S, and NR¹³¹,
R¹¹⁸ to R¹³² are each independently hydrogen, deuterium, a substituted or unsubstituted C1 to C10 alkyl group, a substituted or unsubstituted C6 to C20 aryl group, or -SiR¹³³R¹³⁴R¹³⁵,
R¹³³ to R¹³⁵ are each independently a substituted or unsubstituted C1 to C6 alkyl group, and
at least one of R¹¹⁸ to R¹³² is -SiR¹³³R¹³⁴R¹³⁵ or a tert-butyl group.

The hole transport auxiliary layer 33 includes a third compound having bipolar characteristics having relatively strong hole characteristics.

As described above, the light emitting layer 32 includes the first compound having bipolar characteristics in which electron characteristics are relatively strong and the second compound having relatively strong hole characteristics and thereby increases mobility of electrons and holes and remarkably improves luminous efficiency compared with the compounds alone.

When a material having biased electron or hole characteristics is used to form a light emitting layer, excitons in a device including the light emitting layer are relatively more generated due to recombination of carriers on the interface between the light emitting layer and the electron or hole transport layer. As a result, the molecular excitons in the light emitting layer interact with charges on the interface of the hole transport layer and thus, cause a roll-off of sharply deteriorating efficiency and also, sharply deteriorate light emitting life-span characteristics.

In order to solve the problems, the first and second compounds are simultaneously included in the light emitting layer to make a light emitting region not be biased to either of the electron transport layer or the hole transport layer, and additionally, the hole transport auxiliary layer including the third compound having relatively strong hole characteristics is disposed between the hole transport layer and the light emitting layer, and thereby charges are prevented from being accumulated at the interface between the hole transport layer and the light emitting layer and a device capable of adjusting carrier balance in the light emitting layer may be provided. Accordingly, roll-off characteristics of an organic optoelectronic device may be improved and simultaneously life-span characteristics may be remarkably improved.

The third compound may be represented by Chemical Formula 5.

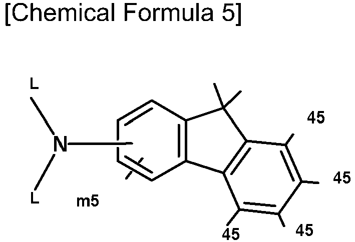

In Chemical Formula 5,
Ar⁸ and Ar⁹ are each independently a substituted or unsubstituted C6 to C30 aryl group, or a substituted or unsubstituted C2 to C30 heterocyclic group,
Ar¹⁰ and Ar¹¹ are each independently a substituted or unsubstituted C1 to C30 alkyl group, or a substituted or unsubstituted C6 to C30 aryl group,
R⁴¹ to R⁴⁵ are each independently hydrogen, deuterium, a cyano group, a halogen, a substituted or unsubstituted C1 to C30 alkyl group, a substituted or unsubstituted C6 to C30 aryl group, or a substituted or unsubstituted C2 to C30 heterocyclic group, and
m5 is one of integers of 1 to 3.

When m5 is 2 or more, each R⁴¹ may be the same or different from each other.

The third compound has a structure in which the amine core is substituted with at least one fluorene group.
By substituting the amine core with at least one fluorene group, the steric hindrance may be used to minimize thermal degradation by reducing the deposition temperature, thereby further improving life-span characteristics.

For example, the third compound may be represented by any one of Chemical Formula 5-1 to Chemical Formula 5-4, depending on the substitution position of fluorene.

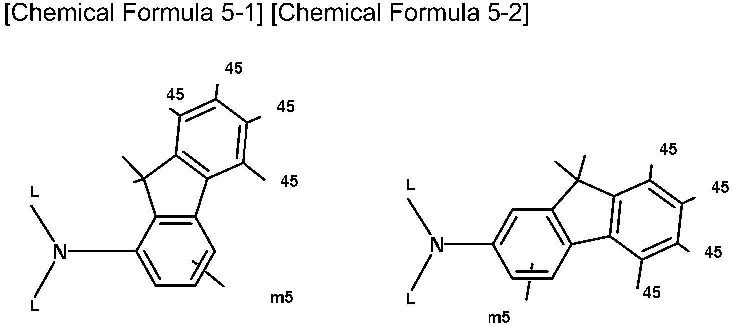

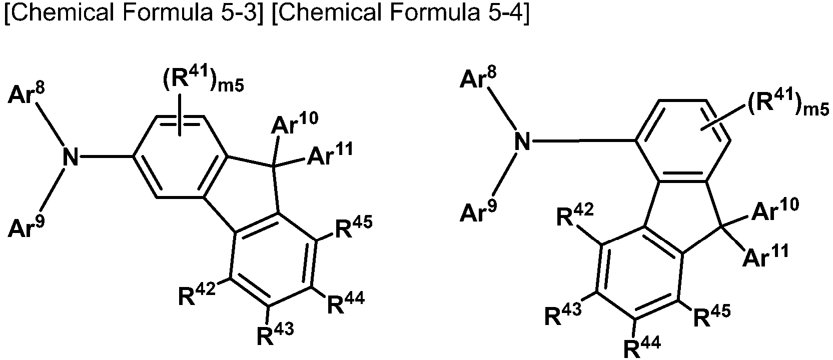

In Chemical Formula 5-1 to Chemical Formula 5-4,
Ar⁸ to Ar¹¹, R⁴¹ to R⁴⁵ and m5 are the same as described above.

For example, third compound the third compound may be represented by Chemical Formula 5-4.

In Chemical Formula 5, Ar⁸ and Ar⁹ may each independently be a substituted or unsubstituted phenyl group, a substituted or unsubstituted biphenyl group, a substituted or unsubstituted terphenyl group, a substituted or unsubstituted fluorenyl group, a substituted or unsubstituted spirobifluorenyl group, a substituted or unsubstituted triphenylene group, a substituted or unsubstituted dibenzofuranyl group, or a substituted or unsubstituted dibenzothiophenyl group.

For example, Ar⁸ and Ar⁹ may each independently be a substituted or unsubstituted phenyl group, a substituted or unsubstituted biphenyl group, or a substituted or unsubstituted fluorenyl group.

In Chemical Formula 5, Ar¹⁰ and Ar¹¹ may each independently be a substituted or unsubstituted C1 to C5 alkyl group, a substituted or unsubstituted C6 to C12 aryl group.

For example, Ar¹⁰ and Ar¹¹ may each independently be a substituted or unsubstituted C1 to C5 alkyl group, a substituted or unsubstituted phenyl group, or a substituted or unsubstituted biphenyl group.

In Chemical Formula 5, R⁴¹ to R⁴⁵ may each independently be hydrogen, deuterium or a substituted or unsubstituted C1 to C5 alkyl group.

For example, R⁴¹ to R⁴⁵ may each independently be hydrogen, deuterium or tert-butyl group.

At least one of Ar⁸ and Ar⁹ may be a substituted or unsubstituted fluorenyl group, and may be represented by, for example, Chemical Formula 5-4-1.

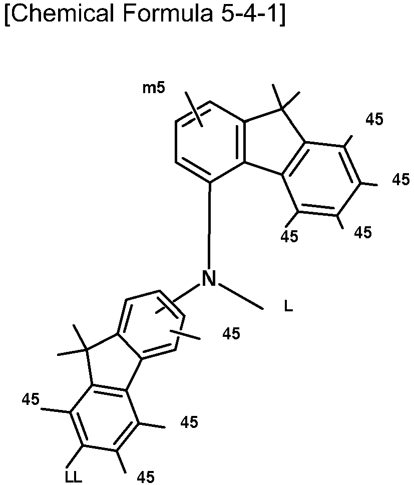

In Chemical Formula 5-4-1,
Ar⁹ to Ar¹¹, R⁴¹ to R⁴⁵ and m5 are the same as described above,
Ar¹² and Ar¹³ are each independently a substituted or unsubstituted C1 to C30 alkyl group, or a substituted or unsubstituted C6 to C30 aryl group,
R⁵³ to R⁵⁷ are each independently hydrogen, deuterium, a cyano group, a halogen, a substituted or unsubstituted C1 to C30 alkyl group, a substituted or unsubstituted C6 to C30 aryl group, or a substituted or unsubstituted C2 to C30 heterocyclic group, and
m13 is one of integers of 1 to 3.

In Chemical Formula 5-4-1, when m13 is 2 or more, each R⁵³ may be the same or different from each other.

In Chemical Formula 5-4-1, Ar¹² and Ar¹³ may each independently be a substituted or unsubstituted C1 to C5 alkyl group, or a substituted or unsubstituted C6 to C12 aryl group.

For example, Ar¹² and Ar¹³ may each independently be a substituted or unsubstituted C1 to C5 alkyl group, or a substituted or unsubstituted phenyl group, or a substituted or unsubstituted naphthyl group.

In Chemical Formula 5-4-1, R⁵³ to R⁵⁷ may each independently be hydrogen, deuterium, or a substituted or unsubstituted C1 to C5 alkyl group.

For example, R⁵³ to R⁵⁷ may each independently be hydrogen, deuterium, or a tert-butyl group.

As a more specific example, Chemical Formula 5-4-1 may be selected from Chemical Formula 5-4-1a, Chemical Formula 5-4-1b, Chemical Formula 5-4-1c, and Chemical Formula 5-4-1d.

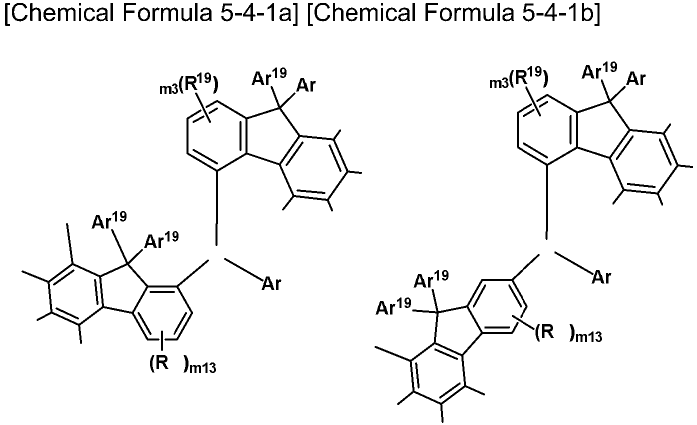

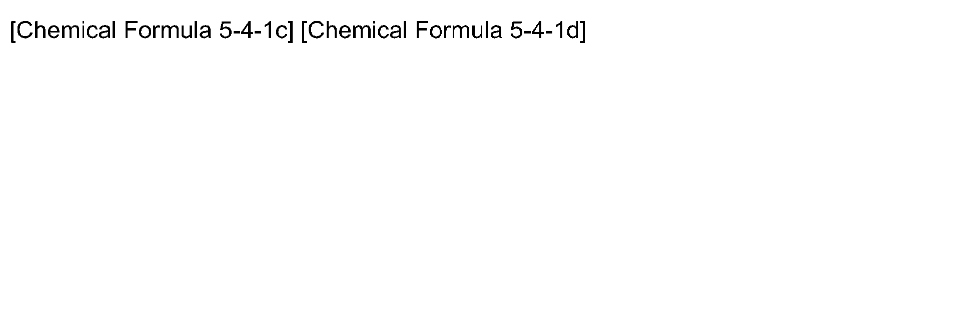

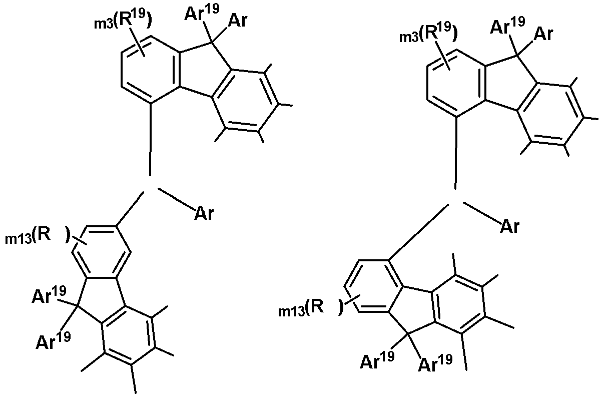

In Chemical Formula 5-4-1a, Chemical Formula 5-4-1b, Chemical Formula 5-4-1c, and Chemical Formula 5-4-1d,
Ar⁹ to Ar¹³, R⁴¹ to R⁴⁵, R⁵³ to R⁵⁷, m5 and m13 are the same as described above.
As the most specific example, third compound may be represented by Chemical Formula 5-4-1b.

For example, in Chemical Formula 5, at least two of R⁴² to R⁴⁵ may be a tert-butyl group.

An alkyl group that can improve a glass transition temperature may be introduced to improve heat resistance.

As a specific example, at least two of R⁴² to R⁴⁵ or at least two of R⁵⁴ to R⁵⁷ in Chemical Formula 5-4-1 may be a tert-butyl group.

For example, R⁴³ and R⁴⁵ in Chemical Formula 5 may each be a tert-butyl group.

For example, R43 and R45 in Chemical Formula 5-4-1 may each be a tert-butyl group.

For example, R⁵⁴ and R⁵⁶ in Chemical Formula 5-4-1 may each be a tert-butyl group.

For example, the third compound may be, for example, one selected from compounds of Group 3, but is not limited thereto.

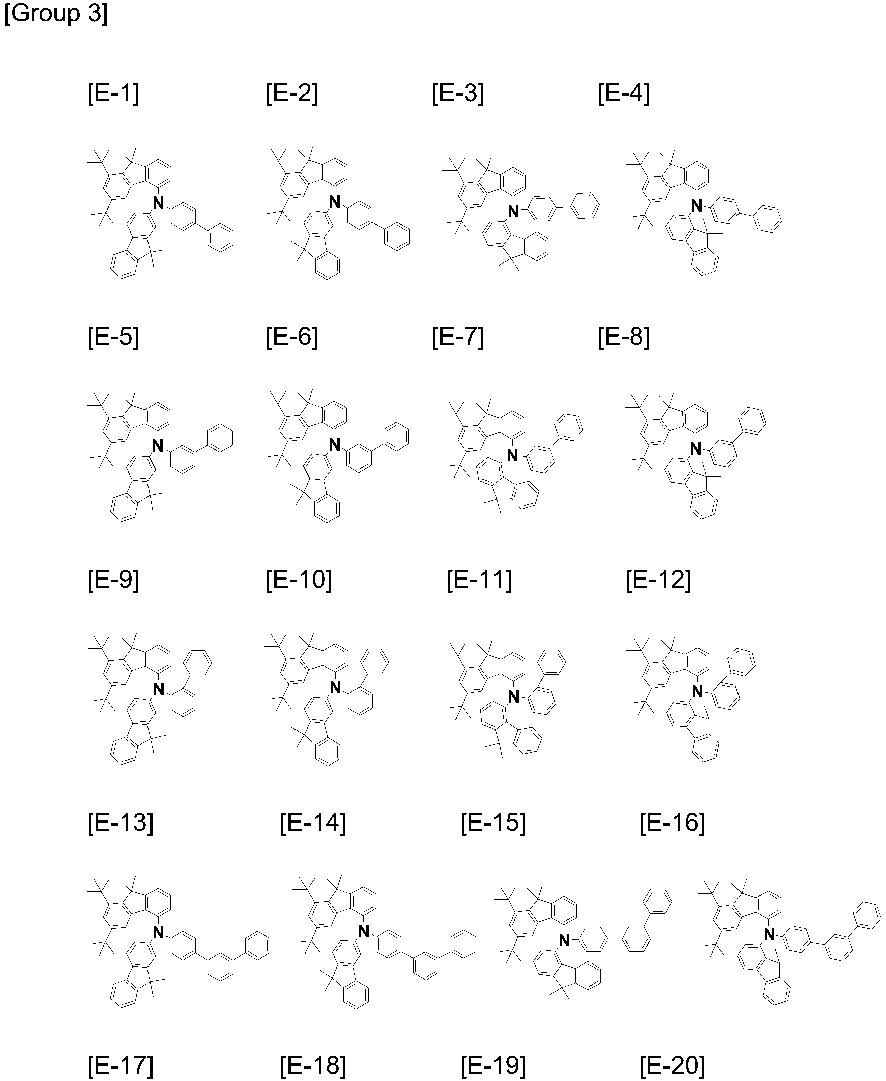

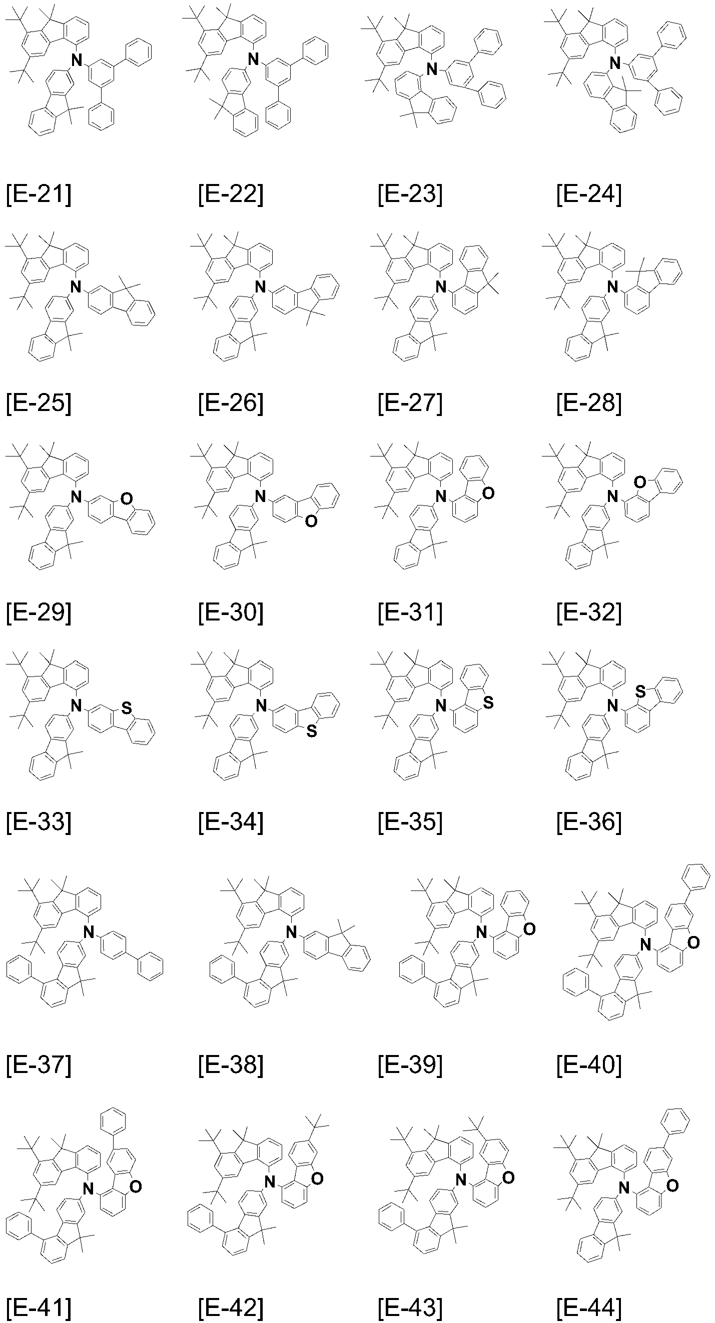

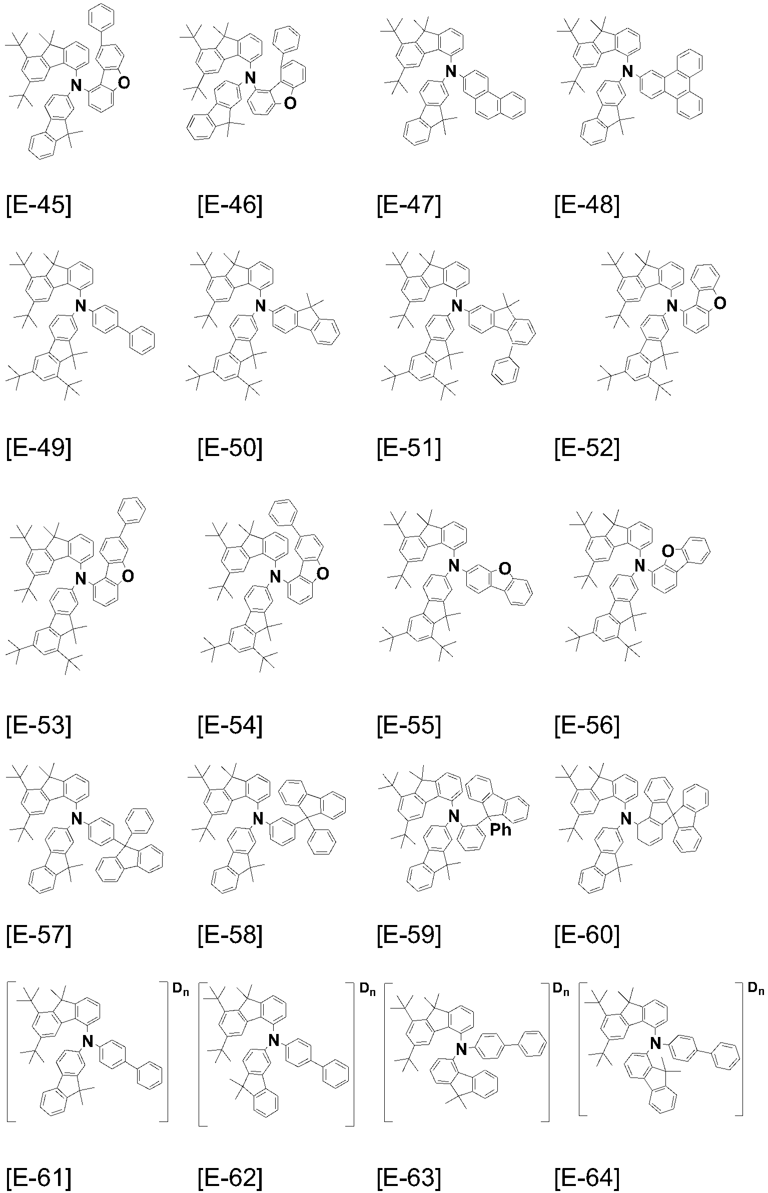

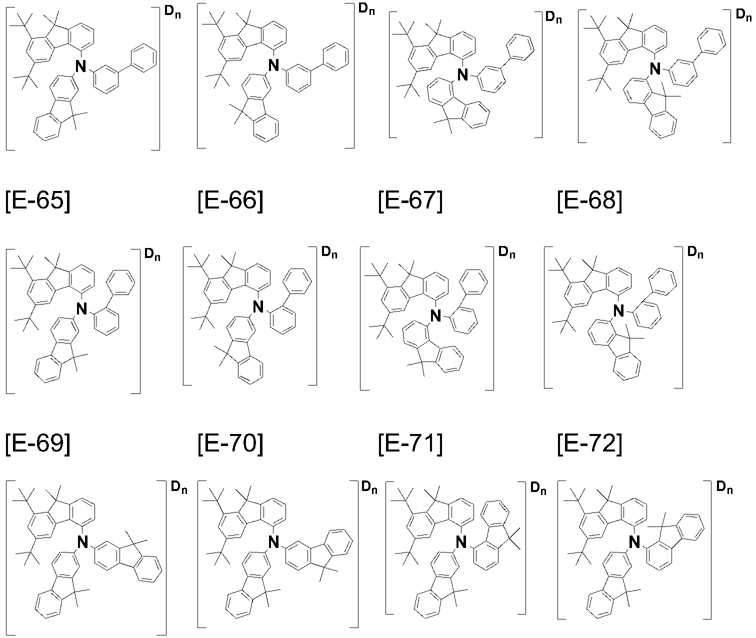

In the most specific embodiment of the present invention, the first compound may be represented by Chemical Formula 1, the second compound may be represented by Chemical Formula 2-8 or Chemical Formula 3C, and the third compound may be represented by Chemical Formula 5-4-1b.

In addition, the organic layer 30 may further include an electron transport region.

The electron transport region may further increase electron injection and/or electron mobility but block holes between the cathode 20 and the light emitting layer 32.

Specifically, the electron transport region may include an electron transport layer 34 between the cathode 20 and the light emitting layer 32, and an electron transport auxiliary layer between the light emitting layer 32 and the electron transport layer 34, and at least one of the compounds listed in Group B may be included in at least either one layer of the electron transport layer and the electron transport auxiliary layer.

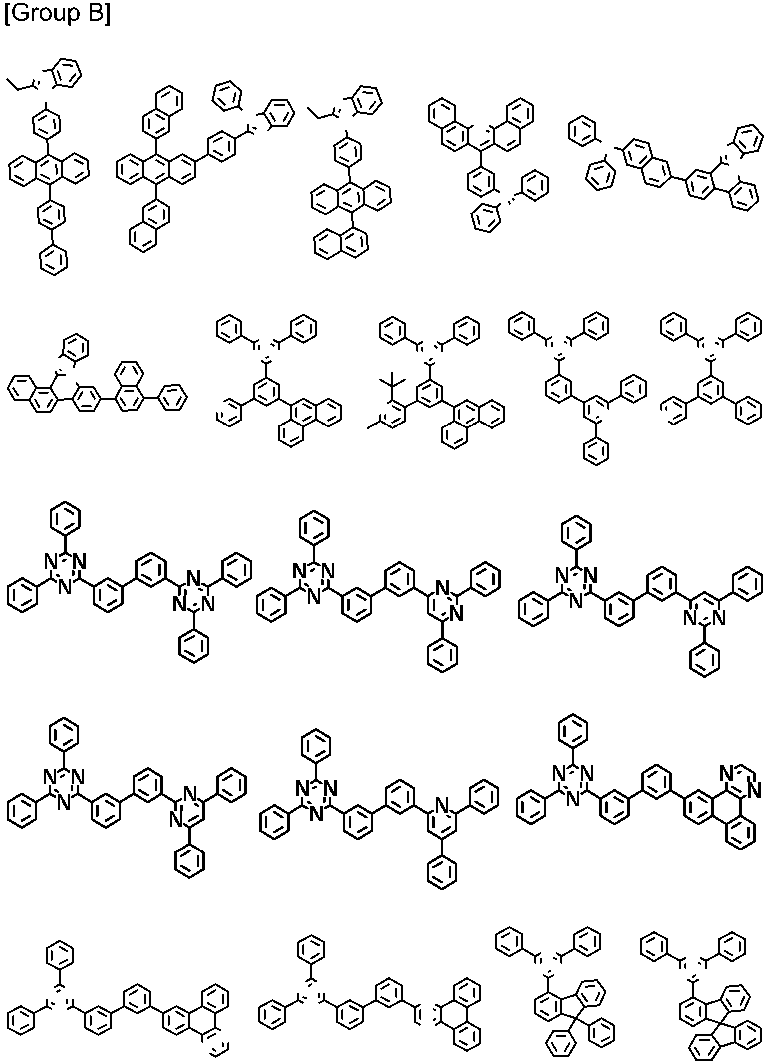

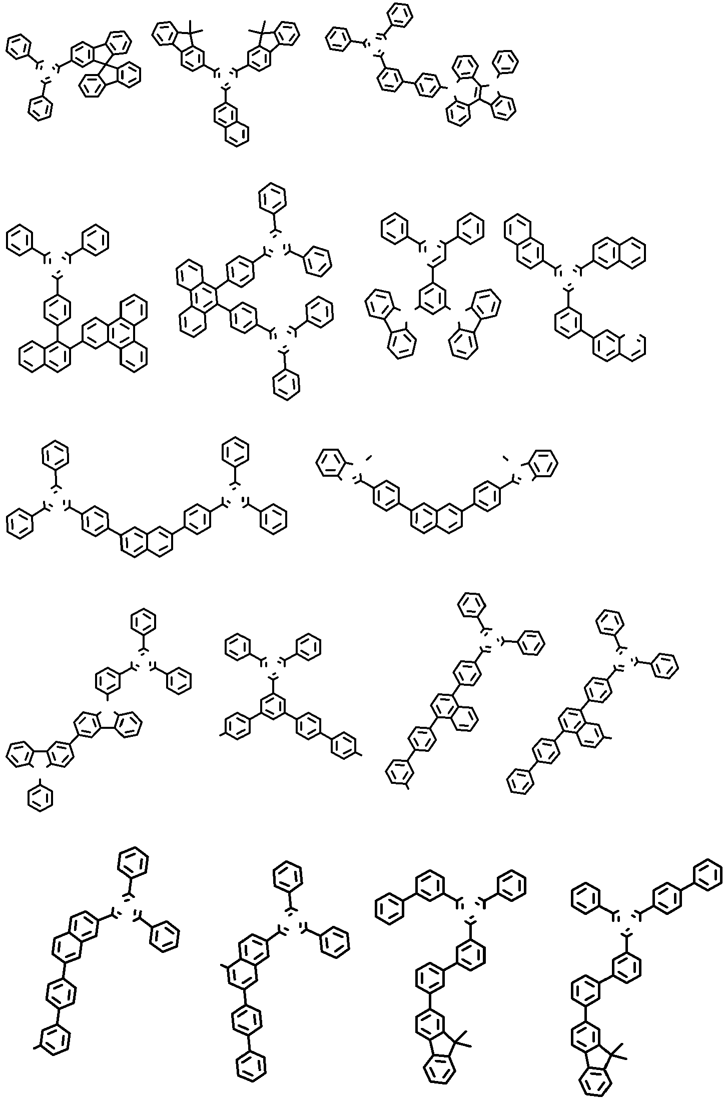

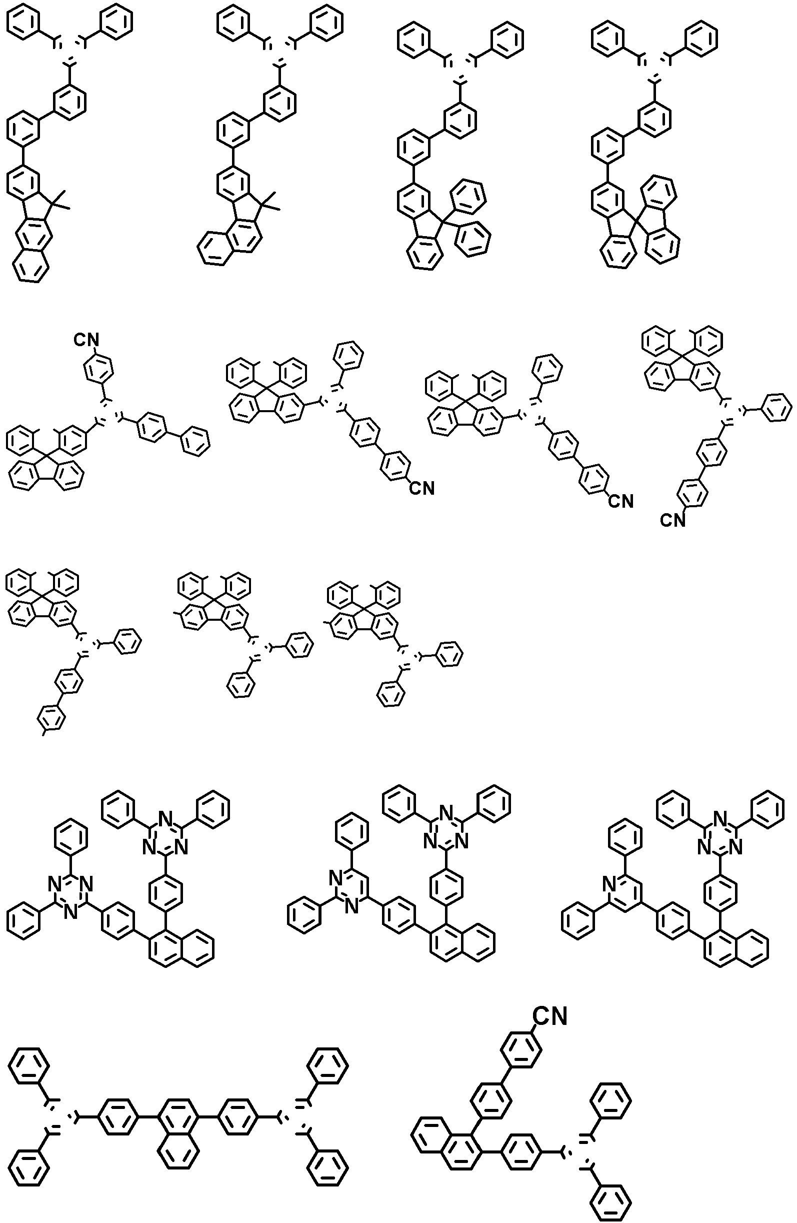

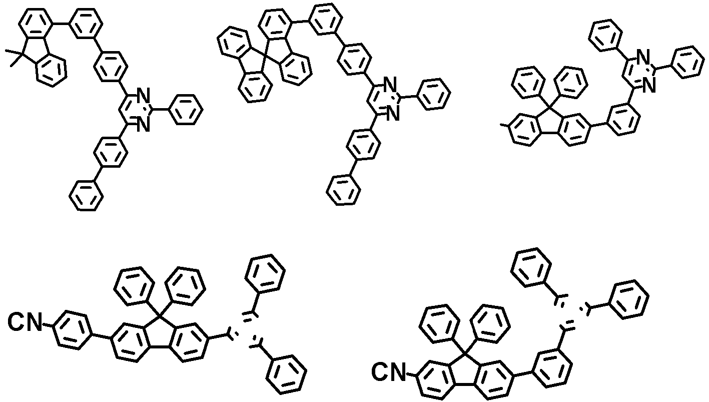

Meanwhile, the organic light emitting diode may additionally include an electron injection layer (not shown), a hole injection layer (not shown), etc. in addition to the light emitting layer as the aforementioned organic layer.

An organic light emitting diode may be manufactured by forming an anode or cathode on a substrate, forming an organic layer using a dry film method such as evaporation, sputtering, plasma plating, and ion plating, and then forming a cathode or anode thereon.

The organic light emitting diode may be applied to an organic light emitting display device.

### [Mode for Invention]

Hereinafter, the embodiments are illustrated in more detail with reference to examples. However, these examples are exemplary, and the present scope is not limited thereto.

Hereinafter, starting materials and reactants used in Examples and Synthesis Examples were purchased from Sigma-Aldrich Co. Ltd., TCI Inc., Tokyo Chemical Industry, or P&H Tech as far as there in no particular comment or were synthesized by known methods.

As a more specific example of the compound of the present invention, the compound presented was synthesized through the following steps.

### Synthesis of First Compound

### Synthesis Example 1: Synthesis of Compound A-43

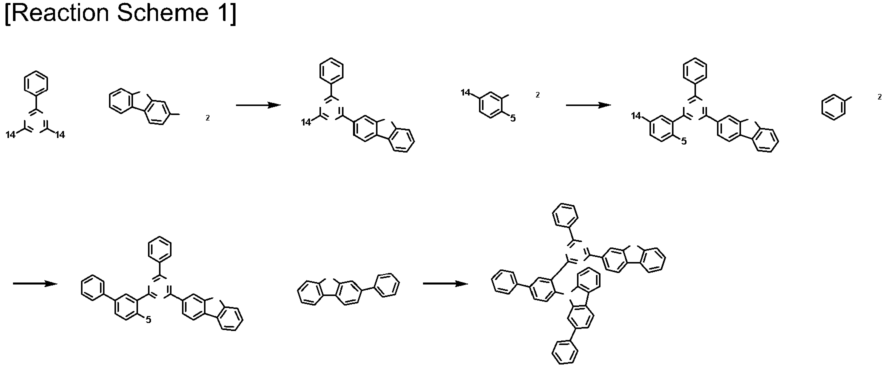

### 1st step: Synthesis of Intermediate Int-1

2,4-dichloro-6-phenyl-1,3,5-triazine (20.0 g, 88.5 mmol), 3-dibenzofuranylboronic acid (17.8 g, 84.1 mmol), K₂CO₃ (24.5 g, 176.9 mmol), and Pd(dppf)Cl₂ (3.6 g, 4.4 mmol) were added to a round bottom flask and then, dissolved in 250 ml of toluene and 90 ml of distilled water, and the solution was stirred at 60 °C for 6 hours. When a reaction was completed, after separating an aqueous layer by using a separatory funnel, an organic layer therefrom was distilled under a reduced pressure. A product obtained therefrom was dissolved by heating in monochlorobenzene and then, silica-filtered and recrystallized, obtaining 14.4 g (48%) of Intermediate Int-1.

### 2nd step: Synthesis of Intermediate Int-2

Intermediate Int-1 (14.4 g, 40.2 mmol), 5-chloro-2-fluorophenylboronic acid (6.8 g, 39.0 mmol), K₂CO₃ (10.8 g, 78.0 mmol), and Pd(PPh₃)₄ (2.25 g, 1.95 mmol) were added to a round bottom flask and then, dissolved in 180 ml of THF and 40 ml of distilled water, and the solution was stirred under reflux at 55 °C for 6 hours. When a reaction was completed, after removing an aqueous layer, the residue was treated through column chromatography (hexane:DCM (30%)), obtaining 13.2 g (75%) of Intermediate Int-2.

### 3rd step: Synthesis of Intermediate Int-3

Intermediate Int-2 (13.2 g, 29.2 mmol), phenylboronic acid (10.7 g, 86.6 mmol), Cs₂CO₃ (19.0 g, 58.4 mmol), tri-tert-butylphosphine (2.9 ml, 5.8 mmol), and Pd₂(dba)₃ (1.3 g, 1.5 mmol) were added to a round bottom flask and then, dissolved in 120 ml of 1,4-dioxane, and the solution was stirred under reflux at 100 °C for 8 hours. When a reaction was completed, the reactant was cooled to room temperature and then, poured into an excessive amount of methanol to precipitate a solid, which was filtered and then, recrystallized with monochlorobenzene, obtaining 10.8 g (75%) of Intermediate Int-3.

### 4th step: Synthesis of Compound A-43

Intermediate Int-3 (10.8 g, 21.9 mmol), 2-phenyl-9H-carbazole (6.4 g, 26.3 mmol), and K₃PO₄ (9.3 g, 43.8 mmol) were added to a round bottom flask and then, dissolved in 100 ml of DMF, and the solution was stirred under reflux at 150 °C for 4 hours. When a reaction was completed, the reactant was slowly added in a dropwise fashion to an excessive amount of water to precipitate a solid, which was filtered and then, recrystallized with toluene, obtaining 12.6 g (80%) of Compound A-43.

### Synthesis Example 2: Synthesis of Compound A-44

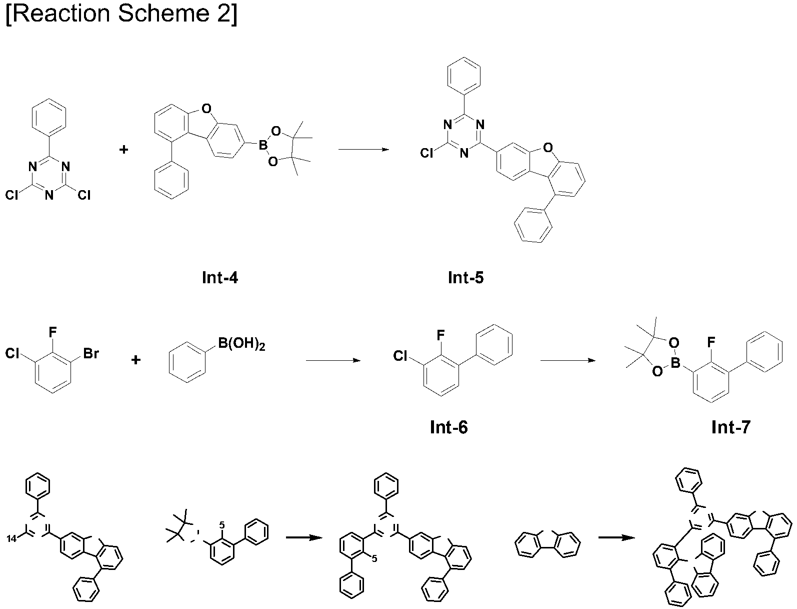

### 1st step: Synthesis of Intermediate Int-5

2,4-dichloro-6-phenyl-1,3,5-triazine (30.0 g, 132.7 mmol), Intermediate Int-4 (46.7 g, 126.1 mmol), K₂CO₃ (36.7 g, 265.4 mmol), and Pd(dppf)Cl₂ (5.42 g, 6.64 mmol) were used in the same manner as in the 1st step of Synthesis Example 1, obtaining 45.6 g (83%) of Intermediate Int-5.

### 2nd step: Synthesis of Intermediate Int-6

1-bromo-3-chloro-2-fluorobenzene (25.0 g, 119.4 mmol), phenylboronic acid (16.0 g, 131.3 mmol), K₂CO₃ (33.0 g, 238.7 mmol), and Pd(PPh₃)₄ (6.9 g, 6.0 mmol) were added to a round bottom flask and then, dissolved in 350 ml of THF and 120 ml of distilled water, and the solution was stirred under reflux at 65 °C for 6 hours. When a reaction was completed, after removing an aqueous layer, the residue was treated through column chromatography (hexane:DCM (20%)), obtaining 21.7 g (88%) of Intermediate Int-6.

### 3rd step: Synthesis of Intermediate Int-7

Intermediate Int-6 (21.7 g, 105.0 mmol), bis(pinacolato)diboron (32.0 g, 126.0 mmol), tricyclohexylphosphine (5.1 g, 21.0 mmol), potassium acetate (20.6 g, 210.0 mmol), and Pd(dppf)Cl₂ (4.29 g, 5.25 mmol) were added to a round bottom flask and then, dissolved in 250 ml of DMF. The mixture was stirred under reflux at 140 °C for 8 hours. When a reaction was completed, after cooling to room temperature and then, removing a salt therefrom by filtering, an excessive amount of DCM and distilled water were added thereto for precipitation. Subsequently, column chromatography (hexane:DCM (30% to 50%)) was performed, obtaining 25.1 g (80%) of Intermediate Int-7.

### 4th step: Synthesis of Intermediate Int-8

Intermediate Int-5 (14.5 g, 33.4 mmol), Intermediate Int-7 (11.0 g, 36.8 mmol), K₂CO₃ (9.2 g, 66.8 mmol), and Pd(PPh₃)₄ (1.93 g, 1.67 mmol) were added to a round bottom flask and then, dissolved in 170 ml of THF and 40 ml of distilled water, and the solution was stirred under reflux at 70 °C for 6 hours. When a reaction was completed, after removing an aqueous layer therefrom, column chromatography (hexane:DCM (30%)) was performed, obtaining 13.3 g (70%) of Intermediate Int-8.

### 5th step: Synthesis of Compound A-44

Intermediate Int-8 (13.3 g, 23.4 mmol), 9H-carbazole (4.7 g, 28.0 mmol), and K₃PO₄ (9.9 g, 46.7 mmol) were added to a round bottom flask and then, dissolved in 100 ml of DMF, and the solution was stirred under reflux at 150 °C for 4 hours. When a reaction was completed, the reactant was slowly added in a dropwise fashion to an excessive amount of water to precipitate a solid, which was filtered and then, recrystallized with monochlorobenzene, obtaining 14.1 g (84%) of Compound A-44.

### Synthesis Example 3: Synthesis of Compound A-77

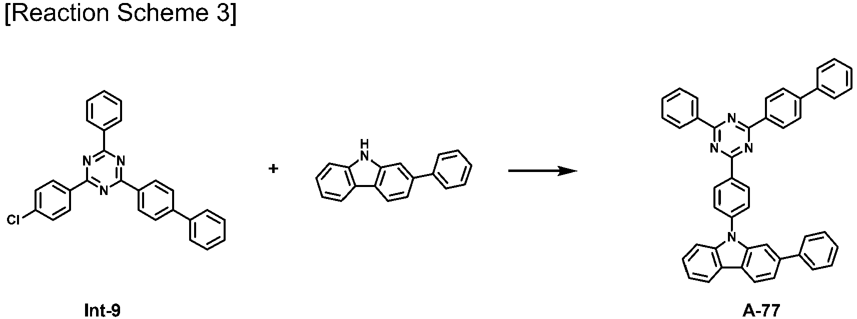

Compound A-77 was synthesized in the same manner as in the 4^{th} step by using Intermediate Int-9 (CAS No.1642330-72-0) and 2-phenyl-9H-carbazole.

### Synthesis Example 4: Synthesis of Compound A-90

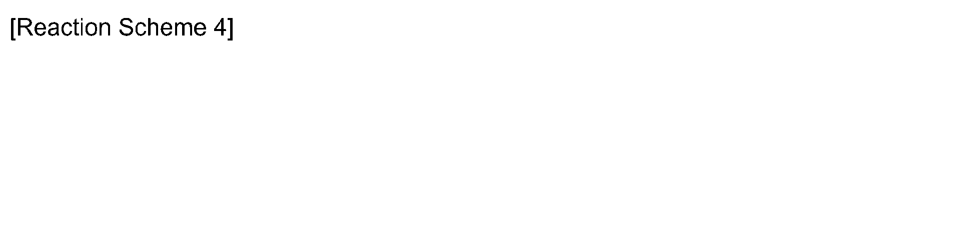

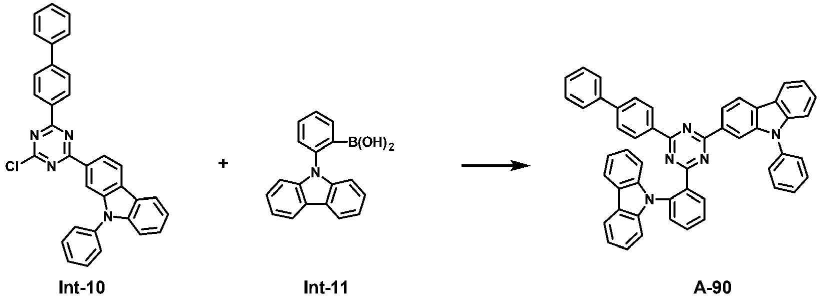

Compound A-90 was synthesized in the same manner as in the 1st step of Synthetic Example 1 by using Intermediate Int-10 (CAS No. 2745196-22-7) and Intermediate Int-11 (CAS No. 1189047-28-6).

### Comparative Synthesis Example 1: Synthesis of Compound Host-1

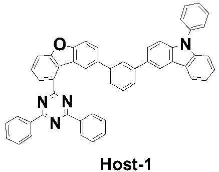

Compound Host-1 was synthesized with reference to the synthetic method disclosed in the published publication WO2023/072977.

### Synthesis of Second Compound

### Synthesis Example 5: Synthesis of Compound B-136

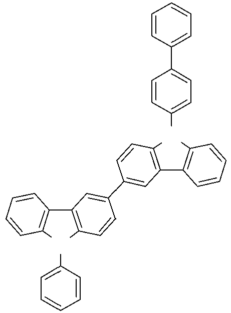

Compound B-136 was synthesized with reference to the synthetic method disclosed in registered patent US 10476008 B2.

HRMS (70eV, El+): m/z calcd for C42H28N2: 560.2252, found: 560.

Elemental Analysis: C, 90%; H, 5%

### Synthesis of Third Compound

### Synthesis Example 6: Synthesis of Compound E-1

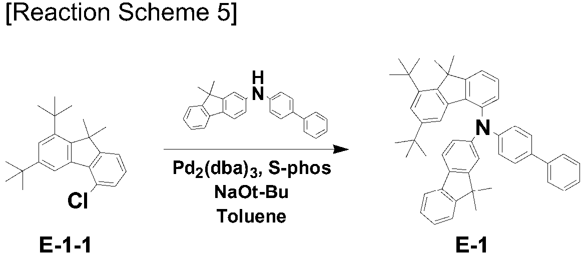

In a round-bottomed flask, 410 g (1.203 mol) of Intermediate E-1-1 (CAS No. 2924473-03-8), 435 g (1.082 mol) of an amine intermediate (CAS No. 897674-69-1), and 173 g (1.804 mol) of sodium t-butoxide were added and then, dissolved in 4000 ml of toluene. 55 g (0.06 mol) of Pd₂(dba)₃ and 74 g (0.18 mol) of S-phos were sequentially added thereto and then, stirred under reflux for 6 hours under a nitrogen atmosphere. When a reaction was completed, after removing the toluene solvent, an organic layer, which was extracted with toluene and distilled water, was dried with magnesium sulfate and filtered, and a filtrate therefrom was concentrated under a reduced pressure. A product therefrom was purified by recrystallization with n-hexane/methanol, obtaining 600 g (Yield: 71%) of Compound E-1.

### Synthesis Example 7: Synthesis of Compound E-21

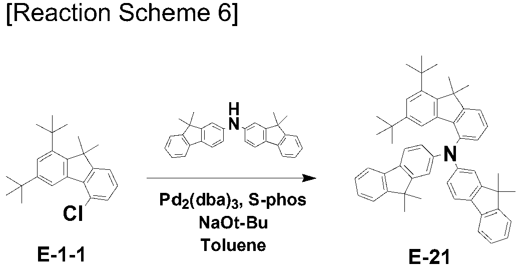

Compound E-21 was synthesized using the same method as in Synthesis Example 6 using intermediate E-1-1 and amine intermediate (CAS NO. 500717-23-7).

### (Manufacturing of Organic Light Emitting Diode)

### Example 1

A glass substrate coated with ITO (Indium tin oxide) as a thin film was washed with a distilled water ultrasonic wave. After washing with the distilled water, the glass substrate was washed with a solvent such as isopropyl alcohol, acetone, methanol, and the like ultrasonically and dried and then, moved to a plasma cleaner, cleaned by using oxygen plasma for 10 minutes, and moved to a vacuum depositor. This prepared ITO transparent electrode was used as an anode, and Compound A doped with 3% NDP-9 (commercially available from Novaled) was vacuum-deposited on the ITO substrate to form a 100 A-thick hole injection layer, and a 1350 A-thick hole transport layer was formed thereon by depositing Compound A. Compound E-21 obtained in Synthesis Example 8 was deposited on the hole transport layer to form a 270 A-thick first hole transport auxiliary layer, and Compound B was deposited on the first hole transport auxiliary layer to form a 50 A-thick second hole transport auxiliary layer. On the second hole transport auxiliary layer, 85 wt% of Compound A-43 (40%) synthesized in Synthesis Example 1 and Compound B-136 (60%) synthesized in Synthesis Example 5 were used as hosts, and 15 wt% of PtGD was doped as a dopant to form a 380 A-thick light emitting layer by vacuum deposition. Subsequently, Compound C was deposited on the light emitting layer to a thickness of 50 Å to form an electron transport auxiliary layer, and Compound D and Liq were simultaneously vacuum deposited at a weight ratio of 1:1 to form a 310 A-thick electron transport layer. An organic light emitting diode was manufactured by sequentially vacuum-depositing 15 Å of Yb and 1200 Å of Al on the electron transport layer to form a cathode.

The organic light emitting diode has a structure of ITO / Compound A (3% NDP-9 doping, 100 Å) / Compound A (1350 Å) / first hole transport auxiliary layer (270 Å) / Compound B (50Å) / light emitting layer [Host (Compound A-43: Compound B-136 = 40:60) : PtGD = 85 wt% : 15 wt%] (380 Å) / Compound C (50 Å) / Compound D : Liq (310 Å) / Yb (15 Å) / Al (1200 Å).
Compound A: N-(9,9-diphenyl-9H-fluoren-2-yl)-N,9-diphenyl-9H-carbazol-2-amine
Compound B: 9,9-dimethyl-N-[3-(9-phenyl-9H-fouoren-9-yl)phenyl]-N-(4-phenylphenyl)-9H-fluoren-2-amine
Compound C: 4-{4-[3-(9,9-dimethyl-9H-fluoren-4-yl)phenyl]phenyl}-2-phenyl-6- (4-phenylphenyl)pyrimidine
Compound D: 2-(4-{1-[4-(diphenyl-1,3,5-triazin-2-yl)phenyl]naphthalen-2-yl}phenyl)-4,6-diphenyl-1,3,5-triazine
PtGD:

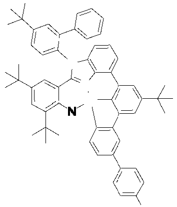

### Examples 2 to 4 and Comparative Example 1

Diodes of Examples 2 to 4 and Comparative Example 1 were manufactured in the same manner as in Example 1, except that the host was changed as described in Table 1.

### Evaluation

The luminous efficiency characteristics of the organic light emitting diodes according to Examples 1 to 4 and Comparative Example 1 were evaluated.

Specific measurement methods are as follows, and the results are shown in Table 1.

### (1) Measurement of Current Density Change Depending on Voltage Change

The obtained organic light emitting diodes were measured regarding a current value flowing in the unit diode, while increasing the voltage from 0 V to 10 V using a current-voltage meter (Keithley 2400), and the measured current value was divided by area to provide the results.

### (2) Measurement of Luminance Change Depending on Voltage Change

Luminance was measured by using a luminance meter (Minolta Cs-1000A), while the voltage of the organic light emitting diodes was increased from 0 V to 10 V.

### (3) Measurement of Luminous Efficiency

The current efficiency (cd/A) at the same current density (10 mA/cm²) was calculated using the luminance and current density measured from (1) and (2) above and the voltage.

The luminous efficiency values of Examples 1 to 4 and Comparative Example 1 were calculated as relative values based on Example 1 and are listed in Table 1.

**(Table 1)**

| No. | Host | | Hole transport auxiliary layer | Luminous efficiency (%) |
|---|---|---|---|---|
| | First compound | Second compound | Third compound | |
| Example 1 | A-43 | B-136 | E-21 | 110 |
| Example 2 | A-44 | B-136 | E-21 | 109 |
| Example 3 | A-77 | B-136 | E-21 | 109 |
| Example 4 | A-90 | B-136 | E-21 | 112 |
| Comparative Example 1 | Host-1 | B-136 | E-21 | 100 |

Referring to Table 1, the organic light emitting diodes including the compositions according to Examples of the present invention exhibited significantly improved luminous efficiency compared to the organic light emitting diode according to Comparative Example.

While this invention has been described in connection with what is presently considered to be practical embodiments, it is to be understood that the invention is not limited to the disclosed embodiments, but, on the contrary, is intended to cover various modifications and equivalent arrangements included within the spirit and scope of the appended claims.

## Claims

1. An organic optoelectronic device, comprising
an anode and a cathode facing each other,
a light emitting layer between the anode and the cathode,
a hole transport layer between the anode and the light emitting layer, and
hole transport auxiliary layer between the light emitting layer and the hole transport layer
wherein the light emitting layer includes a first compound represented by Chemical Formula 1 and a second compound represented by Chemical Formula 2 or a combination of Chemical Formula 3 and Chemical Formula 4, and
the hole transport auxiliary layer includes a third compound represented by Chemical Formula 5: 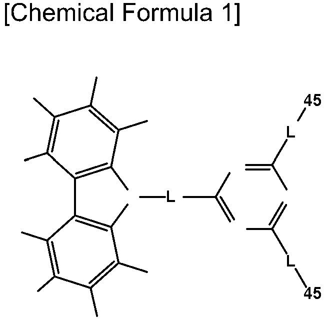
wherein, in Chemical Formula 1,
Z¹ to Z³ are each independently N or CR^{a},
at least two of Z¹ to Z³ are N,
R¹ to R⁸ and R^{a} are each independently hydrogen, deuterium, a substituted or unsubstituted C1 to C10 alkyl group, a substituted or unsubstituted C6 to C30 aryl group, or a substituted or unsubstituted C2 to C30 heterocyclic group,
L¹ to L³ are each independently a single bond, a substituted or unsubstituted C6 to C20 arylene group, or a substituted or unsubstituted C2 to C20 heterocyclic group, and
Ar¹ and Ar² are each independently a substituted or unsubstituted C6 to C30 aryl group, a substituted or unsubstituted C2 to C30 heterocyclic group; 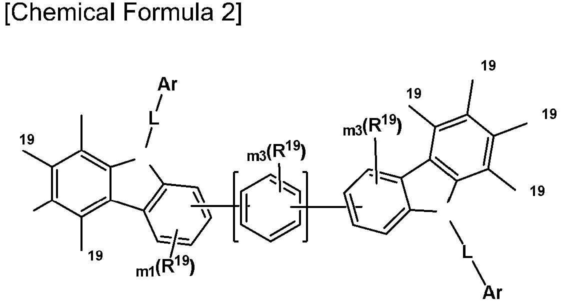
wherein, in Chemical Formula 2,
Ar³ and Ar⁴ are each independently a substituted or unsubstituted C6 to C20 aryl group or a substituted or unsubstituted C2 to C30 heterocyclic group,
L⁴ and L⁵ are each independently a single bond or a substituted or unsubstituted C6 to C20 arylene group,
R⁹ to R¹⁹ are each independently hydrogen, deuterium, a cyano group, a halogen, a substituted or unsubstituted amine group, a substituted or unsubstituted C1 to C30 alkyl group, a substituted or unsubstituted C6 to C30 aryl group, or a substituted or unsubstituted C2 to C30 heterocyclic group,
m1 and m2 are each independently one of integers of 1 to 3,
m3 is one of integers of 1 to 4, and
n is one of integers of 0 to 2; 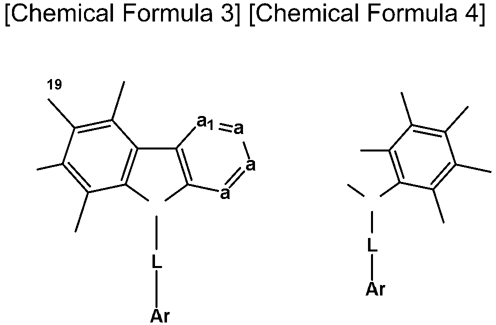
wherein, in Chemical Formula 3 and Chemical Formula 4,
Ar⁵ and Ar⁶ are each independently a substituted or unsubstituted C6 to C20 aryl group or a substituted or unsubstituted C2 to C30 heterocyclic group,
a₁* to a₄* in Chemical Formula 3 are each independently a linking carbon (C) or C-L^{a}-R^{b},
*s in Chemical Formula 4 are each independently a linking carbon (C),
adjacent two of a₁* to a₄* in Chemical Formula 3 are each linked to * in Chemical Formula 4,
L^{a}, L⁶, and L⁷ are each independently a single bond or a substituted or unsubstituted C6 to C20 arylene group, and
R^{b} and R²⁰ to R²⁷ are each independently hydrogen, deuterium, a cyano group, a halogen, a substituted or unsubstituted amine group, a substituted or unsubstituted C1 to C30 alkyl group, a substituted or unsubstituted C6 to C30 aryl group, or a substituted or unsubstituted C2 to C30 heterocyclic group; 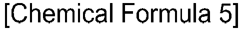 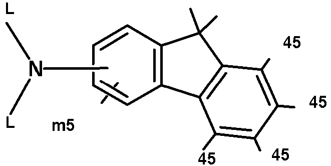
wherein, in Chemical Formula 5,
Ar⁸ and Ar⁹ are each independently a substituted or unsubstituted C6 to C30 aryl group, or a substituted or unsubstituted C2 to C30 heterocyclic group,
the Ar¹⁰ and Ar¹¹ are each independently a substituted or unsubstituted C1 to C30 alkyl group, or a substituted or unsubstituted C6 to C30 aryl group,
R⁴¹ to R⁴⁵ are each independently hydrogen, deuterium, a cyano group, a halogen, a substituted or unsubstituted C1 to C30 alkyl group, a substituted or unsubstituted C6 to C30 aryl group, or a substituted or unsubstituted C2 to C30 heterocyclic group, and
m5 is one of integers of 1 to 3.

2. The organic optoelectronic device as claimed in claim 1, wherein in Chemical Formula 1, Ar¹ and Ar² are each independently a substituted or unsubstituted phenyl group, a substituted or unsubstituted biphenyl group, a substituted or unsubstituted terphenyl group, a substituted or unsubstituted naphthyl group, a substituted or unsubstituted phenanthrenyl group, a substituted or unsubstituted triphenylene group, a substituted or unsubstituted fluorenyl group, a substituted or unsubstituted dibenzofuranyl group, a substituted or unsubstituted dibenzothiophenyl group, a substituted or unsubstituted dibenzosilolyl group, or a substituted or unsubstituted carbazolyl group.

3. The organic optoelectronic device as claimed in claim 1, wherein
in Chemical Formula 1, L¹-Ar¹ and L²-Ar² are each independently selected from the substituents listed in Group I : 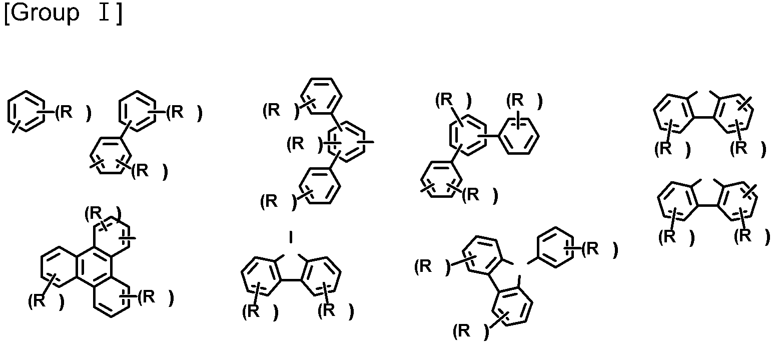
wherein, in Group I,
R⁴⁶ to R⁴⁸ are each independently hydrogen, deuterium, a cyano group, a substituted or unsubstituted C1 to C10 alkyl group, or a substituted or unsubstituted C6 to C12 aryl group,
m6 is one of integers of 1 to 5,
m7 is one of integers of 1 to 4,
m8 is one of integers of 1 to 3, and
* is a linking point.

4. The organic optoelectronic device as claimed in claim 1, wherein
the first compound is one selected from the compounds listed in Group 1:

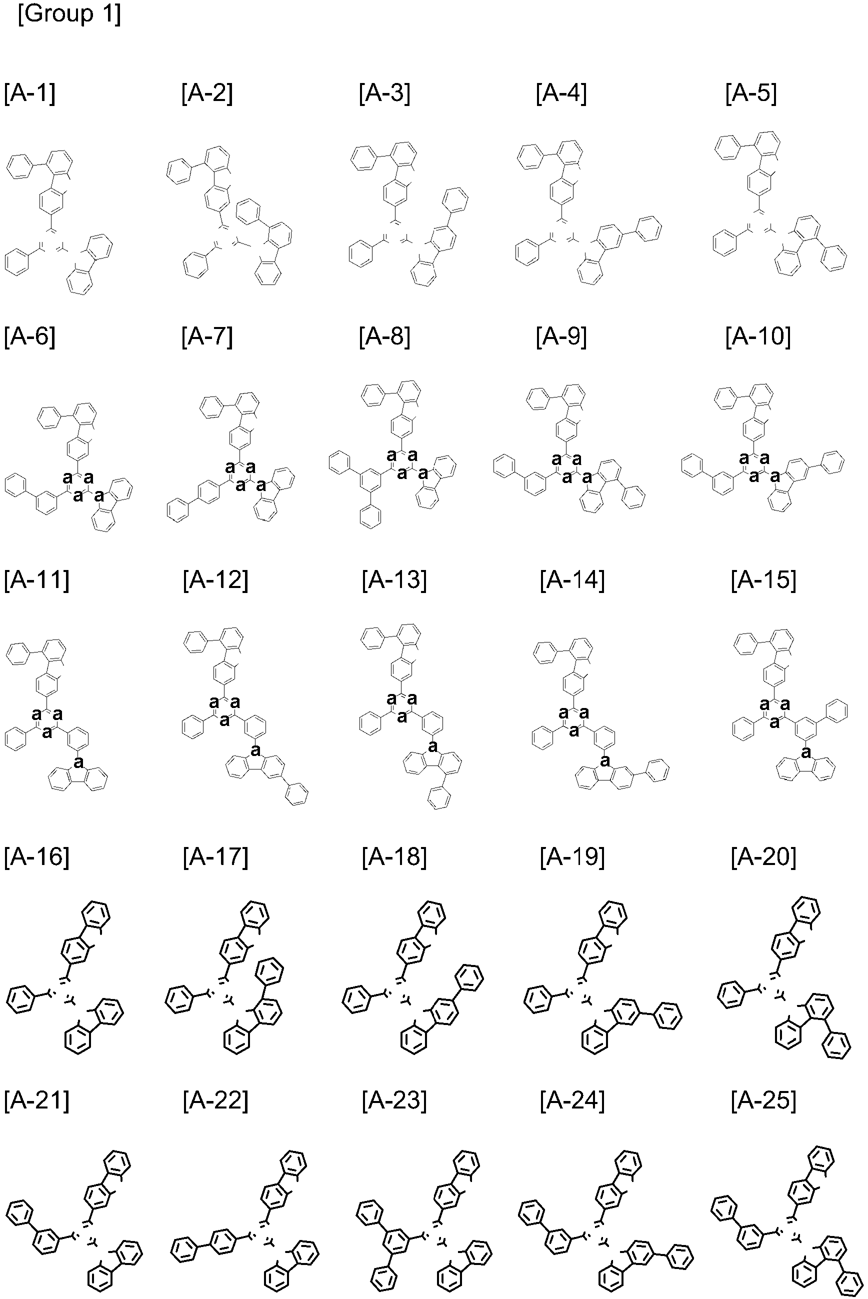

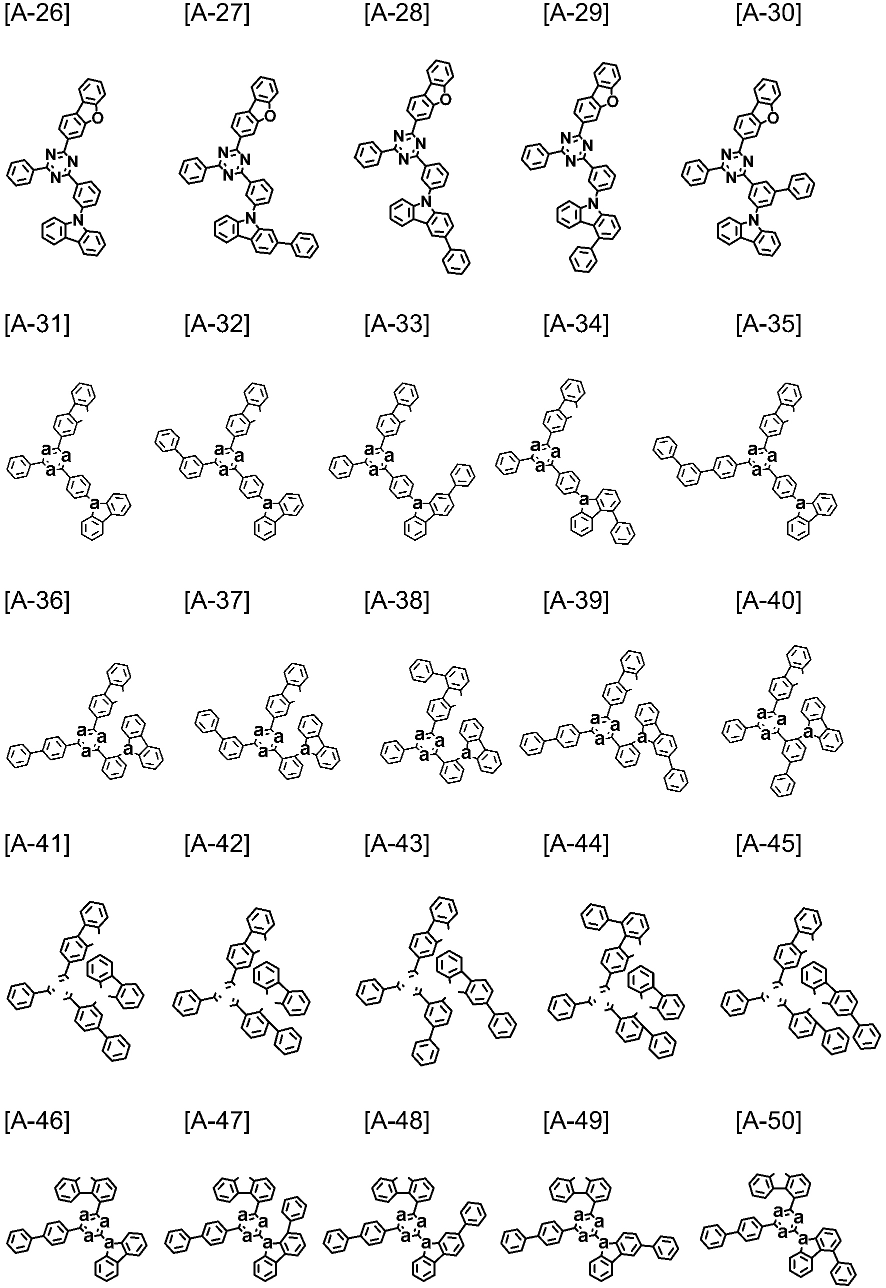

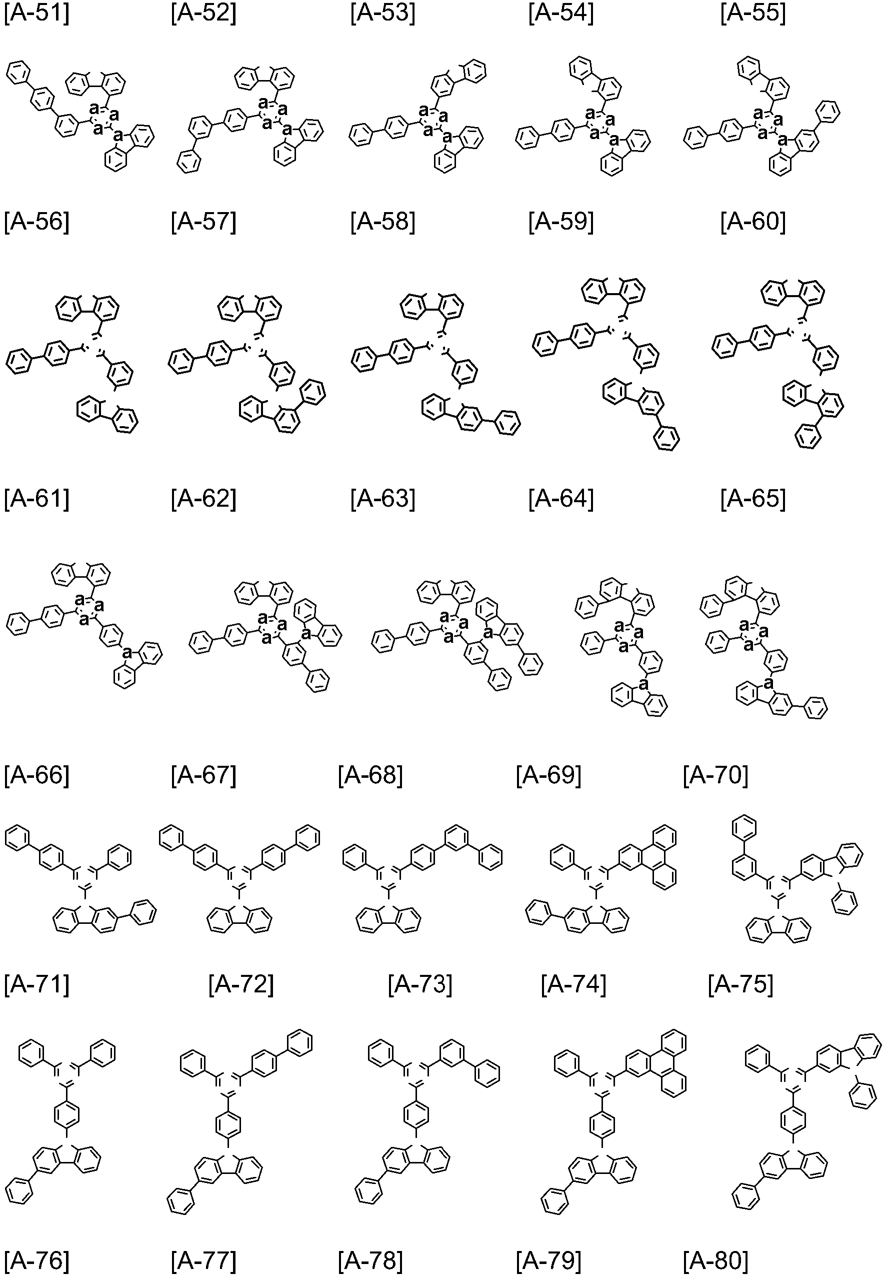

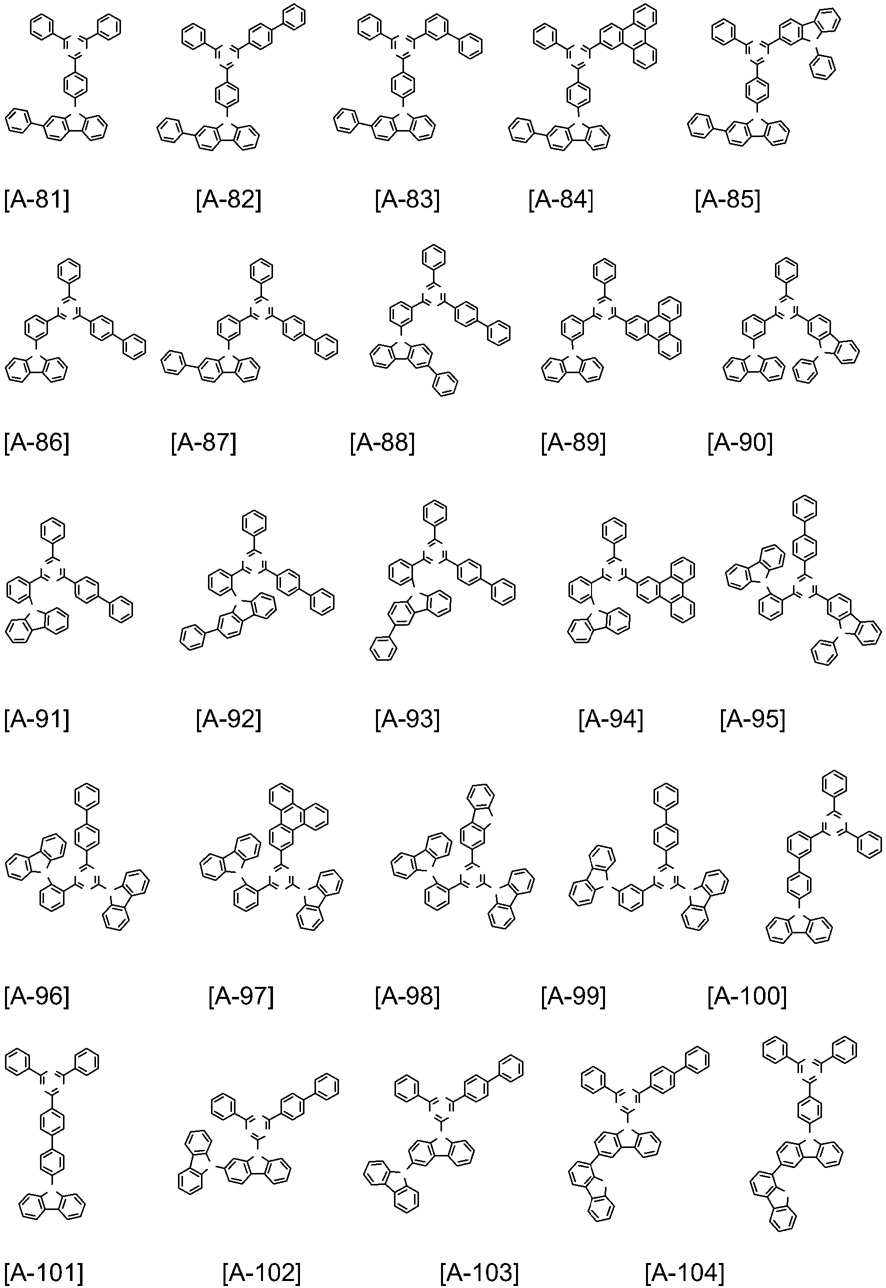

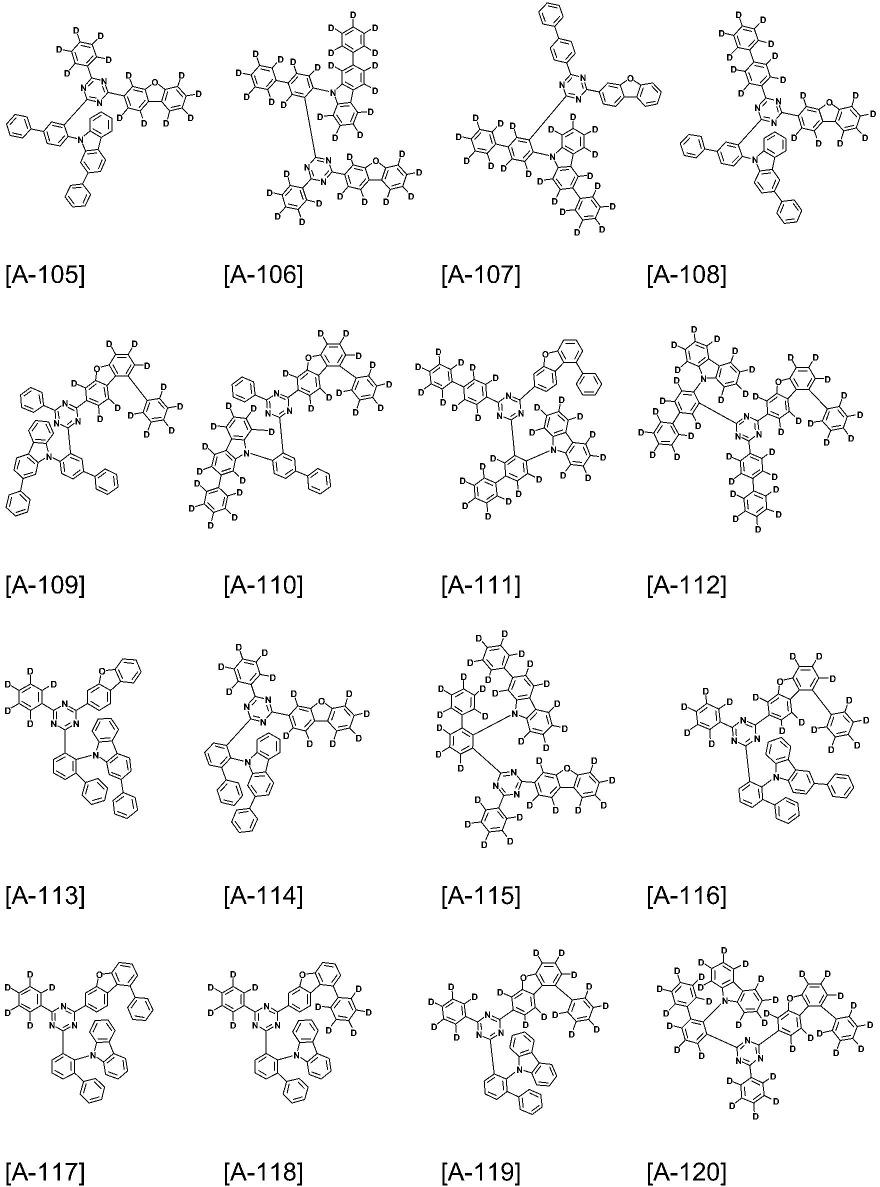

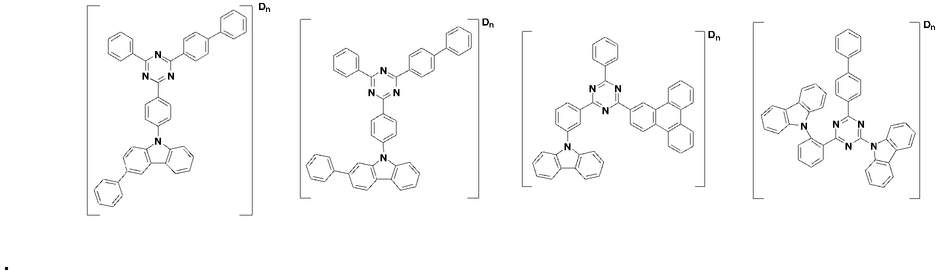

5. The organic optoelectronic device as claimed in claim 1, wherein
Chemical Formula 2 is represented by Chemical Formula 2-8:
[Chemical Formula 2-8]
wherein, in Chemical Formula 2-8,
R⁹ to R¹⁸ are each independently hydrogen, deuterium, or a substituted or unsubstituted C6 to C12 aryl group,
m1 and m2 are each independently one of integers of 1 to 3, and
L⁴-Ar³ and L⁵-Ar⁴ are each independently one of substituents listed in Group II, 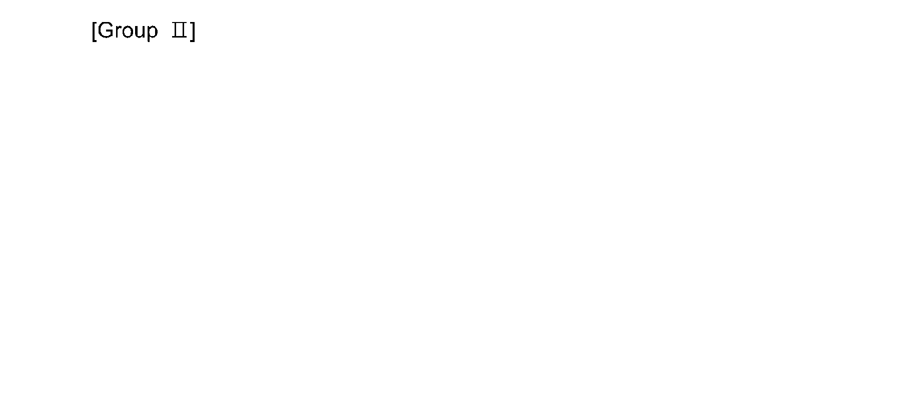 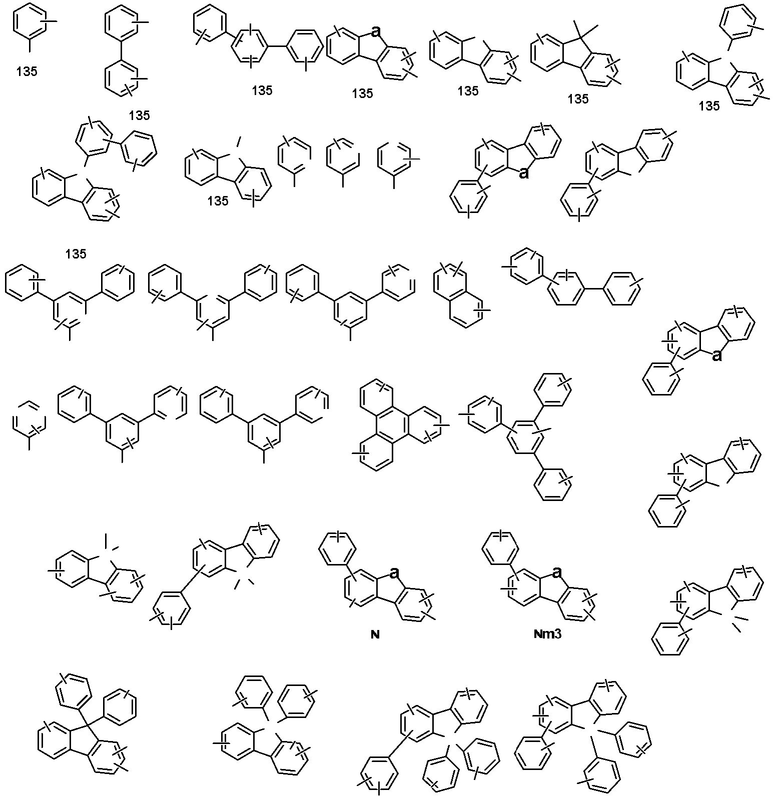
wherein, in Group II,
R⁴⁹ to R⁵² are each independently hydrogen, deuterium, a cyano group, a substituted or unsubstituted C1 to C10 alkyl group, or a substituted or unsubstituted C6 to C12 aryl group,
m9 is one of integers of 1 to 5,
m10 is one of integers of 1 to 4,
m11 is one of integers of 1 to 3,
m12 is an integer of 1 or 2, and
* is a linking point.

6. The organic optoelectronic device as claimed in claim 1, wherein
the combination of Chemical Formula 3 and Chemical Formula 4 is represented by Chemical Formula 3: 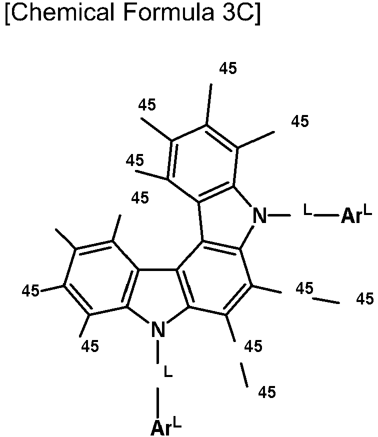
wherein, in Chemical Formula 3C,
L^{a3} and L^{a4} are a single bond,
R²⁰ to R²⁷, R^{b3}, and R^{b4} are each independently hydrogen or a C6 to C12 aryl group, and
L⁶-Ar⁵ and L⁷-Ar⁶ are each independently one of substituents listed in Group II, 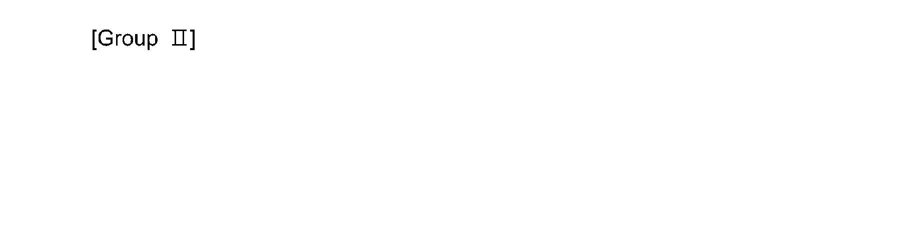 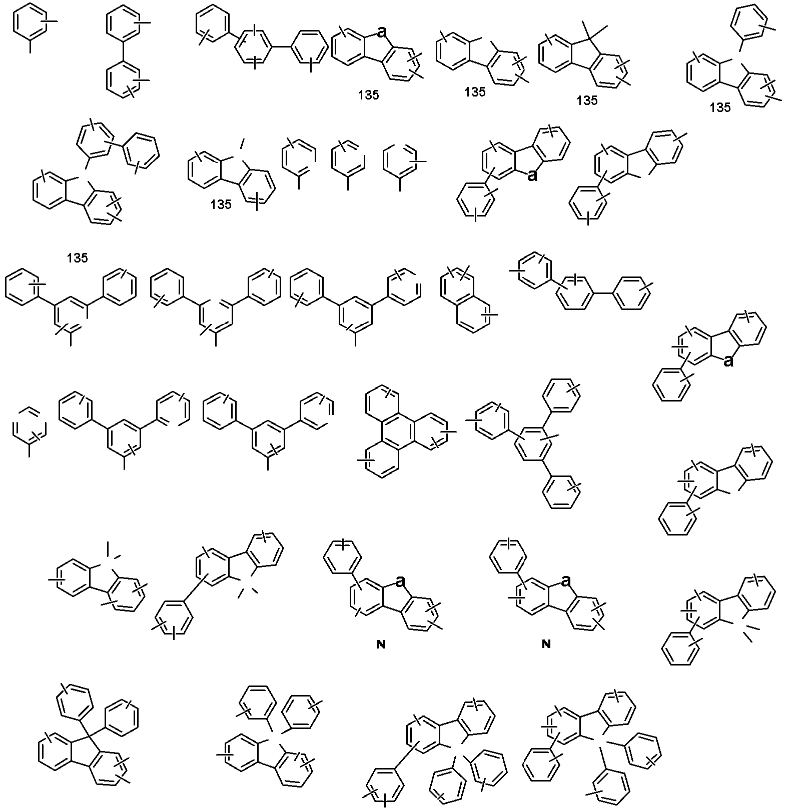
wherein, in Group II,
R⁴⁹ to R⁵² are each independently hydrogen, deuterium, a cyano group, a substituted or unsubstituted C1 to C10 alkyl group, or a substituted or unsubstituted C6 to C12 aryl group,
m9 is one of integers of 1 to 5,
m10 is one of integers of 1 to 4,
m11 is one of integers of 1 to 3,
m12 is an integer of 1 or 2, and
* is a linking point.

7. The organic optoelectronic device as claimed in claim 1, wherein
Chemical Formula 5 is represented by Chemical Formula 5-4: 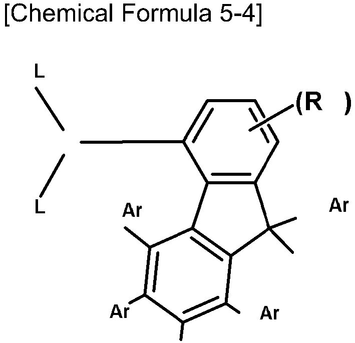
wherein, in Chemical Formula 5-4,
Ar⁸ to Ar¹¹, R⁴¹ to R⁴⁵, and m5 are as defined in Chemical Formula 5.

8. The organic optoelectronic device as claimed in claim 7, wherein
Chemical Formula 5-4 is represented by Chemical Formula 5-4-1: 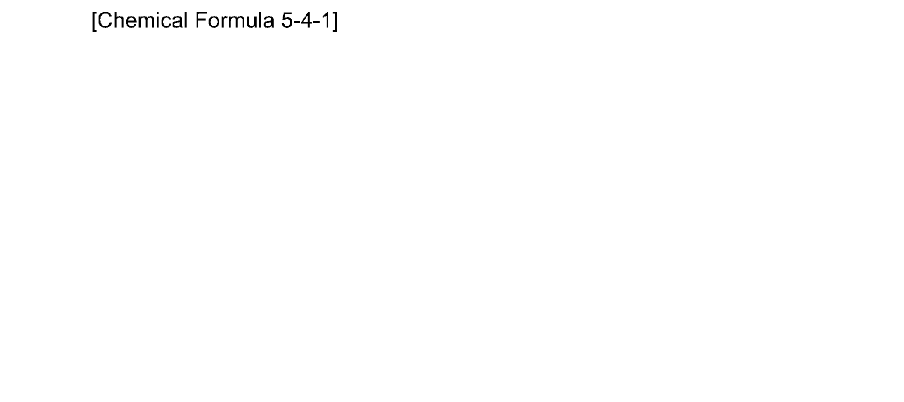 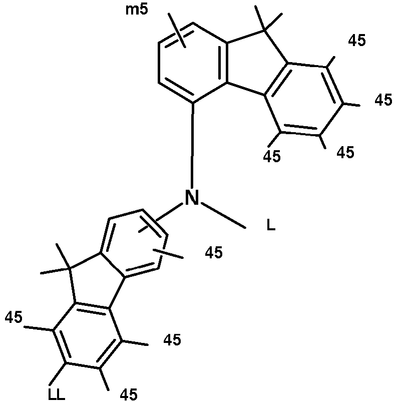
wherein, in Chemical Formula 5-4-1,
Ar⁹ to Ar¹¹, R⁴¹ to R⁴⁵ and m5 are as defined in claim 1,
Ar¹² and Ar¹³ are each independently a substituted or unsubstituted C1 to C30 alkyl group, or a substituted or unsubstituted C6 to C30 aryl group,
R⁵³ to R⁵⁷ are each independently hydrogen, deuterium, a cyano group, a halogen, a substituted or unsubstituted C1 to C30 alkyl group, a substituted or unsubstituted C6 to C30 aryl group, or a substituted or unsubstituted C2 to C30 heterocyclic group, and
m13 is one of integers of 1 to 3.

9. The organic optoelectronic device as claimed in claim 8, wherein
Chemical Formula 5-4-1 is represented by Chemical Formula 5-4-1b: 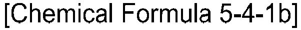 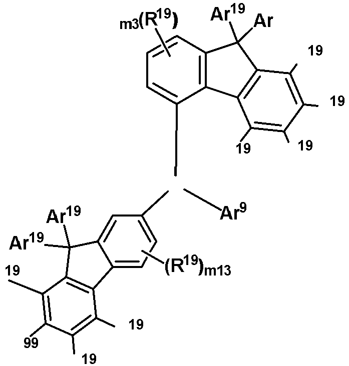
wherein, in Chemical Formula 5-4-1b,
Ar⁹ to Ar¹³, R⁴¹ to R⁴⁵, R⁵³ to R⁵⁷, m5, and m13 are as defined in Chemical Formula 5-4-1.

10. The organic optoelectronic device as claimed in claim 1, wherein
the third compound is selected from compounds listed in Group 3:

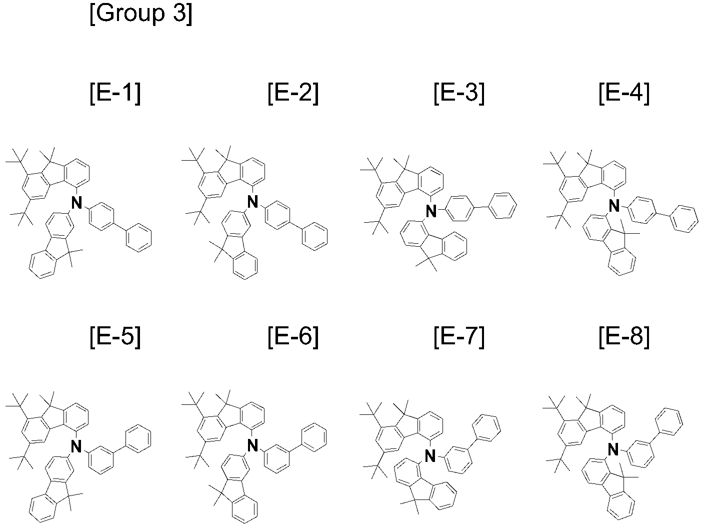

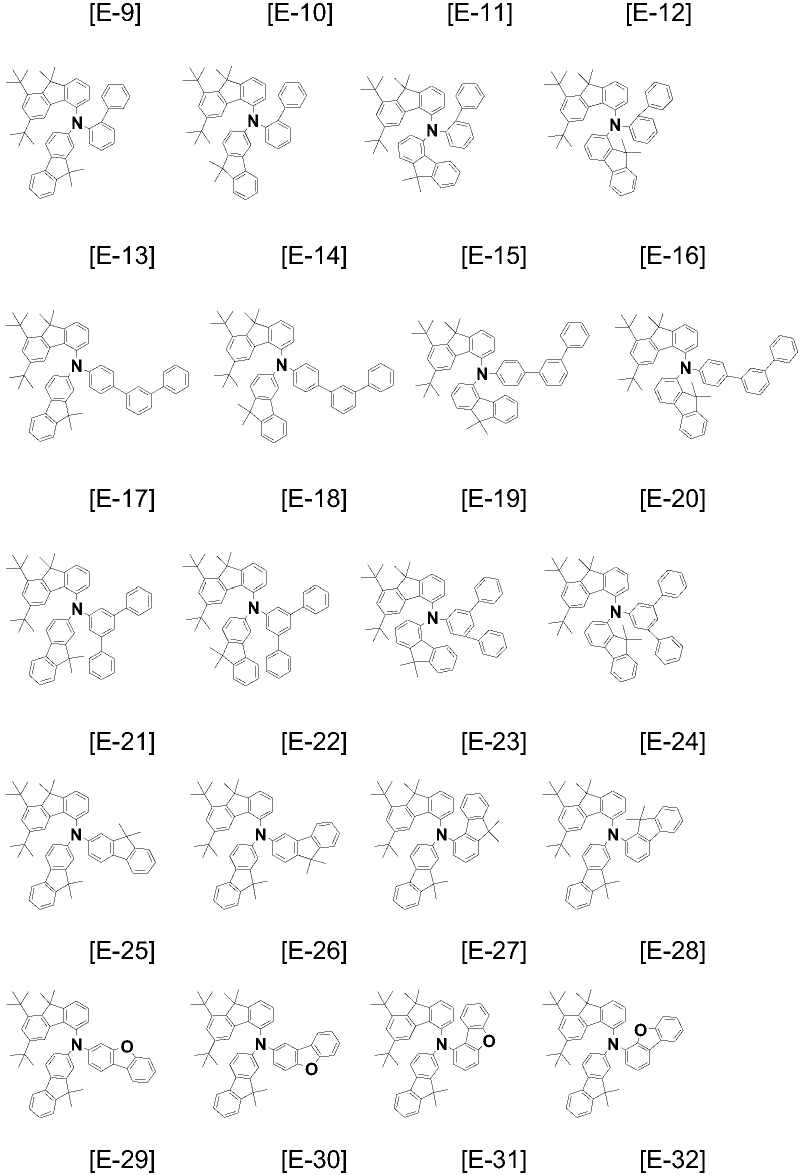

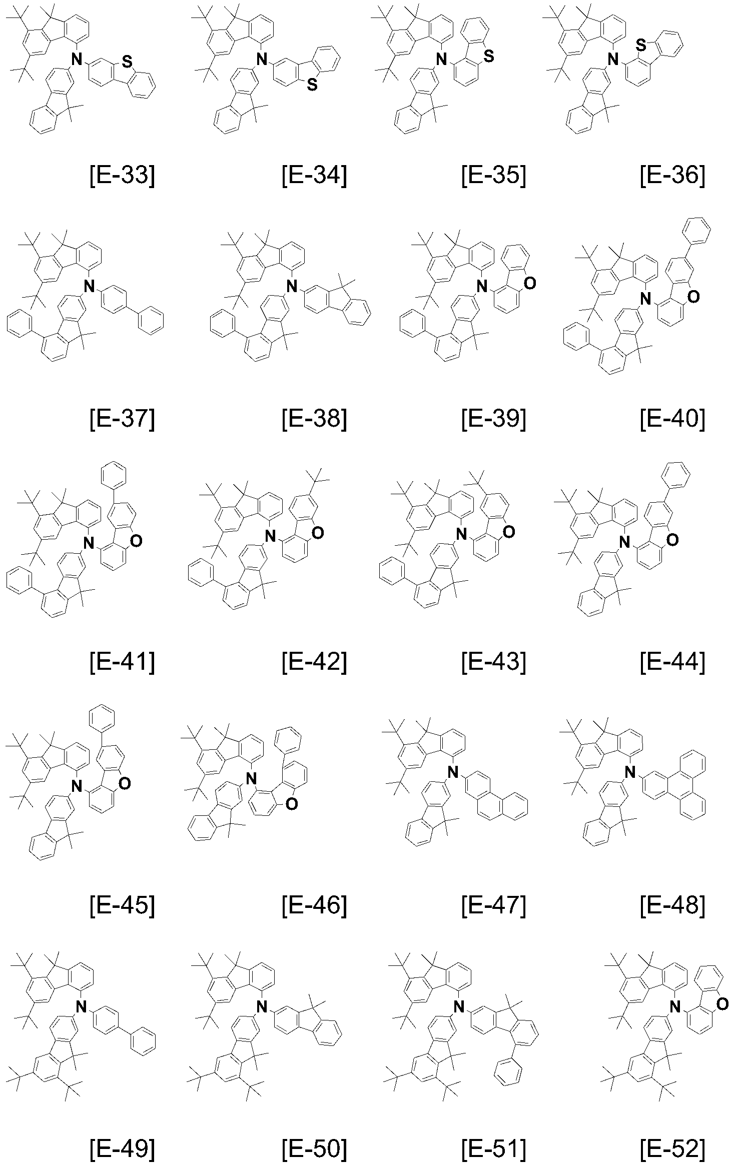

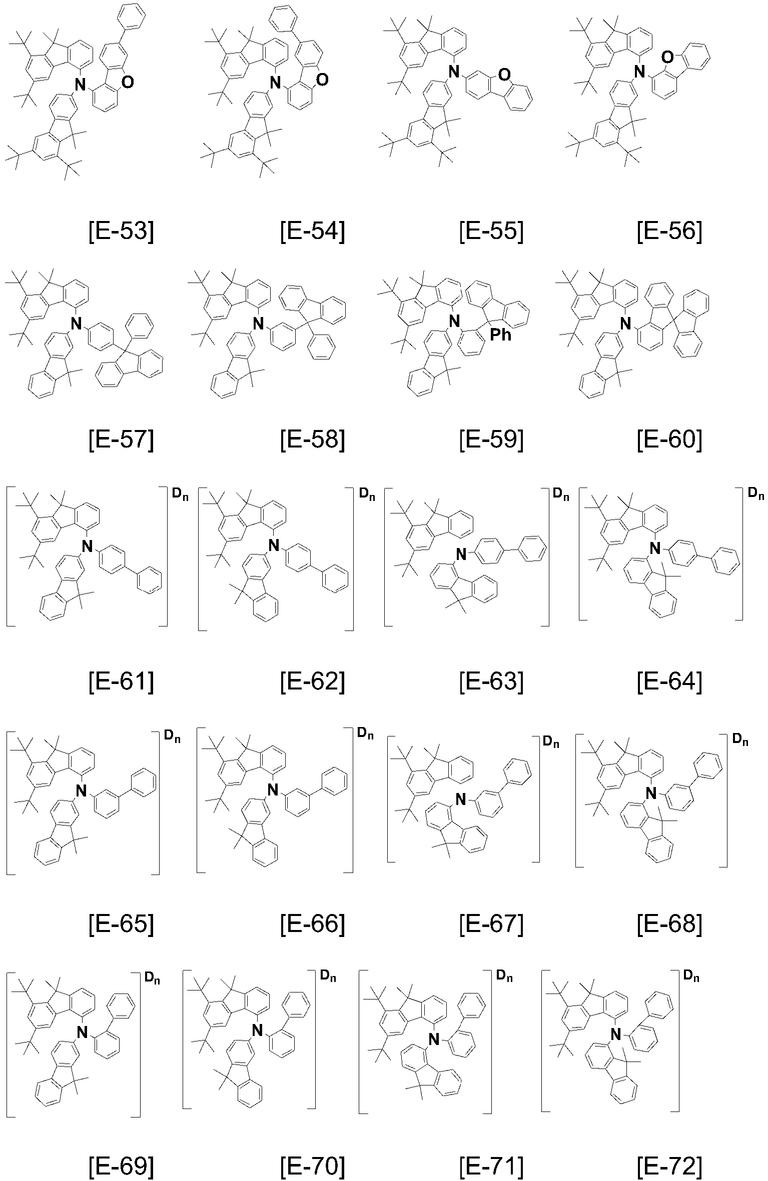

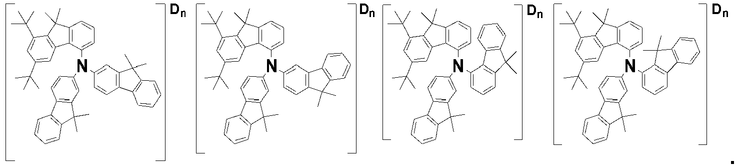

11. The organic optoelectronic device as claimed in claim 1, wherein
the second compound is represented by Chemical Formula 2-8 or Chemical Formula 3C, and
the third compound is represented by Chemical Formula 5-4-1b: 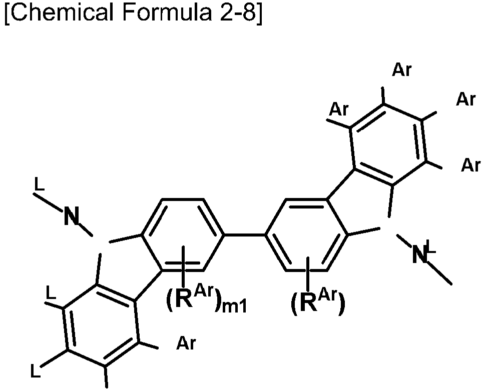
wherein, in Chemical Formula 2-8,
R⁹ to R¹⁸ are each independently hydrogen, deuterium, or a substituted or unsubstituted C6 to C12 aryl group,
m1 and m2 are each independently one of integers of 1 to 3, and
L⁴-Ar³ and L⁵-Ar⁴ are each independently one of substituents listed in Group II, 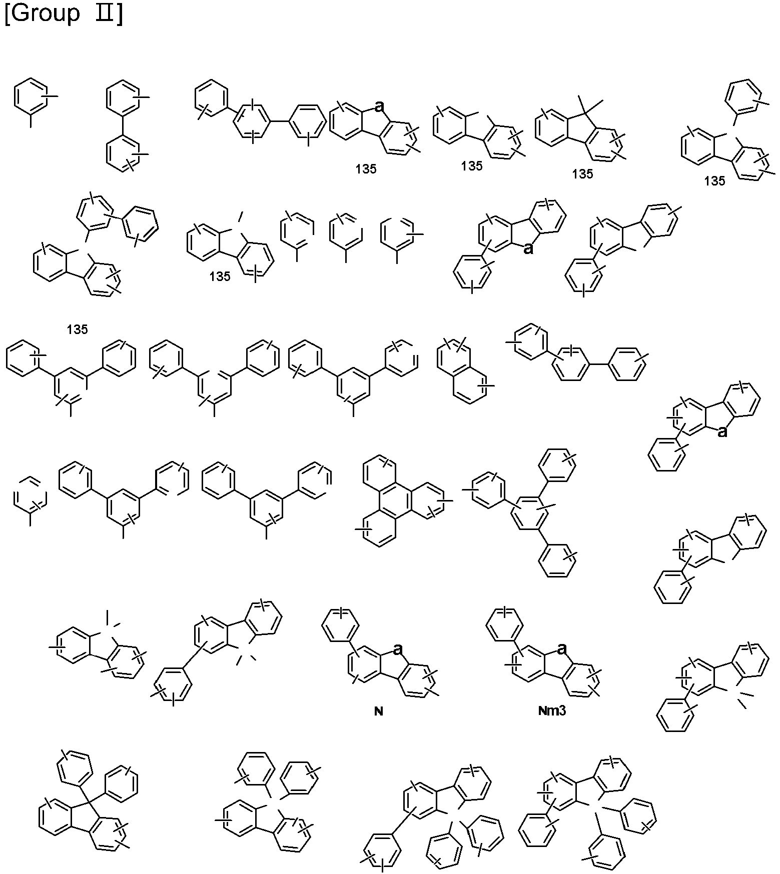
wherein, in Group II,
R⁴⁹ to R⁵² are each independently hydrogen, deuterium, a cyano group, a substituted or unsubstituted C1 to C10 alkyl group, or a substituted or unsubstituted C6 to C12 aryl group,
m9 is one of integers of 1 to 5,
m10 is one of integers of 1 to 4,
m11 is one of integers of 1 to 3,
m12 is an integer of 1 or 2, and
* is a linking point; 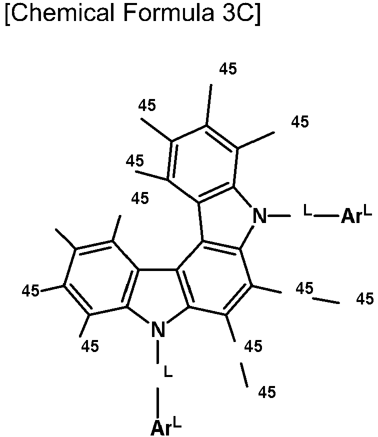
wherein, in Chemical Formula 3C,
L^{a3} and L^{a4} is a single bond,
R²⁰ to R²⁷, R^{b3}, and R^{b4} are each independently hydrogen or a C6 to C12 aryl group, and
L⁶-Ar⁵ and L⁷-Ar⁶ are each independently one of substituents listed in Group II, 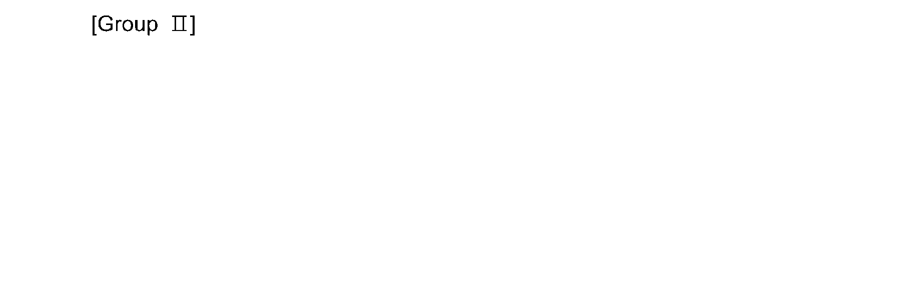 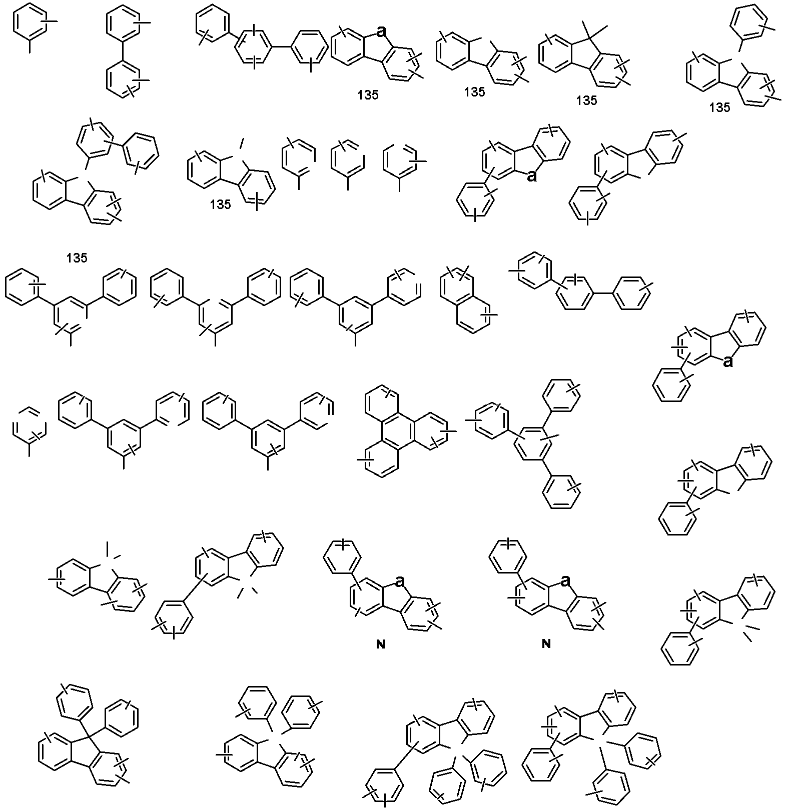
wherein, in Group II,
R⁴⁹ to R⁵² are each independently hydrogen, deuterium, a cyano group, a substituted or unsubstituted C1 to C10 alkyl group, or a substituted or unsubstituted C6 to C12 aryl group,
m9 is one of integers of 1 to 5,
m10 is one of integers of 1 to 4,
m11 is one of integers of 1 to 3,
m12 is an integer of 1 or 2, and
* is a linking point; 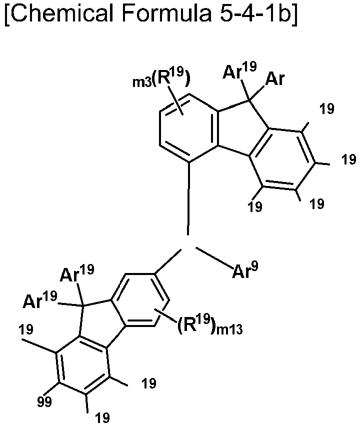
wherein, in Chemical Formula 5-4-1b,
Ar¹⁰ and Ar¹¹ are each independently a substituted or unsubstituted C1 to C5 alkyl group, a substituted or unsubstituted C6 to C12 aryl group,
Ar¹² and Ar¹³ are each independently a substituted or unsubstituted C1 to C5 alkyl group, or a substituted or unsubstituted C6 to C12 aryl group,
R⁴¹ to R⁴⁵ and R⁵³ to R⁵⁷ are each independently hydrogen, deuterium or a substituted or unsubstituted C1 to C5 alkyl group,
Ar⁹ is a substituted or unsubstituted phenyl group, a substituted or unsubstituted biphenyl group, a substituted or unsubstituted terphenyl group, a substituted or unsubstituted fluorenyl group, a substituted or unsubstituted spirobifluorenyl group, a substituted or unsubstituted triphenylene group, a substituted or unsubstituted dibenzofuranyl group, or a substituted or unsubstituted dibenzothiophenyl group, and
m5 and m13 are each independently one of integers of 1 to 3.

12. A display device comprising the organic optoelectronic device of any one of claim 1 to claim 11.
